# EUROPEAN PATENT APPLICATION

(11) **EP 4 697 916 A1**
(43) Date of publication of application: **18.02.2026**
(21) Application number: 24938084.1
(22) Date of filing: 31.05.2024
(51) Int. Cl.: H10K 71/00, H10K 59/121, H10K 59/123, H10K 59/80, H10K 59/131, H10K 59/126, H10K 59/35, H10K 59/88, H10K 59/12

(54) **DISPLAY DEVICE AND MANUFACTURING METHOD THEREFOR**

(30) Priority: 30.05.2024 KR 20240070865
(71) Applicant: Samsung Display Co., Ltd, Yongin-City, Gyeonggi-do 17113 (KR)
(72) Inventor: PARK, Ill Won, Yongin-si, Gyeonggi-do 17113 (KR); LEE, Suk Ei, Yongin-si, Gyeonggi-do 17113 (KR); MOON, Joon Chul, Yongin-si, Gyeonggi-do 17113 (KR); SONG, Dae Hyuk, Yongin-si, Gyeonggi-do 17113 (KR)
(74) Representative: Walaski, Jan Filip
(86) International application number: PCT/KR2024/007464
(87) International publication number: WO 2025/249611

(57) **Abstract**

The present disclosure relates to a display device, and more particularly, to a display device whose defect rate and image quality deterioration can be minimized and a method of fabricating the display device. According to an aspect of the present disclosure, there is provided a display device including: a first light emitting element; a (1-1)-th transistor including a drain electrode connected to a driving voltage line and a source electrode connected to a first anode of the first light emitting element; a (1-2)-th transistor including a gate electrode connected to a first scan line, a drain electrode connected to a first data line, and a source electrode connected to a gate electrode of the (1-1)-th transistor; a (1-3)-th transistor including a gate electrode connected to a second scan line, a drain electrode connected to the first anode of the first light emitting element, and a source electrode connected to an initialization voltage line; a second light emitting element; a (2-1)-th transistor including a drain electrode connected to a driving voltage line and a source electrode connected to a second anode of the second light emitting element; a (2-2)-th transistor including a gate electrode connected to the first scan line, a drain electrode connected to a second data line, and a source electrode connected to a gate electrode of the (2-1)-th transistor; a (2-3)-th transistor including a gate electrode connected to the second scan line, a drain electrode connected to the second anode of the second light emitting element, and a source electrode connected to the initialization voltage line; a first data connection electrode connected to the first data line and the drain electrode of the (1-2)-th transistor; and a second data connection electrode connected to the second data line and the drain electrode of the (2-2)-th transistor, wherein at least one of the drain electrode of the (1-2)-th transistor and the first data connection electrode is cut, the second data connection electrode is cut, and the second data connection electrode and the first data line are connected to each other.

## Description

### [Technical Field]

The present disclosure relates to a display device, and more particularly, to a display device whose defect rate and image quality deterioration can be minimized and a method of fabricating the display device.

### [Background Art]

Organic light emitting diode displays have self-luminous properties and, unlike liquid crystal displays, do not require a separate light source and thus can be reduced in thickness and weight. In addition, organic light emitting diode displays are attracting attention as next-generation displays for televisions, monitors, and portable electronic devices due to their high-quality characteristics such as low power consumption, high luminance, and high response speed.

### [Disclosure of the Invention]

### [Technical Problem]

The present invention aims to provide a display device whose defect rate and image quality deterioration can be minimized and a method of fabricating the display device.

The problems to be solved by the present invention are not limited to those mentioned above, and other technical problems not mentioned will be clearly understood by those skilled in the art from the following description.

### [Technical Solution]

In order to achieve the above object, there is provided a display device including: a first light emitting element; a (1-1)-th transistor including a drain electrode connected to a driving voltage line and a source electrode connected to a first anode of the first light emitting element; a (1-2)-th transistor including a gate electrode connected to a first scan line, a drain electrode connected to a first data line, and a source electrode connected to a gate electrode of the (1-1)-th transistor; a (1-3)-th transistor including a gate electrode connected to a second scan line, a drain electrode connected to the first anode of the first light emitting element, and a source electrode connected to an initialization voltage line; a second light emitting element; a (2-1)-th transistor including a drain electrode connected to a driving voltage line and a source electrode connected to a second anode of the second light emitting element; a (2-2)-th transistor including a gate electrode connected to the first scan line, a drain electrode connected to a second data line, and a source electrode connected to a gate electrode of the (2-1)-th transistor; a (2-3)-th transistor including a gate electrode connected to the second scan line, a drain electrode connected to the second anode of the second light emitting element, and a source electrode connected to the initialization voltage line; a first data connection electrode connected to the first data line and the drain electrode of the (1-2)-th transistor; and a second data connection electrode connected to the second data line and the drain electrode of the (2-2)-th transistor, wherein at least one of the drain electrode of the (1-2)-th transistor and the first data connection electrode is cut, the second data connection electrode is cut, and the second data connection electrode and the first data line are connected to each other.

According to another aspect of the present disclosure, there is provided a display device including: a first light emitting element; a (1-1)-th transistor including a drain electrode connected to a driving voltage line and a source electrode connected to a first anode of the first light emitting element; a (1-2)-th transistor including a gate electrode connected to a first scan line, a drain electrode connected to a first data line, and a source electrode connected to a gate electrode of the (1-1)-th transistor; a (1-3)-th transistor including a gate electrode connected to a second scan line, a drain electrode connected to the first anode of the first light emitting element, and a source electrode connected to an initialization voltage line; a second light emitting element; a (2-1)-th transistor including a drain electrode connected to a driving voltage line and a source electrode connected to a second anode of the second light emitting element; a (2-2)-th transistor including a gate electrode connected to the first scan line, a drain electrode connected to a second data line, and a source electrode connected to a gate electrode of the (2-1)-th transistor; a (2-3)-th transistor including a gate electrode connected to the second scan line, a drain electrode connected to the second anode of the second light emitting element, and a source electrode connected to the initialization voltage line; a first light blocking layer overlapping the gate electrode of the (1-1)-th transistor; a first anode connection electrode overlapping the gate electrode of the (1-1)-th transistor and connected to the first light blocking layer and the drain electrode of the (1-3)-th transistor; a second anode connection electrode overlapping the gate electrode of the (2-1)-th transistor and connected to the second anode; and a dummy electrode extending from the second anode connection electrode to overlap the first light blocking layer.

According to another aspect of the present disclosure, there is provided a method of fabricating a display device. The method includes: forming, on a substrate, a (1-1)-th transistor including a drain electrode connected to a driving voltage line, a (1-2)-th transistor including a gate electrode connected to a first scan line, a drain electrode connected to a first data line and a source electrode connected to a gate electrode of the (1-1)-th transistor, a (1-3)-th transistor including a gate electrode connected to a second scan line and a source electrode connected to an initialization voltage line, a (2-1)-th transistor including a drain electrode connected to a driving voltage line, a (2-2)-th transistor including a gate electrode connected to the first scan line, a drain electrode connected to a second data line and a source electrode connected to a gate electrode of the (2-1)-th transistor, and a (2-3)-th transistor including a gate electrode connected to the second scan line and a source electrode connected to the initialization voltage line; forming a first insulating layer on the (1-1)-th transistor, the (1-2)-th transistor, the (1-3)-th transistor, the (2-1)-th transistor, the (2-2)-th transistor, and the (2-3)-th transistor; forming, on the first insulating layer, a first data connection electrode connected to the first data line and the drain electrode of the (1-2)-th transistor and a second data connection electrode connected to the second data line and the drain electrode of the (2-2)-th transistor; forming a second insulating layer on the first data connection electrode and the second data connection electrode; cutting at least one of the drain electrode of the (1-2)-th transistor and the first data connection electrode; cutting the second data connection electrode; and connecting the second data connection electrode and the first data line to each other.

According to another aspect of the present disclosure, there is provided a method of fabricating a display device. The method includes: forming, on a substrate, a (1-1)-th transistor including a drain electrode connected to a driving voltage line, a (1-2)-th transistor including a gate electrode connected to a first scan line, a drain electrode connected to a first data line and a source electrode connected to a gate electrode of the (1-1)-th transistor, a (1-3)-th transistor including a gate electrode connected to a second scan line and a source electrode connected to an initialization voltage line, a (2-1)-th transistor including a drain electrode connected to a driving voltage line, a (2-2)-th transistor including a gate electrode connected to the first scan line, a drain electrode connected to a second data line and a source electrode connected to a gate electrode of the (2-1)-th transistor, a (2-3)-th transistor including a gate electrode connected to the second scan line and a source electrode connected to the initialization voltage line, and a first light blocking layer overlapping the gate electrode of the (1-1)-th transistor; forming a first insulating layer on the (1-1)-th transistor, the (1-2)-th transistor, the (1-3)-th transistor, the (2-1)-th transistor, the (2-2)-th transistor, the (2-3)-th transistor, and the first light blocking layer; and forming, on the first insulating layer, a first anode connection electrode overlapping the gate electrode of the (1-1)-th transistor and connected to the first light blocking layer and a drain electrode of the (1-3)-th transistor, a second anode connection electrode overlapping the gate electrode of the (2-1)-th transistor, and a dummy electrode extending from the second anode connection electrode to overlap the first light blocking layer.

The specific details of other embodiments are included in the detailed description and drawings.

### [Advantageous Effects of the Invention]

According to the display device of the present invention, the defect rate and degradation of image quality can be minimized. For example, the visibility issue of defective pixels can be resolved by repairing defective pixels with high visibility through the pixel circuit of normal pixels with low visibility.

Meanwhile, the effects obtainable from the present invention are not limited to the effects mentioned above, and other effects not mentioned herein will be clearly understood by those skilled in the art from the following description.

### [Brief Description of the Drawings]

FIG. 1 is a schematic plan view of a part of a display device according to an embodiment of the present disclosure;
FIG. 2 is a circuit diagram of the display device according to the embodiment;
FIGS. 3 through 5 are plan views of the display device according to the embodiment;
FIG. 6 is a cross-sectional view taken along line I-I' of FIG. 3;
FIG. 7 is a circuit diagram for explaining a method of fabricating a display device according to an embodiment;
FIGS. 8 through 18 are array diagrams for explaining a method of fabricating a display device according to an embodiment;
FIGS. 19 and 20 are diagrams for explaining a process of repairing a display device according to an embodiment;
FIGS. 21 through 23 are diagrams for explaining a method of fabricating a display device according to an embodiment;
FIGS. 24 and 25 are diagrams for explaining a process of repairing a display device according to an embodiment;
FIGS. 26 through 31 are diagrams for explaining a method of fabricating a display device according to an embodiment;
FIGS. 32 through 36 are diagrams for explaining a method of fabricating a display device according to an embodiment;
FIGS. 37 through 40 are diagrams for explaining a method of fabricating a display device according to an embodiment;
FIG. 41 is a circuit diagram of a display device according to an embodiment;
FIG. 42 is a plan view of a display device according to an embodiment;
FIG. 43 is a circuit diagram for explaining a method of fabricating a display device according to an embodiment;
FIGS. 44 through 47 are diagrams for explaining a method of fabricating a display device according to an embodiment;
FIG. 48 is a circuit diagram of a display device according to an embodiment;
FIGS. 49 through 51 are plan views of a display device according to an embodiment;
FIG. 52 is a cross-sectional view taken along line A-A' of FIG. 49;
FIG. 53 is a circuit diagram for explaining a method of fabricating a display device according to an embodiment; and
FIGS. 54 through 64 are array diagrams for explaining a method of fabricating a display device according to an embodiment.

### [Mode for Carrying Out the Invention]

The advantages and features of the present invention, and methods for achieving them, will be clearly understood by referring to the embodiments described in detail below together with the accompanying drawings. However, the present invention is not limited to the embodiments disclosed below but may be implemented in various different forms. The embodiments are provided merely to complete the disclosure of the present invention and to fully inform those skilled in the art of the scope of the invention, which is defined only by the scope of the claims.

The expression that an element or layer is "on" another element or layer includes both the case where it is directly on the other element and the case where another layer or element is interposed in between. Throughout the specification, like reference numerals denote like elements. The shapes, sizes, ratios, angles, numbers, and the like disclosed in the drawings for describing the embodiments are merely illustrative, and the present invention is not limited to those illustrated features.

Although terms such as first, second, etc., are used to describe various components, it is to be understood that these components are not limited by these terms. These terms are only used to distinguish one component from another. Therefore, a first component mentioned below may also be referred to as a second component within the technical scope of the present invention.

The respective features of the various embodiments of the present invention may be combined or selectively combined in whole or in part, various technical linkages and operations are possible, and each embodiment may be independently implemented or implemented in association with each other.

Specific embodiments will be described below with reference to the accompanying drawings.

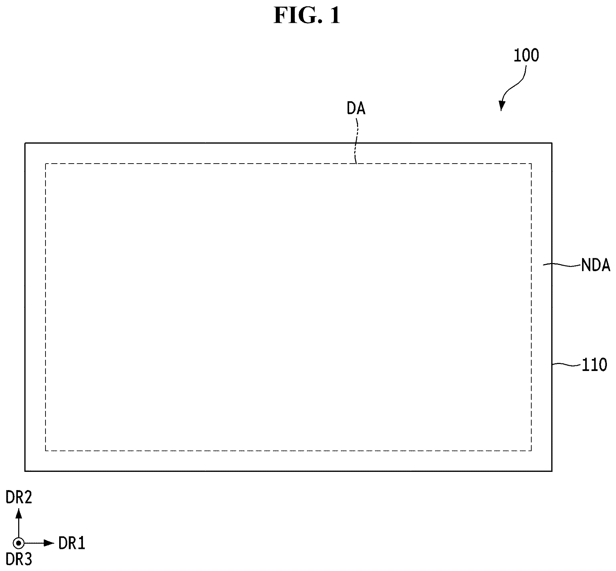

FIG. 1 is a schematic plan view of a part of a display device 100 according to an embodiment of the present disclosure.

The display device 100 according to the embodiment of the present disclosure may include a display panel 110 as illustrated in FIG. 1. The display device 100 may be any device that includes the display panel 110. For example, the display device 100 may be various products such as a smartphone, a tablet, a laptop, a television, or a billboard. The display panel 110 may include a display area DA and a non-display area NDA outside the display area DA.

The display area DA is a part that displays an image, and a plurality of pixels may be disposed in the display area DA. When viewed in a direction (e.g., a third direction DR3) substantially perpendicular to the display panel 110, the display area DA may have various shapes, for example, an oval shape, a polygonal shape, or a shape of a specific figure.

The display panel 110 included in the display device 100 according to the embodiment may have the display area DA having a greater length in a first direction DR1 which is a horizontal direction than in a second direction DR2 which is a vertical direction. When the display panel 110 has the display area DA of such a shape, it may be understood that a substrate included in the display panel 110 has the display area DA of such a shape. Various driver circuits may be located in a peripheral area PA of the display panel 110.

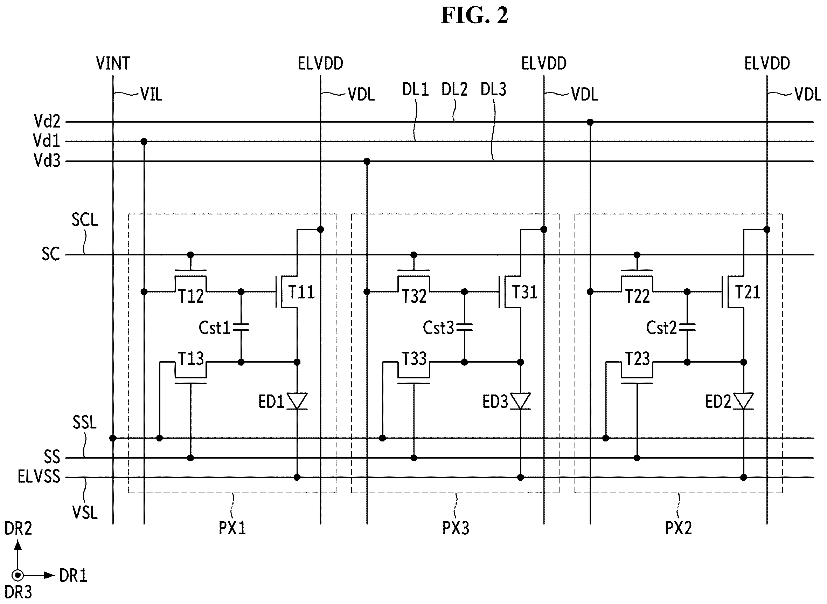

FIG. 2 is a circuit diagram of the display device 100 according to the embodiment.

The display device 100 according to the embodiment may include a plurality of pixels PX1 through PX3. FIG. 2 illustrates three adjacent pixels PX1 through PX3 among the pixels.

As illustrated in FIG. 2, the pixels PX1 through PX3 may include a first pixel PX1, a second pixel PX2, and a third pixel PX3. Each of the first pixel PX1, the second pixel PX2, and the third pixel PX3 may include a plurality of transistors, at least one capacitor, and at least one light emitting diode as a light emitting element.

For example, the first pixel PX1 may include a (1-1)th transistor T11 (hereinafter, referred to as an eleventh transistor T11), a (1-2)th transistor T12 (hereinafter, referred to as a twelfth transistor T12), a (1-3)th transistor T13 (hereinafter, referred to as a thirteenth transistor T13), a first capacitor Cst1, and a first light emitting element ED1.

The second pixel PX2 may include a (2-1)th transistor T21 (hereinafter, referred to as a twenty-first transistor T21), a (2-2)th transistor T22 (hereinafter, referred to as a twenty-second transistor T22), a (2-3)th transistor T23 (hereinafter, referred to as a twenty-third transistor T23), a second capacitor Cst2, and a second light emitting element ED2.

The third pixel PX3 may include a (3-1)th transistor T31 (hereinafter, referred to as a thirty-first transistor T31), a (3-2)th transistor T32 (hereinafter, referred to as a thirty-second transistor T32), a (3-3)th transistor T33 (hereinafter, referred to as a thirty-third transistor T33), a third capacitor Cst3, and a third light emitting element ED3.

The first light emitting element ED1, the second light emitting element ED2, and the third light emitting element ED3 may provide light of different colors. For example, the first light emitting element ED1 may include a light emitting layer that provides green light, the second light emitting element ED2 may include a light emitting layer that provides red light, and the third light emitting element ED3 may include a light emitting layer that provides blue light. However, the present disclosure is not limited thereto. For example, the first light emitting element ED1 may include a light emitting layer that provides red light or blue light, the second light emitting element ED2 may include a light emitting layer that provides green light or blue light, and the third light emitting element ED3 may include a light emitting layer that provides blue light or green light.

The first pixel PX1, the second pixel PX2, and the third pixel PX3 may have the same configuration. Therefore, the eleventh transistor T11, the twelfth transistor T12, the thirteenth transistor T13, the first capacitor Cst1, and the first light emitting element ED1 included in the first pixel PX1 will be described as a representative example.

A gate electrode of the eleventh transistor T11 may be connected to a first electrode of the capacitor Cst, a drain electrode of the eleventh transistor T11 may be connected to a driving voltage line VDL that transmits a driving voltage ELVDD, and a source electrode of the eleventh transistor T11 may be connected to an anode of the first light emitting element ED1 and a second electrode of the first capacitor Cst1. The eleventh transistor T11 may receive a data voltage Vd1, Vd2 or Vd3 according to a switching operation of the twelfth transistor T12 and supply a driving current to the first light emitting element ED1 according to a voltage stored in the first capacitor Cst1.

A gate electrode of the twelfth transistor T12 may be connected to a first scan line SCL that transmits a first scan signal SC, a drain electrode of the twelfth transistor T12 may be connected to a first data line DL1 that can transmit a data voltage or a reference voltage, and a source electrode of the twelfth transistor T12 may be connected to the first electrode of the first capacitor Cst1 and the gate electrode of the eleventh transistor T11. A plurality of data lines DL1 through DL3 may transmit different data voltages. For example, the first data line DL1 may transmit a first data voltage Vd1, a second data line DL2 may transmit a second data voltage Vd2, and a third data line DL3 may transmit a third data voltage Vd3. The twelfth transistors T12, T22 and T32 of the pixels PX1, PX2 and PX3 may be connected to different data lines DL1, DL2 and DL3. For example, the twelfth transistor T12 may be connected to the first data line DL1, the twenty-second transistor T22 may be connected to the second data line DL2, and the thirty-second transistor T32 may be connected to the third data line DL3.

The twelfth transistor T12 may be turned on according to the first scan signal SC from the first scan line SCL to transmit the reference voltage or the first data voltage Vd1 to the gate electrode of the eleventh transistor T11 and the first electrode of the first capacitor Cst1.

A gate electrode of the thirteenth transistor T13 may be connected to a second scan line SSL that transmits a second scan signal SS from the second scan line SSL, a drain electrode of the thirteenth transistor T13 may be connected to the second electrode of the first capacitor Cst1, the source electrode of the eleventh transistor T11 and the anode of the first light emitting element ED1, and a source electrode of the thirteenth transistor T13 may be connected to an initialization voltage line VIL that transmits an initialization voltage VINT. The thirteenth transistor T13 may be turned on according to the second scan signal SS to transmit the initialization voltage INIT to the anode of the first light emitting element ED1 and the second electrode of the first capacitor Cst1, thereby initializing the voltage of the anode of the first light emitting element ED1.

The first electrode of the first capacitor Cst1 is connected to the gate electrode of the eleventh transistor T11, and the second electrode of the first capacitor Cst1 is connected to the drain electrode of the thirteenth transistor T13 and the anode of the first light emitting element ED1. A cathode of the first light emitting element ED1 is connected to a common voltage line VSL that transmits a common voltage ELVSS.

The first light emitting element ED1 may emit light with a luminance according to the driving current generated by the eleventh transistor T11.

An example of the operation of the circuit illustrated in FIG. 1, particularly an example of the operation during one frame, will be described as follows. Here, a case where the transistors T11 through T13 are N-type channel transistors will be described as an example, but the present disclosure is not limited thereto.

When a frame starts, the first scan signal SC at a high level and the second scan signal SS at a high level may be supplied in an initialization period to turn on the twelfth transistor T12 and the thirteenth transistor T13. The reference voltage from the first data line DL1 may be supplied to the gate electrode of the eleventh transistor T11 and one end of the first capacitor Cst1 through the turned-on twelfth transistor T12, and the initialization voltage INIT may be supplied to the source electrode of the eleventh transistor T11 and the anode of the first light emitting element ED1 through the turned-on thirteenth transistor T13. Accordingly, during the initialization period, the source electrode of the eleventh transistor T11 and the anode of the first light emitting element ED1 may be initialized to the initialization voltage INIT. Here, a difference voltage between the reference voltage and the initialization voltage INIT may be stored in the first capacitor Cst1.

Next, when the second scan signal SS becomes a low level while the first scan signal SC at a high level is maintained in a sensing period, the twelfth transistor T12 may be kept turned on, and the thirteenth transistor T13 may be turned off. The gate electrode of the eleventh transistor T11 and the one end of the first capacitor Cst1 may maintain the reference voltage through the turned-on twelfth transistor T12, and the source electrode of the eleventh transistor T11 and the anode of the first light emitting element ED1 may be electrically isolated from the initialization voltage line VIL through the turned-off thirteenth transistor T13. Accordingly, the eleventh transistor T11 may be turned off when the voltage of the source electrode becomes "reference voltage - Vth" while a current flows from the drain electrode to the source electrode. Vth represents a threshold voltage of the eleventh transistor T11. Here, a voltage difference between the gate electrode and the source electrode of the eleventh transistor T11 may be stored in the capacitor Cst, and sensing of the threshold voltage Vth of the eleventh transistor T11 may be completed. Since a data signal compensated based on characteristic information sensed during the sensing period is generated, a difference in the characteristics of the eleventh transistor T11 between pixels can be externally compensated.

Next, when the first scan signal SC at a high level and the second scan signal SS at a low level are supplied in a data input period, the twelfth transistor T12 may be turned on, and the thirteenth transistor T13 may be turned off. A data voltage from each data line DL1, DL2 or DL3 is supplied to the gate electrode of each eleventh transistor T11, T21 or T31 and the one end of each capacitor Cst1, Cst2 or Cst3 through the turned-on twelfth transistor T12, T22 or T32 of each pixel PX1, PX2 or PX3. Here, the source electrode of each eleventh transistor T11, T21 or T31 and the anode of each light emitting element ED1, ED2 or ED3 can maintain the potential in the sensing period almost as it is through the turned-off eleventh transistor T11, T21 or T31.

Next, each eleventh transistor T11, T21 or T31 turned on by a data voltage transmitted to the gate electrode in a light emission period may generate a driving current according to the data voltage, and each light emitting element ED1, ED2 or ED3 may emit light in response to the driving current.

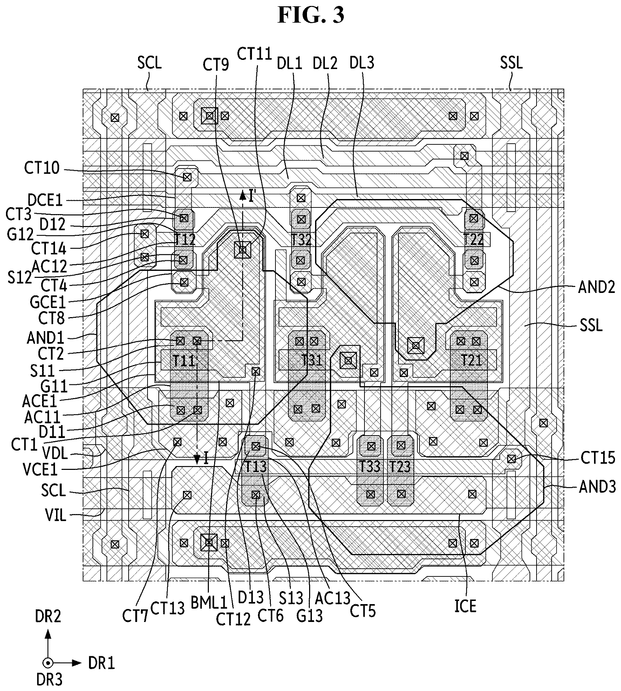

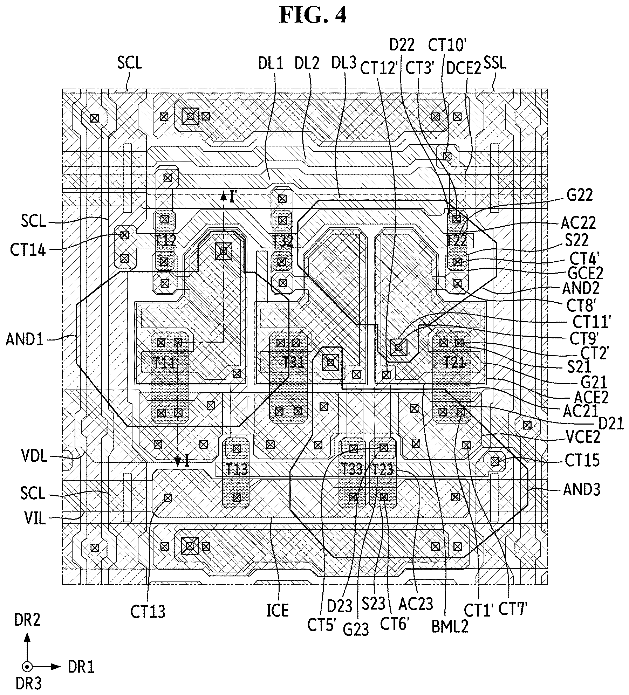

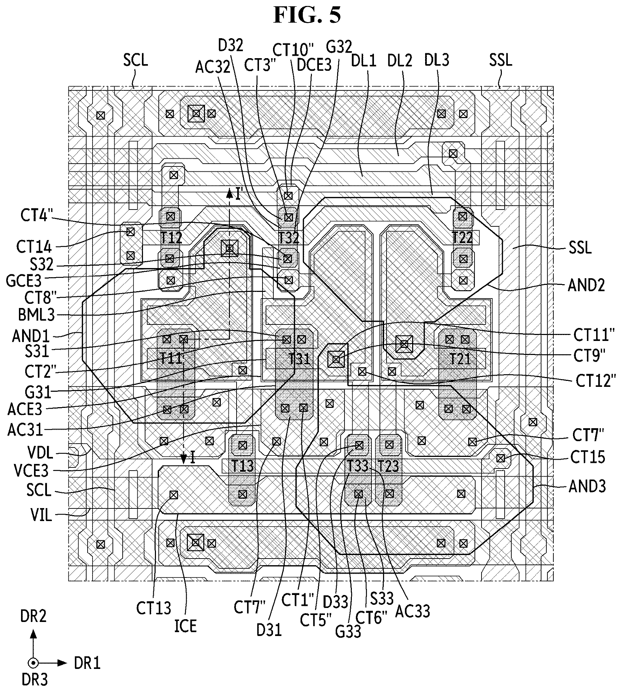

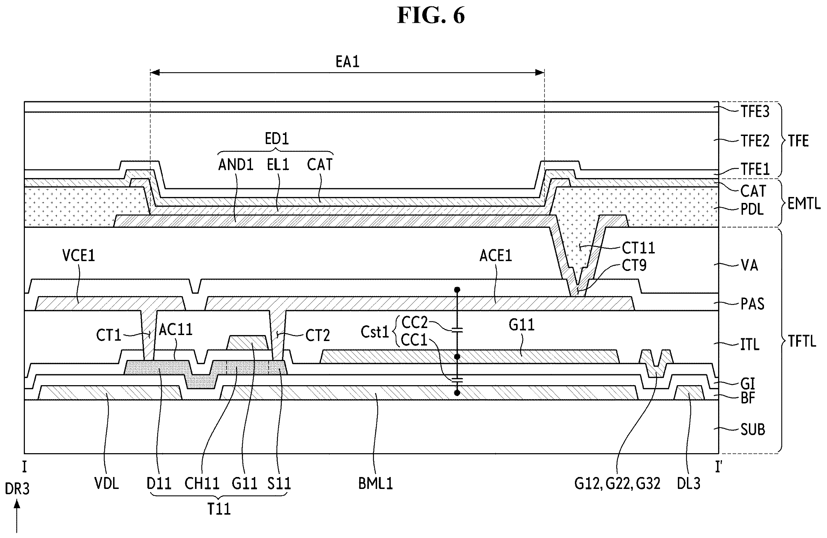

FIGS. 3 through 5 are plan views of the display device 100 according to the embodiment. For example, FIG. 3 may be a plan view of the display device 100 including the first through third pixels PX1 through PX3 of FIG. 2. FIG. 3 may include reference numerals related to the first pixel PX1. FIG. 4 is the same drawing as FIG. 3 and may include reference numerals related to the second pixel PX2. FIG. 5 is the same drawing as FIG. 3 and may include reference numerals related to the third pixel PX3. FIG. 6 is a cross-sectional view taken along line I-I' of FIG. 3.

As illustrated in FIG. 6, the display device 100 may include a substrate SUB, a thin-film transistor layer TFTL, a light emitting element layer EMTL, and an encapsulation layer ENC. The thin-film transistor layer TFTL, the light emitting element layer EMTL, and the encapsulation layer ENC may be sequentially disposed on the substrate SUB along the third direction DR3. Here, the thin-film transistor layer TFTL may include the eleventh transistors T11, T21 and T31, the twelfth transistors T12, T22 and T22, and the thirteenth transistors T13, T23 and T33 described above.

The substrate SUB may be a rigid substrate or a flexible substrate that can be bent, folded, rolled, etc. The substrate SUB may be made of an insulating material such as glass, quartz, or polymer resin. The polymer material may be, for example, polyethersulphone (PES), polyacrylate (PA), polyarylate (PAR), polyetherimide (PEI), polyethylene naphthalate (PEN), polyethylene terepthalate (PET), polyphenylene sulfide (PPS), polyallylate, polyimide (PI), polycarbonate (PC), cellulose triacetate CAT, cellulose acetate propionate (CAP), or a combination thereof. Alternatively, the first substrate SUB may include a metal material.

As illustrated in FIG. 6, a first pattern layer may be disposed on the substrate SUB. The first pattern layer may include, for example, a first light blocking layer BML1, a second light blocking layer BML2, a third light blocking layer BML3, the first data line DL1, the second data line DL2, the third data line DL3, the driving voltage line VDL, and the initialization voltage line VIL as illustrated in FIGS. 3 through 6. As illustrated in FIG. 6, the driving voltage line VDL, the first light blocking layer BML1, and the third data line DL3 may be disposed on the substrate SUB.

The first light blocking layer BML1 may be made of, for example, a metal material such as chromium (Cr) or molybdenum (Mo) or may be made of black ink or black dye. When a light blocking layer is made of a metal material, it may receive static power. Accordingly, the light blocking layer may not float electrically, and the electrical characteristics of transistors on the light blocking layer may be stabilized. The second light blocking layer BML2 and the third light blocking layer BML3 may be made of the same material as the first light blocking layer BML1 described above.

The first data line DL1, the second data line DL2, the third data line DL3, the driving voltage line VDL, and the initialization voltage line VIL may each extend along the first direction DR1. The first data line DL1 may be disposed between the second data line DL2 and the third data line DL3. The first data line DL1, the second data line DL2, the third data line DL3, the driving voltage line VDL, and the initialization voltage line VIL may be made of the same material as the first light blocking layer BML1 described above.

According to an embodiment, as illustrated in FIG. 3, the first data line DL1 may be disposed at an uppermost position, and the third data line DL3 may be disposed at a lowermost position. For example, among the first through third data lines DL1 through DL3, the second data line DL2 may be disposed furthest from a gate structure (e.g., a twelfth gate electrode G12, a thirty-second gate electrode G32 and a twenty-second gate electrode G22), and the third data line DL3 may be disposed closest to the gate structure.

A buffer layer BF may be disposed on the first pattern layer. For example, as in the example illustrated in FIG. 6, the buffer layer BF may be disposed on the driving voltage line VDL, the first light blocking layer BML1, and the third data line DL3. The buffer layer BF may be a layer for protecting transistors T1 through T3 of the thin-film transistor layer TFTL and light emitting layers EL of the light emitting element layer EMTL from moisture introduced through the substrate SUB which is vulnerable to moisture penetration. The buffer layer BF may be composed of a plurality of inorganic layers stacked alternately. For example, the buffer layer BF may be a multilayer in which one or more inorganic layers selected from a silicon nitride layer, a silicon oxynitride layer, a silicon oxide layer, a titanium oxide layer, and an aluminum oxide layer are alternately stacked.

A second pattern layer may be disposed on the buffer layer BF. The second pattern layer may include, as illustrated in FIGS. 3 through 6, a (1-1)th active layer AC11 (hereinafter, referred to as an eleventh active layer AC11), a (1-2)th active layer AC12 (hereinafter, referred to as a twelfth active layer AC12), a (1-3)th active layer AC13 (hereinafter, referred to as a thirteenth active layer AC13), a (2-1)th active layer AC21 (hereinafter, referred to as a twenty-first active layer AC21), a (2-2)th active layer AC22 (hereinafter, referred to as a twenty-second active layer AC22), a (2-3)th active layer AC23 (hereinafter, referred to as a twenty-third active layer AC23), a (3-1)th active layer AC31 (hereinafter, referred to as a thirty-first active layer AC31), a (3-2)th active layer AC32 (hereinafter, referred to as a thirty-second active layer AC32), and a (3-3)th active layer AC33 (hereinafter, referred to as a thirty-third active layer AC33). As in the example illustrated in FIG. 6, the eleventh active layer AC11 may be disposed on the buffer layer BF.

The eleventh active layer AC11, the twelfth active layer AC12, the thirteenth active layer AC13, the twenty-first active layer AC21, the twenty-second active layer AC22, the twenty-third active layer AC23, the thirty-first active layer AC31, the thirty-second active layer AC32, and the thirty-third active layer AC33 may overlap the first pattern layer thereunder. For example, as illustrated in FIG. 6, the eleventh active layer AC11 may be disposed on the buffer layer BF to overlap the driving voltage line VDL and the first light blocking layer BML1.

The eleventh active layer AC11 may be an active layer made of low temperature polycrystalline silicon (LTPS). In addition, the eleventh active layer AC11 may be an oxide-based active layer. For example, the first active layer may be an oxide semiconductor including indium-gallium-zinc-oxide (IGZO) or indium-gallium-zinc-tin oxide (IGZTO). Each of the twelfth active layer AC12, the thirteenth active layer AC13, the twenty-first active layer AC21, the twenty-second active layer AC22, the twenty-third active layer AC23, the thirty-first active layer AC31, the thirty-second active layer AC32, and the thirty-third active layer AC33 may include the same material as the eleventh active layer AC11 described above.

As illustrated in FIG. 6, a gate insulating layer GI may be disposed on the second pattern layer. For example, as illustrated in FIG. 6, the gate insulating layer GI may be disposed on the eleventh active layer AC11.

The gate insulating layer GI may include at least one of tetraethylorthosilicate (TEOS), silicon nitride (SiNx), and silicon oxide (SiO2). For example, the gate insulating layer GI may have a double-layer structure in which a silicon nitride layer with a thickness of 40 nm and a tetraethylorthosilicate layer with a thickness of 80 nm are sequentially stacked.

A third pattern layer may be disposed on the gate insulating layer GI. The third pattern layer may include, as illustrated in FIGS. 3 through 6, a (1-1)th gate electrode G11 (hereinafter, referred to as an eleventh gate electrode G11), a (1-2)th gate electrode G12 (hereinafter, referred to as a twelfth gate electrode G12), a (1-3)th gate electrode G13 (hereinafter, referred to as a thirteenth gate electrode G13), a (2-1)th gate electrode G21 (hereinafter, referred to as a twenty-first gate electrode G21), a (2-2)th gate electrode G22 (hereinafter, referred to as a twenty-second gate electrode G22), a (2-3)th gate electrode G23 (hereinafter, referred to as a twenty-third gate electrode G23), a (3-1)th gate electrode G31 (hereinafter, referred to as a thirty-first gate electrode G31), a (3-2)th gate electrode G32 (hereinafter, referred to as a thirty-second gate electrode G32), and a (3-3)th gate electrode G33 (hereinafter, referred to as a thirty-third gate electrode G33). As in the example illustrated in FIG. 6, the eleventh gate electrode G11, the twelfth gate electrode G12, the twenty-second gate electrode G22, and the thirty-second gate electrode G32 may be disposed on the gate insulating layer GI.

The eleventh gate electrode G11 may be disposed on the gate insulating layer GI to overlap the eleventh active layer AC11 and the first light blocking layer BML1, the twelfth gate electrode G12 may be disposed on the gate insulating layer GI to overlap the twelfth active layer AC12, the thirteenth gate electrode G13 may be disposed on the gate insulating layer GI to overlap the thirteenth active layer AC13, the twenty-first gate electrode G21 may be disposed on the gate insulating layer GI to overlap the twenty-first active layer AC21 and the second light blocking layer BML2, the twenty-second gate electrode G22 may be disposed on the gate insulating layer GI to overlap the twenty-second active layer AC22, the twenty-third gate electrode G23 may be disposed on the gate insulating layer GI to overlap the twenty-third active layer AC23, the thirty-first gate electrode G31 may be disposed on the gate insulating layer GI to overlap the thirty-first active layer AC31 and the third light blocking layer BML3, the thirty-second gate electrode G32 may be disposed on the gate insulating layer GI to overlap the thirty-second active layer AC32, and the thirty-third gate electrode G33 may be disposed on the gate insulating layer GI to overlap the thirty-third active layer AC33.

A first intermediate capacitor CC1 of the first capacitor Cst1 may be formed in an overlapping area of the eleventh gate electrode G11 and the first light blocking layer BML1.

A region of the eleventh active layer AC11 which is overlapped by the eleventh gate electrode G11 may be a channel region CH11 of the eleventh transistor T11. In addition, two regions of the eleventh active layer AC11 which are not overlapped by the eleventh gate electrode G11 and are separated by the eleventh gate electrode G11 in plan view may be a (1-1)th drain electrode D11 (hereinafter, referred to as an eleventh drain electrode D11) and a (1-1)th source electrode S11 (hereinafter, referred to as an eleventh source electrode S11) of the eleventh transistor T11, respectively.

A region of the twelfth active layer AC12 which is overlapped by the twelfth gate electrode G12 may be a channel region of the twelfth transistor T12. In addition, two regions of the twelfth active layer AC12 which are not overlapped by the twelfth gate electrode G12 and are separated by the twelfth gate electrode G12 in plan view may be a (1-2)th drain electrode D12 (hereinafter, referred to as a twelfth drain electrode D12) and a (1-2)th source electrode S12 (hereinafter, referred to as a twelfth source electrode S12) of the twelfth transistor T12, respectively.

A region of the thirteenth active layer AC13 which is overlapped by the thirteenth gate electrode G13 may be a channel region of the thirteenth transistor T13. In addition, two regions of the thirteenth active layer AC13 which are not overlapped by the thirteenth gate electrode G13 and are separated by the thirteen gate electrode G13 in plan view may be a (1-3)th drain electrode D13 (hereinafter, referred to as a thirteenth drain electrode D13) and a (1-3)th source electrode S13 (hereinafter, referred to as a thirteenth source electrode S13) of the thirteenth transistor T13, respectively.

A first intermediate capacitor of the second capacitor Cst2 may be formed in an overlapping area of the twenty-first gate electrode G21 and the second light blocking layer BML2.

A region of the twenty-first active layer AC21 which is overlapped by the twenty-first gate electrode G21 may be a channel region of the twenty-first transistor T21. In addition, two regions of the twenty-first active layer AC21 which are not overlapped by the twenty-first gate electrode G21 and are separated by the twenty-first gate electrode G21 in plan view may be a (2-1)th drain electrode D21 (hereinafter, referred to as a twenty-first drain electrode D21) and a (2-1)th source electrode S21 (hereinafter, referred to as a twenty-first source electrode S21) of the twenty-first transistor T21, respectively.

A region of the twenty-second active layer AC22 which is overlapped by the twenty-second gate electrode G22 may be a channel region of the twenty-second transistor T22. In addition, two regions of the twenty-second active layer AC22 which are not overlapped by the twenty-second gate electrode G22 and are separated by the twenty-second gate electrode G22 in plan view may be a (2-2)th drain electrode D22 (hereinafter, referred to as a twenty-second drain electrode D22) and a (2-2)th source electrode S22 (hereinafter, referred to as a twenty-second source electrode S22) of the twenty-second transistor T22, respectively.

A region of the twenty-third active layer AC23 which is overlapped by the twenty-third gate electrode G23 may be a channel region of the twenty-third transistor T23. In addition, two regions of the twenty-third active layer AC23 which are not overlapped by the twenty-third gate electrode G23 and are separated by the twenty-third gate electrode G23 in plan view may be a (2-3)th drain electrode D23 (hereinafter, referred to as a twenty-third drain electrode D23) and a (2-3)th source electrode S23 (hereinafter, referred to as a twenty-third source electrode S23) of the twenty-third transistor T23, respectively.

A first intermediate capacitor of the third capacitor Cst3 may be formed in an overlapping area of the thirty-first gate electrode G31 and the third light blocking layer BML3.

A region of the thirty-first active layer AC31 which is overlapped by the thirty-first gate electrode G31 may be a channel region of the thirty-first transistor T31. In addition, two regions of the thirty-first active layer AC31 which are not overlapped by the thirty-first gate electrode G31 and are separated by the thirty-first gate electrode G31 in plan view may be a (3-1)th drain electrode D31 (hereinafter, referred to as a thirty-first drain electrode D31) and a (3-1)th source electrode S31 (hereinafter, referred to as a thirty-first source electrode S31) of the thirty-first transistor T31, respectively.

A region of the thirty-second active layer AC32 which is overlapped by the thirty-second gate electrode G32 may be a channel region of the thirty-second transistor T32. In addition, two regions of the thirty-second active layer AC32 which are not overlapped by the thirty-second gate electrode G32 and are separated by the thirty-second gate electrode G32 in plan view may be a (3-2)th drain electrode D32 (hereinafter, referred to as a thirty-second drain electrode D32) and a (3-2)th source electrode S32 (hereinafter, referred to as a thirty-second source electrode S32) of the thirty-second transistor T32, respectively.

A region of the thirty-third active layer AC33 which is overlapped by the thirty-third gate electrode G33 may be a channel region of the thirty-third transistor T33. In addition, two regions of the thirty-third active layer AC33 which are not overlapped by the thirty-third gate electrode G33 and are separated by the thirty-third gate electrode G33 in plan view may be a (3-3)th drain electrode D33 (hereinafter, referred to as a thirty-third drain electrode D33) and a (3-3)th source electrode S33 (hereinafter, referred to as a thirty-third source electrode S33) of the thirty-third transistor T33, respectively.

The twelfth gate electrode G12, the twenty-second gate electrode G22, and the thirty-second gate electrode G32 may be integrally formed with each other. A gate structure including the twelfth gate electrode G12, the twenty-second gate electrode G22, and the thirty-second gate electrode G32 may extend along the first direction DR1.

The thirteenth gate electrode G13, the twenty-third gate electrode G23, and the thirty-third gate electrode G33 may be integrally formed with each other. A gate structure including the thirteenth gate electrode G13, the twenty-third gate electrode G23, and the thirty-third gate electrode G33 may extend along the first direction DR1.

An interlayer insulating layer ITL may be disposed on the third pattern layer. For example, as illustrated in FIG. 6, the interlayer insulating layer ITL may be disposed on the eleventh gate electrode G11, the twelfth gate electrode G12, the twenty-second gate electrode G22, and the thirty-second gate electrode G32.

The interlayer insulating layer ITL may include an inorganic layer, for example, a silicon nitride layer, a silicon oxynitride layer, a silicon oxide layer, a titanium oxide layer, or an aluminum oxide layer. The interlayer insulating layer ITL may include a plurality of inorganic layers.

A fourth pattern layer may be disposed on the interlayer insulating layer ITL. The fourth pattern layer may include, as illustrated in FIGS. 3 through 6, a first anode connection electrode ACE1, a second anode connection electrode ACE2, a third anode connection electrode ACE3, a first gate connection electrode GCE1, a second gate connection electrode GCE2, a third gate connection electrode GCE3, a first data connection electrode DCE1, a second data connection electrode DCE2, a third data connection electrode DCE3, a first driving connection electrode VCE1, a second driving connection electrode VCE2, a third driving connection electrode VCE3, an initialization connection electrode ICE, the first scan line SCL, and the second scan line SSL. As in the example illustrated in FIG. 6, the first driving connection electrode VCE1 and the first anode connection electrode ACE1 may be disposed on the interlayer insulating layer ITL.

The first anode connection electrode ACE1 may overlap the eleventh gate electrode G11. A second intermediate capacitor CC2 of the first capacitor Cst1 may be formed in an overlapping area of the first anode connection electrode ACE1 and the eleventh gate electrode G11. The first capacitor Cst1 may include the first intermediate capacitor CC1 and the second intermediate capacitor CC2. The first anode connection electrode ACE1 may be connected to the eleventh source electrode S11 of the eleventh transistor T11 through a second contact hole CT2 penetrating the interlayer insulating layer ITL and the gate insulating layer GI. In addition, the first anode connection electrode ACE1 may be connected to the first light blocking layer BML1 through a twelfth contact hole CT12 penetrating the interlayer insulating layer ITL, the gate insulating layer GI, and the buffer layer BF. In addition, the first anode connection electrode ACE1 may be connected to the thirteenth drain electrode D13 of the thirteenth transistor T13 through a fifth contact hole CT5 penetrating the interlayer insulating layer ITL and the gate insulating layer GI.

The second anode connection electrode ACE2 may overlap the twenty-first gate electrode G21. A second intermediate capacitor of the second capacitor Cst2 may be formed in an overlapping area of the second anode connection electrode ACE2 and the twenty-first gate electrode G21. The second capacitor Cst2 may include the first intermediate capacitor and the second intermediate capacitor. The second anode connection electrode ACE2 may be connected to the twenty-first source electrode S21 of the twenty-first transistor T21 through a second contact hole CT2' penetrating the interlayer insulating layer ITL and the gate insulating layer GI. In addition, the second anode connection electrode ACE2 may be connected to the second light blocking layer BML2 through a twelfth contact hole CT12' penetrating the interlayer insulating layer ITL, the gate insulating layer GI, and the buffer layer BF. In addition, the second anode connection electrode ACE2 may be connected to the twenty-third drain electrode D23 of the twenty-third transistor T23 through a fifth contact hole CT5' penetrating the interlayer insulating layer ITL and the gate insulating layer GI.

The third anode connection electrode ACE3 may overlap the thirty-first gate electrode G31. A second intermediate capacitor of the third capacitor Cst3 may be formed in an overlapping area of the third anode connection electrode ACE3 and the thirty-first gate electrode G31. The third capacitor Cst3 may include the first intermediate capacitor and the second intermediate capacitor. The third anode connection electrode ACE3 may be connected to the thirty-first source electrode S31 of the thirty-first transistor T31 through a second contact hole CT2" penetrating the interlayer insulating layer ITL and the gate insulating layer GI. In addition, the third anode connection electrode ACE3 may be connected to the third light blocking layer BML3 through a twelfth contact hole CT12" penetrating the interlayer insulating layer ITL, the gate insulating layer GI, and the buffer layer BF. In addition, the third anode connection electrode ACE3 may be connected to the thirty-third drain electrode D33 of the thirty-third transistor T33 through a fifth contact hole CT5" penetrating the interlayer insulating layer ITL and the gate insulating layer GI.

The first gate connection electrode GCE1 may be connected to the eleventh gate electrode G11 of the eleventh transistor T11 through an eighth contact hole CT8 penetrating the interlayer insulating layer ITL. In addition, the first gate connection electrode GCE1 may be connected to the twelfth source electrode S12 of the twelfth transistor T12 through a fourth contact hole CT4 penetrating the interlayer insulating layer ITL and the gate insulating layer GI.

The second gate connection electrode GCE2 may be connected to the twenty-first gate electrode G21 of the twenty-first transistor T21 through an eighth contact hole CT8' penetrating the interlayer insulating layer ITL. In addition, the second gate connection electrode GCE2 may be connected to the twenty-second source electrode S22 of the twenty-second transistor T22 through a fourth contact hole CT4' penetrating the interlayer insulating layer ITL and the gate insulating layer GI.

The third gate connection electrode GCE3 may be connected to the thirty-first gate electrode G31 of the thirty-first transistor T31 through an eighth contact hole CT8" penetrating the interlayer insulating layer ITL. In addition, the third gate connection electrode GCE3 may be connected to the thirty-second source electrode S32 of the thirty-second transistor T32 through a fourth contact hole CT4" penetrating the interlayer insulating layer ITL and the gate insulating layer GI.

The first data connection electrode DCE1 may overlap the first data line DL1 and the third data line DL3 among the first through third data lines DL1 through DL3. The first data connection electrode DCE1 may be connected to the twelfth drain electrode D12 of the twelfth transistor T12 through a third contact hole CT3 penetrating the interlayer insulating layer ITL and the gate insulating layer GI. In addition, the first data connection electrode DCE1 may be connected to the first data line DL1 through a tenth contact hole CT10 penetrating the interlayer insulating layer ITL, the gate insulating layer GI, and the buffer layer BF.

The second data connection electrode DCE2 may overlap the first through third data lines DL1 through DL3. The second data connection electrode DCE2 may be connected to the twenty-second drain electrode D22 of the twenty-second transistor T22 through a third contact hole CT3' penetrating the interlayer insulating layer ITL and the gate insulating layer GI. In addition, the second data connection electrode DCE2 may be connected to the second data line DL2 through a tenth contact hole CT10' penetrating the interlayer insulating layer ITL, the gate insulating layer GI, and the buffer layer BF.

The third data connection electrode DCE3 may overlap the third data line DL3 among the first through third data lines DL1 through DL3. The third data connection electrode DCE3 may be connected to the thirty-second drain electrode D32 of the thirty-second transistor T32 through a third contact hole CT3" penetrating the interlayer insulating layer ITL and the gate insulating layer GI. In addition, the third data connection electrode DCE3 may be connected to the third data line DL3 through a tenth contact hole CT10" penetrating the interlayer insulating layer ITL, the gate insulating layer GI, and the buffer layer BF.

The first driving connection electrode VCE1 may be connected to the eleventh drain electrode D11 of the eleventh transistor T11 through a first contact hole CT1 penetrating the interlayer insulating layer ITL and the gate insulating layer GI. In addition, the first driving connection electrode VCE1 may be connected to the driving voltage line VDL through a seventh contact hole CT7 penetrating the interlayer insulating layer ITL, the gate insulating layer GI, and the buffer layer BF.

The second driving connection electrode VCE2 may be connected to the twenty-first drain electrode D21 of the twenty-first transistor T21 through a first contact hole CT1' penetrating the interlayer insulating layer ITL and the gate insulating layer GI. In addition, the second driving connection electrode VCE2 may be connected to the driving voltage line VDL through a seventh contact hole CT7' penetrating the interlayer insulating layer ITL, the gate insulating layer GI, and the buffer layer BF.

The third driving connection electrode VCE3 may be connected to the thirty-first drain electrode D31 of the thirty-first transistor T31 through a first contact hole CT1" penetrating the interlayer insulating layer ITL and the gate insulating layer GI. In addition, the second driving connection electrode VCE2 may be connected to the driving voltage line VDL through a seventh contact hole CT7" penetrating the interlayer insulating layer ITL, the gate insulating layer GI, and the buffer layer BF.

The initialization connection electrode ICE may be connected to the thirteenth source electrode S13 of the thirteenth transistor T13 through a sixth contact hole CT6 penetrating the interlayer insulating layer ITL and the gate insulating layer GI. In addition, the initialization connection electrode ICE may be connected to the twenty-third source electrode S23 of the twenty-third transistor T23 through a sixth contact hole CT6 penetrating the interlayer insulating layer ITL and the gate insulating layer GI. In addition, the initialization connection electrode ICE may be connected to the thirty-third source electrode S33 of the thirty-third transistor T33 through a sixth contact hole CT6 penetrating the interlayer insulating layer ITL and the gate insulating layer GI. In addition, the initialization connection electrode ICE may be connected to the initialization voltage line VIL through a thirteenth contact hole CT13 penetrating the interlayer insulating layer ITL, the gate insulating layer GI, and the buffer layer BF.

The first scan line SCL may be connected to the twelfth gate electrode G12 of the twelfth transistor T12, the twenty-second gate electrode G22 of the twenty-second transistor T22, and the thirty-second gate electrode G32 of the thirty-second transistor T32 through a fourteenth contact hole CT14 penetrating the interlayer insulating layer ITL. For example, the twelfth gate electrode G12, the twenty-second gate electrode G22, and the thirty-second gate electrode G32 may be integrally formed with each other to form a first gate structure, and the first scan line SCL may be connected to the first gate structure through the fourteenth contact hole CT14.

The second scan line SSL may be connected to the thirteenth gate electrode G13 of the thirteenth transistor T13, the twenty-third gate electrode G23 of the twenty-third transistor T23, and the thirty-third gate electrode G33 of the thirty-third transistor T33 through a fifteenth contact hole CT15 penetrating the interlayer insulating layer ITL. For example, the thirteenth gate electrode G13, the twenty-third gate electrode G23, and the thirty-third gate electrode G33 may be integrally formed with each other to form a second gate structure, and the second scan line SSL may be connected to the second gate structure through the fifteenth contact hole CT15.

A passivation layer PAS may be disposed on the fourth pattern layer. For example, as illustrated in FIG. 6, the passivation layer PAS may be disposed on the first driving connection electrode VCE1 and the first anode connection electrode ACE1.

The passivation layer PAS may include an organic layer such as acryl resin, epoxy resin, phenolic resin, polyamide resin, or polyimide resin.

A via layer VA may be disposed on the passivation layer PAS. For example, as illustrated in FIG. 6, the via layer VA may be disposed on the passivation layer PAS. The via layer VA may have a different etch rate from the passivation layer PAS. The via layer VA may have the same material and structure as the passivation layer PAS described above. However, the passivation layer PAS may have a higher etch rate than the via layer VA.

A fifth pattern layer may be disposed on the via layer VA. For example, as illustrated in FIGS. 3 through 6, the light emitting element layer EMTL including the fifth pattern layer may be disposed on the via layer VA. In other words, a first anode AND1, a second anode AND2, and a third anode AND3 may be disposed as the fifth pattern layer on the via layer VA.

The first anode AND1 may be connected to the first anode connection electrode ACE1 through an eleventh contact hole CT11 and a ninth contact hole CT9 penetrating the via layer VA and the passivation layer PAS. Here, the eleventh contact hole CT11 and the ninth contact hole CT9 may be connected to each other. In plan view, the eleventh contact hole CT11 may surround the ninth contact hole CT9.

The second anode AND2 may be connected to the second anode connection electrode ACE2 through an eleventh contact hole CT11' and a ninth contact hole CT9' penetrating the via layer VA and the passivation layer PAS. Here, the eleventh contact hole CT11' and the ninth contact hole CT9' may be connected to each other. In plan view, the eleventh contact hole CT11' may surround the ninth contact hole CT9'.

The third anode AND3 may be connected to the third anode connection electrode ACE3 through an eleventh contact hole CT11" and a ninth contact hole CT9" penetrating the via layer VA and the passivation layer PAS. Here, the eleventh contact hole CT11" and the ninth contact hole CT9" may be connected to each other. In plan view, the eleventh contact hole CT11" may surround the ninth contact hole CT9".

The light emitting element layer EMTL described above may further include the first light emitting element ED1, the second light emitting element ED2, the third light emitting element ED3, and a pixel defining layer PDL.

The first light emitting element ED1 may include the first anode AND1, a first light emitting layer EL1, and a cathode CAT. A first emission area EA1 is an area in which the first anode AND1, the first light emitting layer EL1, and the cathode CAT are sequentially stacked so that holes from the first anode AND1 and electrons from the cathode CAT are combined with each other in the first light emitting layer EL1 to emit light.

In a top emission structure in which light is emitted in a direction from the first light emitting layer EL1 toward the cathode CAT, the first anode AND1 may be formed as a single layer of molybdenum (Mo), titanium (Ti), copper (Cu) or aluminum (Al) or, in order to increase reflectivity, may be formed as a stacked structure (Ti/Al/Ti) of aluminum and titanium, a stacked structure (ITO/Al/ITO) of aluminum and indium tin oxide, an APC alloy, or a stacked structure (ITO/APC/ITO) of an APC alloy and indium tin oxide. The APC alloy may be an alloy of silver (Ag), palladium (Pd), and copper (Cu).

The second light emitting element ED2 may include the second anode AND2, a second light emitting layer, and the cathode CAT. A second emission area is an area in which the second anode AND2, the second light emitting layer, and the cathode CAT are sequentially stacked so that holes from the second anode AND2 and electrons from the cathode CAT are combined with each other in the second light emitting layer to emit light.

In a top emission structure in which light is emitted in a direction from the second light emitting layer toward the cathode CAT, the second anode AND2 may be formed as a single layer of molybdenum (Mo), titanium (Ti), copper (Cu) or aluminum (Al) or, in order to increase reflectivity, may be formed as a stacked structure (Ti/Al/Ti) of aluminum and titanium, a stacked structure (ITO/Al/ITO) of aluminum and indium tin oxide, an APC alloy, or a stacked structure (ITO/APC/ITO) of an APC alloy and indium tin oxide. The APC alloy may be an alloy of silver (Ag), palladium (Pd), and copper (Cu).

The third light emitting element ED3 may include the third anode AND3, a third light emitting layer, and the cathode CAT. A third emission area is an area in which the third anode AND3, the third light emitting layer, and the cathode CAT are sequentially stacked so that holes from the third anode AND3 and electrons from the cathode CAT are combined with each other in the third light emitting layer to emit light.

In a top emission structure in which light is emitted in a direction from the third light emitting layer toward the cathode CAT, the third anode AND3 may be formed as a single layer of molybdenum (Mo), titanium (Ti), copper (Cu) or aluminum (Al) or, in order to increase reflectivity, may be formed as a stacked structure (Ti/Al/Ti) of aluminum and titanium, a stacked structure (ITO/Al/ITO) of aluminum and indium tin oxide, an APC alloy, or a stacked structure (ITO/APC/ITO) of an APC alloy and indium tin oxide. The APC alloy may be an alloy of silver (Ag), palladium (Pd), and copper (Cu).

The pixel defining layer PDL may serve to define emission areas of pixels (e.g., the first through third emission areas). To this end, the pixel defining layer PDL may be disposed on the via layer VA to expose a portion of the first anode AND1, a portion of the second anode AND2, and a portion of the third anode AND3. The pixel defining layer PDL may cover each edge of the first anode AND1, the second anode AND2, and the third anode AND3.

The pixel defining layer PDL may be made of an organic layer such as acryl resin, epoxy resin, phenolic resin, polyamide resin, or polyimide resin.

The first light emitting layer EL1 may be formed on the first anode AND1. The first light emitting layer EL1 may include an organic material to emit light of a predetermined color. For example, the first light emitting layer EL1 may include a hole transporting layer, an organic material layer, and an electron transporting layer. The organic material layer may include a host and a dopant. The organic material layer may include a material that emits predetermined light and may be formed using a phosphorescent material or a fluorescent material.

For example, the organic material layer of the first light emitting layer EL1 emitting light of a first color (e.g., blue) may be a phosphorescent material that includes a host material including CBP or mCP and a dopant material including (4,6-F2ppy)2Irpic or L2BD111. However, the present disclosure is not limited thereto.

The organic material layer of the first light emitting layer EL1 emitting light of a second color (e.g., green) may be a phosphorescent material that includes a host material including CBP or mCP and a dopant material including Ir(ppy)3(fac tris(2-phenylpyridine)iridium). Alternatively, the organic material layer of the light emitting layer EL1 emitting light of the second color may be a fluorescent material including tris(8-hydroxyquinolino)aluminum (Alq3). However, the present disclosure is not limited thereto.

The organic material layer of the first light emitting layer EL1 emitting light of a third color (e.g., red) may be a phosphorescent material that includes a host material including carbazole biphenyl (CBP) or 1,3-bis(carbazol-9-yl) (mCP) and a dopant including any one or more of bis(1-phenylisoquinoline)acetylacetonate iridium (PIQIr(acac)), bis(1-phenylquinoline)acetylacetonate iridium (PQIr(acac)), tris(1-phenylquinoline)iridium (PQIr) and octaethylporphyrin platinum (PtOEP). Alternatively, the organic material layer of the light emitting layer EL1 emitting light of the third color may be a fluorescent material including PBD:Eu(DBM)3(Phen) or perylene. However, the present disclosure is not limited thereto.

The second light emitting layer may be formed on the second anode AND2, and the third light emitting layer may be formed on the third anode AND3. Each of the second light emitting layer and the third light emitting layer may include an organic material to emit light of a predetermined color.

According to an embodiment, the first light emitting layer EL1 on the first anode AND1, the second light emitting layer on the second anode AND2, and the third light emitting layer on the third anode AND3 may provide light of the same color (or light of the same wavelength). For example, the first light emitting layer EL1 on the first anode AND1, the second light emitting layer on the second anode AND2, and the third light emitting layer on the third anode AND3 may provide blue light. However, the present disclosure is not limited thereto, and the light emitting layers may also provide light of another color. For example, the first light emitting layer EL1 on the first anode AND1, the second light emitting layer on the second anode AND2, and the third light emitting layer on the third anode AND3 may each provide cyan light (e.g., a mixture of blue light and green light).

The cathode CAT may be disposed on the first light emitting layer EL1, the second light emitting layer, and the third light emitting layer. The cathode CAT may cover the first light emitting layer EL1, the second light emitting layer, and the third light emitting layer. The cathode CAT may be a common layer commonly disposed on a plurality of light emitting layers.

In the top emission structure, the cathode CAT may be made of a transparent conductive material (TCO) that can transmit light, such as indium tin oxide (ITO) or indium zinc oxide (IZO), or a semi-transmissive conductive material such as magnesium (Mg), silver (Ag) or an alloy of Mg and Ag. When the common electrode CAT is made of a semi-transmissive conductive material, light output efficiency may be increased by a microcavity.

The encapsulation layer ENC may be formed on the light emitting element layer EMTL as illustrated in FIG. 6. The encapsulation layer ENC may include at least one inorganic layer TFE1 and TFE3 to prevent oxygen or moisture from penetrating into the light emitting element layer EMTL. In addition, the encapsulation layer ENC may include at least one organic layer to protect the light emitting element layer EMTL from foreign substances such as dust. For example, the encapsulation layer ENC may include a first encapsulating inorganic layer TFE1, an encapsulating organic layer TFE2, and a second encapsulating inorganic layer TFE3.

The first encapsulating inorganic layer TFE1 may be disposed on the cathode CAT, the encapsulating organic layer TFE2 may be disposed on the first encapsulating inorganic layer TFE1, and the second encapsulating inorganic layer TFE3 may be disposed on the encapsulating organic layer TFE2. Each of the first encapsulating inorganic layer TFE1 and the second encapsulating inorganic layer TFE3 may be a multilayer in which one or more inorganic layers selected from a silicon nitride layer, a silicon oxynitride layer, a silicon oxide layer, a titanium oxide layer, and an aluminum oxide layer are alternately stacked. The encapsulating organic layer TFE2 may be an organic layer such as acryl resin, epoxy resin, phenolic resin, polyamide resin, or polyimide resin.

When a foreign substance or the like penetrates into a pixel (e.g., one of the first pixel PX1, the second pixel PX2, and the third pixel PX3) during a process of fabricating the display device 100, a defect may occur in the pixel, and the pixel may be determined to be a defective pixel that cannot normally provide light. In this case, a repair process may be performed on the defective pixel. The repair process will be described in detail as follows.

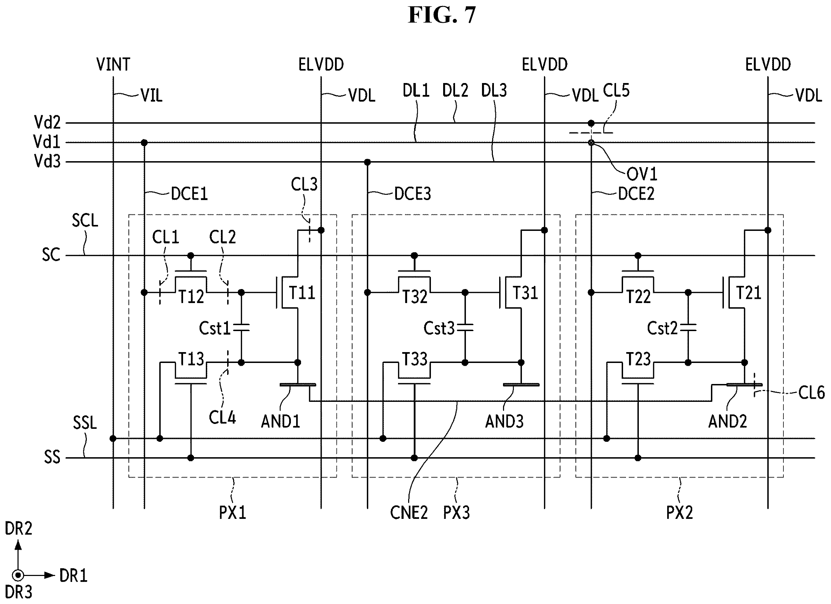

FIG. 7 is a circuit diagram for explaining a method of fabricating a display device 100 according to an embodiment. For example, FIG. 7 may be a diagram for explaining a method of repairing the display device 100 of FIG. 2 described above.

As illustrated in FIG. 7, if a defect occurs in at least one (e.g., an eleventh transistor T11) of transistors of a first pixel PX1 and thus the first pixel PX1 is determined to be a defective pixel that cannot normally provide light, a repair process may be performed on the first pixel PX1. For example, a first pixel circuit of the first pixel PX1 may be disconnected from first signal lines, a second pixel circuit of the second pixel PX2 may be disconnected from a second signal line, the second pixel circuit of the second pixel PX2 and any one of the first signal lines may be connected to each other, and a second anode AND2 of the second pixel PX2 and a first anode AND1 of the first pixel PX1 may be connected to each other.

Here, when the first pixel circuit of the first pixel PX1 is disconnected from the first signal lines, it may mean that, for example, the first pixel circuit of the first pixel PX1 is disconnected from a first data line DL1, the first pixel circuit of the first pixel PX1 is disconnected from a first scan line SCL, and the first pixel circuit of the first pixel PX1 is disconnected from a driving voltage line VDL. In addition, when the second pixel circuit of the second pixel PX2 is disconnected from the second signal line, it may mean that, for example, the second pixel circuit of the second pixel PX2 is disconnected from a second data line DL2. In addition, when the second pixel circuit of the second pixel PX2 and any one of the first signal lines are connected to each other, it may mean that, for example, the second pixel circuit of the second pixel PX2 and the first data line DL1 are electrically connected to each other. Here, the first pixel PX1 may be a pixel that provides green light, and the second pixel PX2 may be a pixel that provides blue light. Alternatively, the first pixel PX1 may be a pixel that provides red light, and the second pixel PX2 may be a pixel that provides blue light.

The repair process will be described in more detail as follows.

For example, as illustrated in FIG. 7, a drain electrode of a twelfth transistor T12 may be cut along a first cutting line CL1, a source electrode of the twelfth transistor T12 may be cut along a second cutting line CL2, a drain electrode of the eleventh transistor T11 may be cut along a third cutting line CL3, and a drain electrode of a thirteenth transistor T13 may be cut along a fourth cutting line CL4.

Accordingly, a first electrode of a first capacitor Cst1 and the source electrode of the twelfth transistor T12 may be electrically isolated from each other, the first data line DL1 and the drain electrode of the twelfth transistor T12 may be electrically isolated from each other, a gate electrode of the eleventh transistor T11 and the source electrode of the twelfth transistor T12 may be electrically isolated from each other, and a second electrode of the first capacitor Cst1 and the drain electrode of the thirteenth transistor T13 may be electrically isolated from each other.

In order to electrically connect the pixel circuit (e.g., a twenty-first transistor T21, a twenty-second transistor T22, a twenty-third transistor T23, and a second capacitor Cst2) of a normally operating pixel, for example, the second pixel PX2 to the first pixel PX1, the second pixel PX2 may be connected to the first data line DL1 instead of the second data line DL2, and the second anode AND2 of the second pixel PX2 may be connected to the first anode AND1. To this end, according to an embodiment, a second data connection electrode DCE2 may be cut along a fifth cutting line CL5, the second anode AND2 may be cut along a sixth cutting line CL6, the second data connection electrode DCE2 may be connected to the first data line DL1 in a first overlapping area OV1 of the second data connection electrode DCE2 and the first data line DL1, and a partial electrode connected to a source electrode of the twenty-first transistor T21 among partial electrodes of the cut second anode AND2 may be connected to the first anode AND1. Here, the cut second anode AND2 and the first anode AND1 may be connected to each other by a connection electrode CNE2. Accordingly, the pixel circuit of the second pixel PX2, which is a normal pixel, may be connected to the first anode AND1 of the first pixel PX1 which is a defective pixel.

Through the above repair process and darkening process, a first light emitting element ED1 of the first pixel PX1, which is a defective pixel, may be normally driven by the pixel circuit of another pixel (e.g., the pixel circuit of the second pixel PX2). For example, the first light emitting element ED1 of the first pixel PX1 may receive a driving current generated through the pixel circuit of the second pixel PX2 (e.g., the twenty-first transistor T21, the twenty-second transistor T22, the twenty-third transistor T23, and the second capacitor Cst2) to emit light. At this time, the second pixel PX2 may receive a first data voltage Vd1 through the first data line DL1. Therefore, the first light emitting element ED1 of the first pixel PX1 may provide light corresponding to the magnitude (or grayscale value) of the first data voltage Vd1 which is the original data voltage.

According to an embodiment, the first pixel PX1 may be a green pixel that provides green light, the second pixel PX2 may be a blue pixel that provides blue light, and a third pixel PX3 may be a red pixel that provides red light. In a unit pixel including the red pixel, the green pixel, and the blue pixel, the luminance contribution of the green pixel is the highest, and the luminance contribution of the blue pixel is the lowest. In other words, in the unit pixel including the red pixel, the green pixel, and the blue pixel, the visibility of the green pixel is the highest, and the visibility of the blue pixel is the lowest. Therefore, when the green pixel making the relatively highest luminance contribution is defective, a light emitting element of the green pixel may be driven using a driving current from a pixel circuit of the blue pixel making the relatively lowest luminance contribution, thereby minimizing the defect rate and image quality deterioration of the display device 100. The luminance contribution (or visibility) of the red pixel may be higher than the luminance contribution (or visibility) of the blue pixel and lower than the luminance contribution (or visibility) of the green pixel.

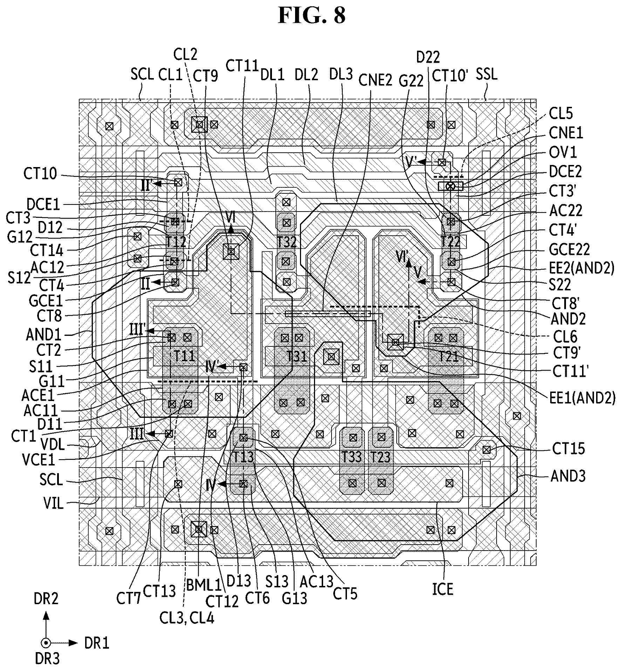

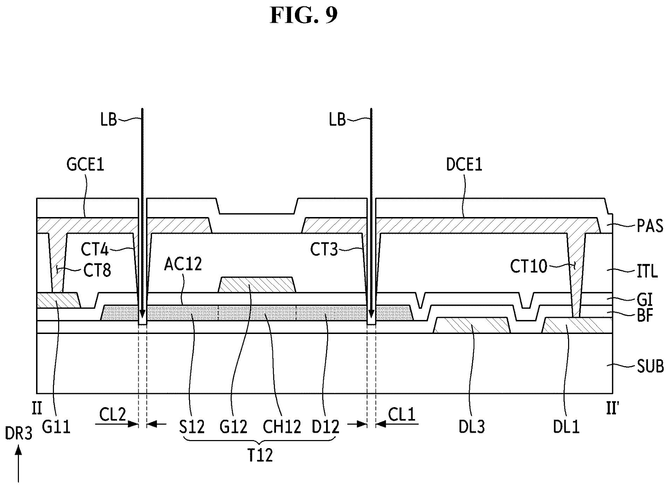

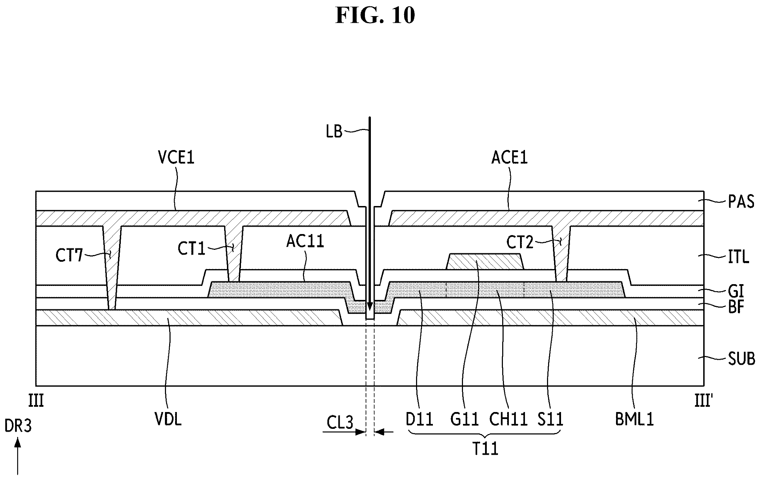

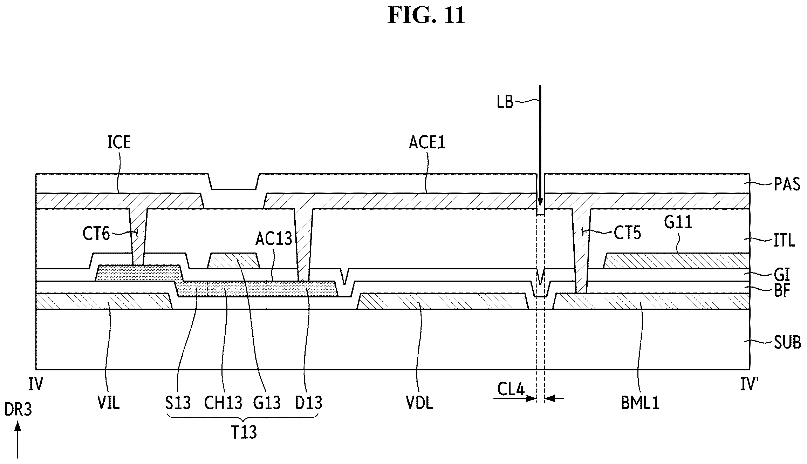

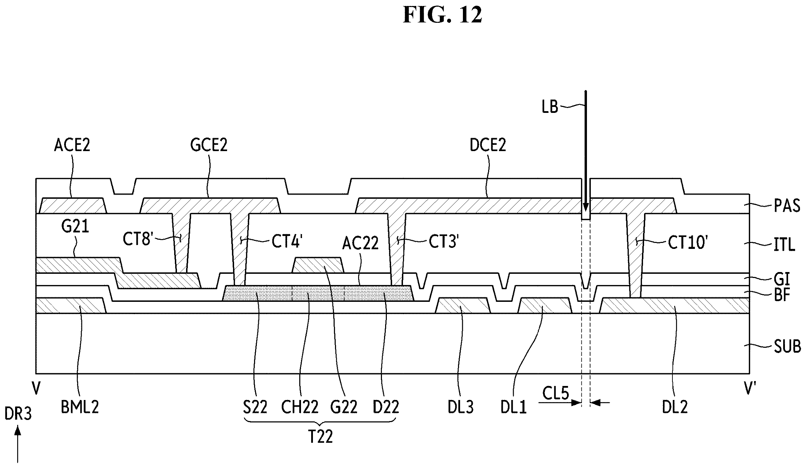

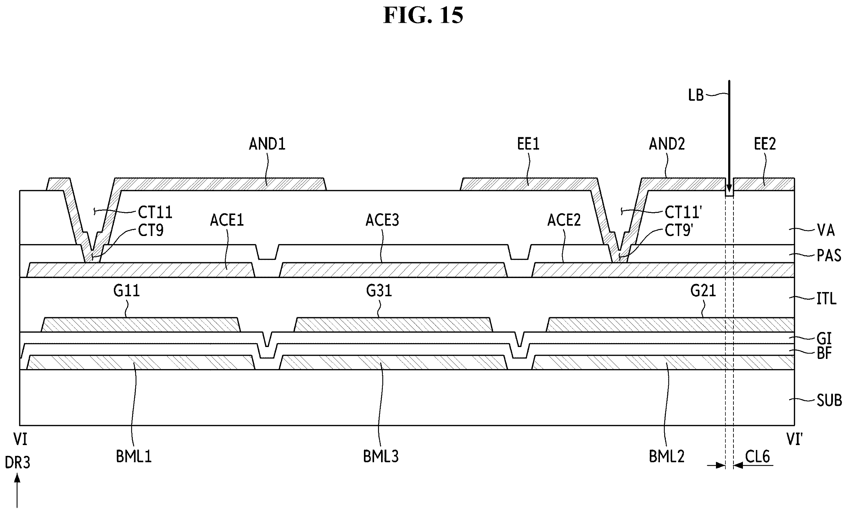

FIGS. 8 through 18 are array diagrams for explaining a method of fabricating a display device 100 according to an embodiment. For example, FIG. 8 may be a diagram for explaining a method of repairing the display device 100 of FIG. 3 described above. Here, FIG. 9 is a process cross-sectional view taken along line II-II' of FIG. 8. FIG. 10 is a process cross-sectional view taken along line III-III' of FIG. 8. FIG. 11 is a process cross-sectional view taken along line IV-IV' of FIG. 8. FIGS. 12 through 14 are process cross-sectional views taken along line V-V' of FIG. 8. FIGS. 15 through 18 are process cross-sectional views taken along line VI-VI' of FIG. 8.

A repair process according to an embodiment may be performed, for example, after a passivation layer PAS is formed. For example, as illustrated in FIG. 9, after a first pattern layer (e.g., a third data line DL3 and a first data line DL1 of FIG. 9), a buffer layer BF, a second pattern layer (e.g., a twelfth active layer AC12 of FIG. 9), a gate insulating layer GI, a third pattern layer (e.g., an eleventh gate electrode G11 and a twelfth gate electrode G12 of FIG. 9), an interlayer insulating layer ITL, a fourth pattern layer (e.g., a first gate connection electrode GCE1 and a first data connection electrode DCE1 of FIG. 9), and the passivation layer PAS are sequentially placed on a substrate SUB, a test process may be performed to detect whether each pixel is defective. After this test process, when it is determined that a defect has occurred in a first pixel PX1 among first through third pixels PX1 through PX3, the following repair process may be performed.

For example, as illustrated in FIGS. 8 and 9, a twelfth drain electrode D12 and a twelfth source electrode S12 of a twelfth transistor T12 may be cut. According to an embodiment, the twelfth drain electrode D12 of the twelfth transistor T12 may be cut along a first cutting line CL1, and the twelfth source electrode S12 of the twelfth transistor T12 may be cut along a second cutting line CL2. For example, as illustrated in FIG. 9, when a laser beam LB is irradiated onto the passivation layer PAS along the first cutting line CL1, the first data connection electrode DCE1 and the twelfth drain electrode D12 of the twelfth transistor T12 on the first cutting line CL1 may be cut. In addition, when a laser beam LB is irradiated onto the passivation layer PAS along the second cutting line CL2, the first gate connection electrode GCE1 and the twelfth source electrode S12 of the twelfth transistor T12 on the second cutting line CL2 may be cut. Accordingly, the twelfth drain electrode D12 of the twelfth transistor T12 and the first data line DL1 may be electrically isolated from each other, and the twelfth source electrode S12 of the twelfth transistor T12 and the eleventh gate electrode G11 of an eleventh transistor T11 may be electrically isolated from each other.

According to an embodiment, in plan view, at least one of the twelfth drain electrode D12 and the first data connection electrode DCE1 may be cut along the first cutting line CL1 between a third contact hole CT3 and a channel region CH12 of the twelfth transistor T12.

According to an embodiment, in plan view, at least one of the twelfth drain electrode D12 and the first data connection electrode DCE1 may be cut along the first cutting line CL1 on the third contact hole CT3.

According to an embodiment, in plan view, at least one of the twelfth source electrode S12 and the first gate connection electrode GCE1 may be cut along the second cutting line CL2 between a fourth contact hole CT4 and the channel region CH12 of the twelfth transistor T12.

According to an embodiment, in plan view, at least one of the twelfth source electrode S12 and the first gate connection electrode GCE1 may be cut along the second cutting line CL2 on the fourth contact hole CT4.

According to an embodiment, the passivation layer PAS, the first data connection electrode DCE1, the interlayer insulating layer ITL, the gate insulating layer GI, and the twelfth drain electrode D12 on the first cutting line CL1 may be penetrated by the laser beam LB, and a groove may be formed in the buffer layer BF. In addition, the passivation layer PAS, the first gate connection electrode GCE1, the interlayer insulating layer ITL, the gate insulating layer GI, and the twelfth source electrode S12 on the second cutting line CL2 may be penetrated by the laser beam LB, and a groove may be formed in the buffer layer BF.

Next, as illustrated in FIGS. 8 and 10, an eleventh drain electrode D11 of the eleventh transistor T11 may be cut. According to an embodiment, the eleventh drain electrode D11 of the eleventh transistor T11 may be cut along a third cutting line CL3. For example, as illustrated in FIG. 10, when a laser beam LB is irradiated onto the passivation layer PAS along the third cutting line CL3, the eleventh drain electrode D11 on the third cutting line CL3 may be cut. Accordingly, the eleventh drain electrode D11 of the eleventh transistor T11 and a driving voltage line VDL may be electrically isolated from each other.

According to an embodiment, in plan view, at least one of the eleventh drain electrode D11, a first driving connection electrode VCE1, and a first anode connection electrode ACE1 may be cut along the third cutting line CL3 between a first contact hole CT1 and a channel region CH11 of the eleventh transistor T11.

According to an embodiment, the passivation layer PAS, the interlayer insulating layer ITL, the gate insulating layer GI, and the eleventh drain electrode D11 on the third cutting line CL3 may be penetrated by the laser beam LB, and a groove may be formed in the buffer layer BF.

Next, as illustrated in FIGS. 8 and 11, the first anode connection electrode ACE1 may be cut. According to an embodiment, the first anode connection electrode ACE1 may be cut along a fourth cutting line CL4. For example, as illustrated in FIG. 11, when a laser beam LB is irradiated onto the passivation layer PAS along the fourth cutting line CL4, the first anode connection electrode ACE1 on the fourth cutting line CL4 may be cut. Accordingly, a thirteenth drain electrode D13 of a thirteenth transistor T13 and a first light blocking layer BML1 may be electrically isolated from each other. In other words, the thirteenth drain electrode D13 of the thirteenth transistor T13 and one electrode of the first capacitor Cst1 may be electrically isolated from each other.

According to an embodiment, in plan view, at least one of the thirteenth drain electrode D13 and the first anode connection electrode ACE1 may be cut along the fourth cutting line CL4 between a fifth contact hole CT5 and a channel region CH13 of the thirteenth transistor T13.

According to an embodiment, the passivation layer PAS and the first anode connection electrode ACE1 on the fourth cutting line CL4 may be penetrated by the laser beam LB, and a groove may be formed in the interlayer insulating layer ITL.

The third cutting line CL3 and the fourth cutting line CL4 described above may be connected as one line, and at this time, the laser beam LB may be continuously irradiated along the third cutting line CL3 and the fourth cutting line CL4. In this case, the passivation layer PAS, the first anode connection electrode ACE1, the interlayer insulating layer ITL, and the gate insulating layer GI on the fourth cutting line CL4 may be penetrated by the laser beam LB, and a groove may be formed in the buffer layer BF.

Next, as illustrated in FIGS. 8 and 12, a second data connection electrode DCE2 may be cut. According to an embodiment, the second data connection electrode DCE2 may be cut along a fifth cutting line CL5. For example, as illustrated in FIG. 12, when a laser beam LB is irradiated onto the passivation layer PAS along the fifth cutting line CL5, the second data connection electrode DCE2 on the fifth cutting line CL5 may be cut. Accordingly, a twenty-second drain electrode D22 of a twenty-second transistor T22 and a second data line DL2 may be electrically isolated from each other.

According to an embodiment, in plan view, at least one of the twenty-second drain electrode D22 and the second data connection electrode DCE2 may be cut along the fifth cutting line CL5 between a tenth contact hole CT10' and a channel region CH22 of the twenty-second transistor T22.

According to an embodiment, the passivation layer PAS and the second data connection electrode DCE2 on the fifth cutting line CL5 may be penetrated by the laser beam LB, and a groove may be formed in the interlayer insulating layer ITL.

The third cutting line CL3 and the fourth cutting line CL4 described above may be connected as one line, and at this time, the laser beam LB may be continuously irradiated along the third cutting line CL3 and the fourth cutting line CL4. In this case, the passivation layer PAS, the first anode connection electrode ACE1, the interlayer insulating layer ITL, and the gate insulating layer GI on the fourth cutting line CL4 may be penetrated by the laser beam LB, and a groove may be formed in the buffer layer BF.

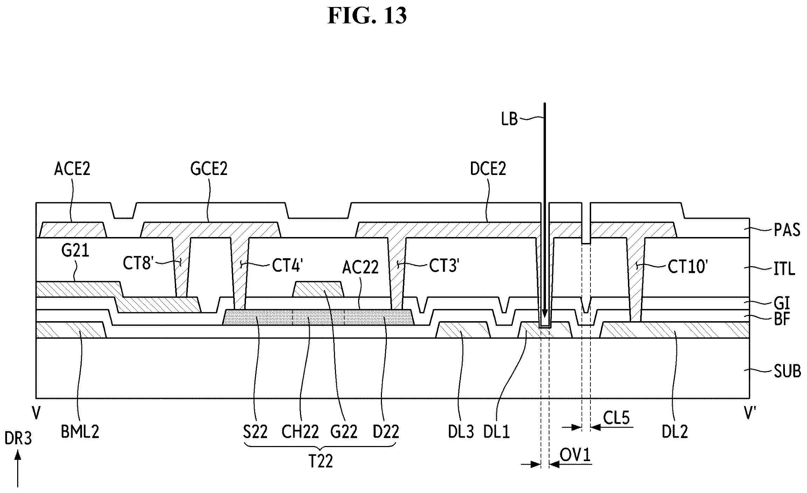

Next, as illustrated in FIGS. 8 and 13, the second data connection electrode DCE2 and the first data line DL1 may be electrically connected to each other. According to an embodiment, the second data connection electrode DCE2 and the first data line DL1 may be electrically connected to each other in a first overlapping area OV1 of the second data connection electrode DCE2 and the first data line DL1. For example, as illustrated in FIG. 13, when a laser beam LB is irradiated onto the passivation layer PAS in the first overlapping area OV1 of the second data connection electrode DCE2 and the first data line DL1, the second data connection electrode DCE2 and the first data line DL1 may contact (or directly contact) each other in the first overlapping area OV1. Accordingly, the twenty-second drain electrode D22 of the twenty-second transistor T22 and the first data line DL1 may be electrically connected to each other.

According to an embodiment, the passivation layer PAS, the interlayer insulating layer ITL, the gate insulating layer GI, and the buffer layer BF may be penetrated by the laser beam LB in the first overlapping area OV1 of the second data connection electrode DCE2 and the first data line DL1, and a groove may be formed in the first data line DL1.

According to an embodiment, in the first overlapping area OV1, a portion of the second data connection electrode DCE2 may be disposed in respective through holes of the interlayer insulating layer ITL, the gate insulating layer GI and the buffer layer BF and the groove of the first data line DL1.

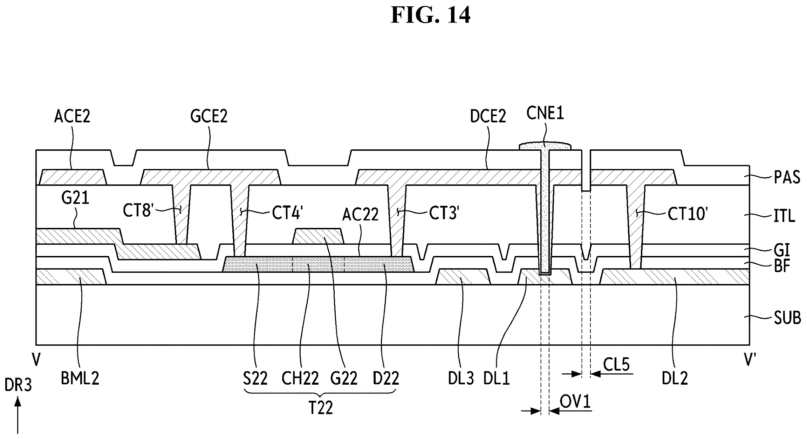

Additionally, as illustrated in FIGS. 8 and 14, a first connection electrode CNE1 may be further disposed on the passivation layer PAS. For example, the first connection electrode CNE1 may be disposed on the passivation layer PAS in the first overlapping area OV1 and around the first overlapping area OV1. A portion of the first connection electrode CNE1 may be disposed in the respective through holes of the passivation layer PAS, the interlayer insulating layer ITL, the gate insulating layer GI and the buffer layer BF (e.g., the through holes formed by irradiating the laser beam LB to the first overlapping area OV1 of FIG. 13) and the groove of the first data line DL1 (e.g., the groove formed by irradiating the laser beam LB to the first overlapping area OV1 of FIG. 13). At this time, the portion of the first connection electrode CNE1 may contact (or directly contact) the second data connection electrode DCE2 and the first data line DL1 in the above-described through holes and groove. The first connection electrode CNE1 may improve the connection state between the second data connection electrode DCE2 and the first data line DL1. The first connection electrode CNE1 may include, for example, conductive ink. The first connection electrode CNE1 may also be omitted.

Next, as illustrated in FIGS. 8 and 15, a ninth contact hole CT9 penetrating the passivation layer PAS to expose the first anode connection electrode ACE1, a ninth contact hole CT9' penetrating the passivation layer PAS to expose a second anode connection electrode ACE2, and a ninth contact hole CT9" penetrating the passivation layer PAS to expose a third anode connection electrode ACE3 may be formed.

Next, a via layer VA may be formed on the passivation layer PAS to fill the ninth contact holes CT9, CT9' and CT9". At this time, the first connection electrode CNE1 on the passivation layer PAS may be covered by the via layer VA. Since the first connection electrode CNE1 is covered by the via layer VA, oxidation of the first connection electrode CNE1 in a subsequent process can be prevented.

Next, eleventh contact holes CT11, CT11' and CT11" penetrating the via layer VA may be formed to overlap the ninth contact holes CT9, CT9' and CT9". The first anode connection electrode ACE1 may be exposed by the eleventh contact hole CT11 and the ninth contact hole CT9 overlapping the first anode connection electrode ACE1. The second anode connection electrode ACE2 may be exposed by the eleventh contact hole CT11' and the ninth contact hole CT9' overlapping the second anode connection electrode ACE2. The third anode connection electrode ACE3 may be exposed by the eleventh contact hole CT11" and the ninth contact hole CT9" overlapping the third anode connection electrode ACE3.

Next, a first anode AND1, a second anode AND2, and a third anode AND3 may be disposed on the via layer VA. At this time, the first anode AND1 may be connected to the first anode connection electrode ACE1 through the eleventh contact hole CT11 of the via layer VA and the ninth contact hole CT9 of the passivation layer PAS, the second anode AND2 may be connected to the second anode connection electrode ACE2 through the eleventh contact hole CT11' of the via layer VA and the ninth contact hole CT9' of the passivation layer PAS, and the third anode AND3 may be connected to the third anode connection electrode ACE3 through the eleventh contact hole CT11" of the via layer VA and the ninth contact hole CT9" of the passivation layer PAS.

Next, the second anode AND2 may be cut. According to an embodiment, the second anode AND2 may be cut along a sixth cutting line CL6. For example, as illustrated in FIG. 15, when a laser beam LB is irradiated onto the second anode AND2 along the sixth cutting line CL6, the second anode AND2 on the sixth cutting line CL6 may be cut. For example, the second anode AND2 may include a first partial electrode EE1 and a second partial electrode EE2 separated from each other by the sixth cutting line CL6. The first partial electrode EE1 may be connected to the second anode connection electrode ACE2 through the eleventh contact hole CT11' and the ninth contact hole CT9', but the second partial electrode EE2 may be electrically and physically separated from the second anode connection electrode ACE2. Accordingly, the first partial electrode EE1 may be connected to a twenty-first source electrode S21 of a twenty-first transistor T21, but the second partial electrode EE2 may be separated from the twenty-first source electrode S21 of the twenty-first transistor T21. At this time, in plan view as illustrated in FIG. 8, the first partial electrode EE1 may be smaller than the second partial electrode EE2. For example, in plan view, the area of the first partial electrode EE1 may be smaller than the area of the second partial electrode EE2. Therefore, when a driving current is supplied to the second anode AND2, an actual emission area of the darkened second pixel PX2 may be minimized. Here, the actual emission area of the darkened second pixel PX2 may be an area corresponding to the first partial electrode EE1 of the second anode AND2.

According to an embodiment, a groove may be formed in the via layer VA on the sixth cutting line CL6 by the laser beam LB.

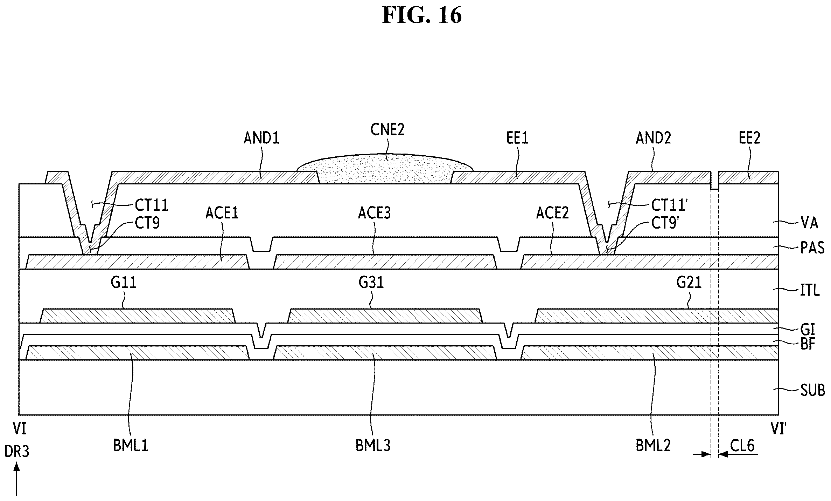

Next, as illustrated in FIGS. 8 and 16, a second connection electrode CNE2 may be disposed on the via layer VA. For example, the second connection electrode CNE2 may be disposed on the via layer VA to overlap the first anode AND1 and the second anode AND2. Specifically, the second connection electrode CNE2 may be disposed on the via layer VA to overlap the first anode AND1 and the first partial electrode EE1 of the second anode AND2. One side of the second connection electrode CNE2 may contact (or directly contact) the first anode AND1, and the other side of the second connection electrode CNE2 may contact (or directly contact) the first partial electrode EE1 of the second anode AND2. Accordingly, the first anode AND1 and the first partial electrode EE1 of the second anode AND2 may be electrically connected to each other. The second connection electrode CNE2 may include, for example, conductive ink.

According to an embodiment, since the pixel circuit of the second pixel PX2 is connected to the first pixel PX1 through the first partial electrode EE1 of the second anode AND2, the first pixel PX1 may be repaired, and the second pixel PX2 may be darkened.

According to an embodiment, as illustrated in FIG. 8, the second connection electrode CNE2 may be shaped like a straight line that connects the first anode AND1 and the first partial electrode EE1 of the second anode AND2 in the shortest path.

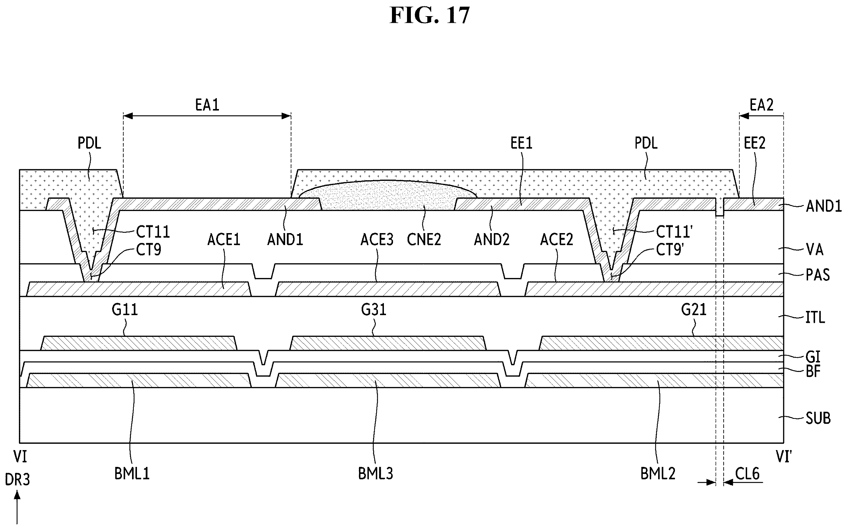

Next, as illustrated in FIGS. 8 and 17, a pixel defining layer PDL may be disposed on the first anode AND1, the second anode AND2, and the second connection electrode CNE2. A portion of the first anode AND1 may be exposed through a first emission area EA1 defined by the pixel defining layer PDL, and a portion of the second anode AND2 may be exposed through a second emission area EA2 defined by the pixel defining layer PDL.

According to an embodiment, the first connection electrode CNE1 may be covered by the pixel defining layer PDL. However, the present disclosure is not limited thereto. For example, at least a portion of the first connection electrode CNE1 may be disposed in at least one of the first emission area EA1 and the second emission area EA2.

According to an embodiment, the first partial electrode EE1 of the second anode AND2 may be covered by the pixel defining layer PDL. For example, at least a portion of the first partial electrode EE1 may be covered by the pixel defining layer PDL. In FIG. 17, an embodiment in which the entire first partial electrode EE1 is covered by the pixel defining layer PDL is illustrated.

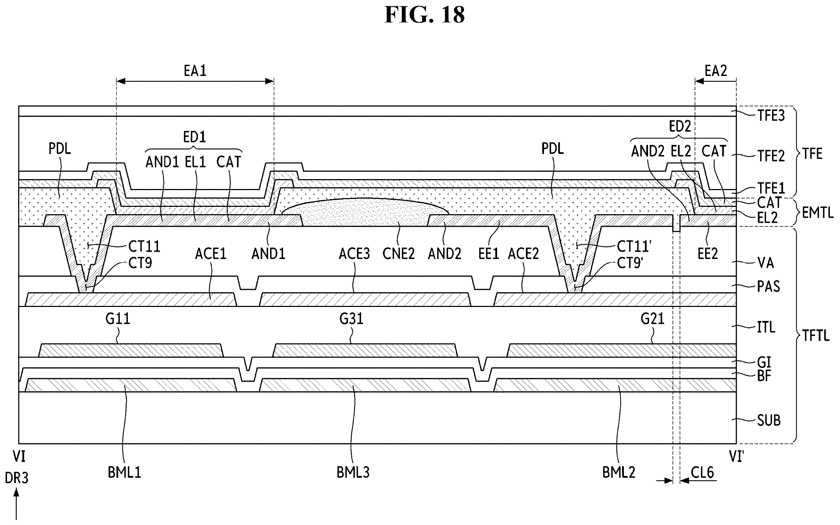

Next, as illustrated in FIGS. 8 and 18, a first light emitting layer EL1 may be disposed on the first anode AND1 through the first emission area EA1 of the pixel defining layer PDL, and a second light emitting layer EL2 may be disposed on the second anode AND2 through the second emission area EA2 of the pixel defining layer PDL. Although not illustrated, a third light emitting layer may be disposed on the third anode AND3.

Next, a cathode CAT may be disposed on the first light emitting layer EL1, the second light emitting layer EL2, and the third light emitting layer.

Next, an encapsulation layer ENC may be disposed on the cathode CAT. The encapsulation layer ENC may include a first encapsulating inorganic layer TFE1, an encapsulating organic layer TFE2, and a second encapsulating inorganic layer TFE3.

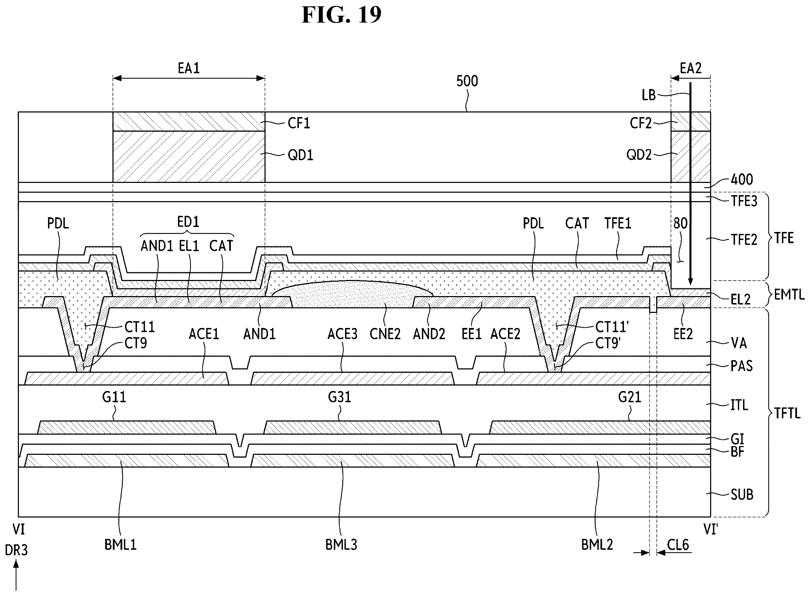

Next, as illustrated in FIGS. 8 and 19, a filler 400 may be disposed on the encapsulation layer ENC. The filler 400 may be made of a material that can transmit light. For example, the filler 400 may be made of an organic material. According to an embodiment, the filler 400 may be made of a silicon-based organic material, an epoxy-based organic material, or a mixture of a silicon-based organic material and an epoxy-based organic material.

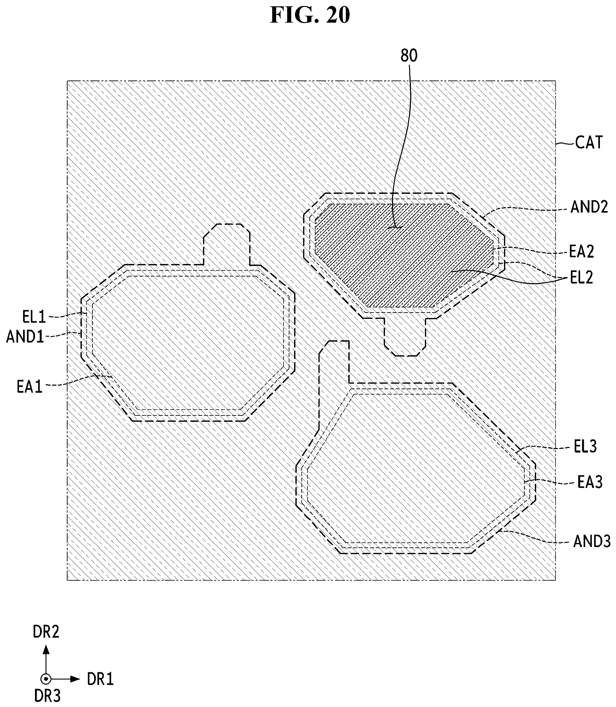

Next, a color conversion substrate 500 may be disposed on the filler 400. According to an embodiment, the color conversion substrate 500 may include a color conversion pattern that converts the color of incident light. According to an embodiment, the color conversion substrate 500 may include at least any one of a color filter and a wavelength conversion pattern as the color conversion pattern. According to an embodiment, the color conversion substrate 500 may include both the color filter and the wavelength conversion pattern. For example, the first pixel PX1 may include a first wavelength conversion pattern QD1 and a first color filter CF1 which overlap the first emission area EA1, and the second pixel PX2 may include a second wavelength conversion pattern QD2 and a second color filter CF2 which overlap the second emission area EA2. Although not illustrated, the third pixel PX3 may include a third wavelength conversion pattern and a third color filter which overlap a third emission area EA3 (see FIG. 20).

The first wavelength conversion pattern QD1 may be a wavelength conversion pattern that converts or shifts a peak wavelength of incident light into another specific peak wavelength and outputs light of the specific peak wavelength. For example, the first wavelength conversion pattern QD1 may convert blue light from the first light emitting layer EL1 into green light and provide the green light to the first color filter CF1.

The second wavelength conversion pattern QD2 may be a wavelength conversion pattern that converts or shifts a peak wavelength of incident light into another specific peak wavelength and outputs light of the specific peak wavelength. For example, the second wavelength conversion pattern QD2 may transmit blue light from the second light emitting layer EL2 and provide the blue light to the second color filter CF2.

The third wavelength conversion pattern may be a wavelength conversion pattern that converts or shifts a peak wavelength of incident light into another specific peak wavelength and outputs light of the specific peak wavelength. For example, the third wavelength conversion pattern may convert blue light from the third light emitting layer EL3 (see FIG. 20) into red light and provide the red light to the third color filter.

The first color filter CF1, the second color filter CF2, and the third color filter may selectively transmit light of different colors (or different wavelengths). For example, the first color filter CF1 may selectively transmit green light, the second color filter CF2 may selectively transmit blue light, and the third color filter may selectively transmit red light.

Here, the first light emitting layer EL1, the second light emitting layer EL2, and the third light emitting layer described above may be integrally formed with each other. For example, the first light emitting layer EL1, the second light emitting layer EL2, and the third light emitting layer may all have a tandem structure that provides blue light (or cyan light). For example, each of the first light emitting layer EL1, the second light emitting layer EL2, and the third light emitting layer may include a red light emitting layer, a green light emitting layer, and a blue light emitting layer stacked along the third direction DR3.

The first pixel PX1 repaired through the above-described processes may emit light normally, and the second pixel PX2 may be darkened. In other words, the first pixel PX1, which is a defective pixel, may be normally driven through the pixel circuit of the second pixel PX2 which is a normal pixel, and the light emitting element ED2 of the second pixel PX2 may be darkened. Since the second pixel PX2 is a pixel that makes the lowest luminance contribution, even if the second pixel PX2 is darkened, the deterioration of the image quality of the display device 100 can be minimized.

The process of repairing the display device 100 according to the embodiment may be performed according to the order of FIGS. 9 through 18. However, the present disclosure is not limited thereto. For example, the process of FIG. 10 may also be performed before the process of FIG. 9. That is, the order of the process of repairing the display device 100 according to the embodiment can be variously changed.

FIGS. 19 and 20 are diagrams for explaining a process of repairing a display device 100 according to an embodiment. For example, the process illustrated in FIGS. 19 and 20 may be performed after the process of FIG. 18 described above. Here, FIG. 20 may be a plan view of a cathode CAT of FIG. 19.

As illustrated in FIGS. 19 and 20, the cathode CAT corresponding to a second emission area EA2 may be removed. For example, as illustrated in FIG. 19, the cathode CAT overlapping the second emission area EA2 may be selectively removed by irradiating a laser beam LB to the cathode CAT overlapping the second emission area EA2 from above a color conversion substate 500. At this time, a portion of a second light emitting layer EL2 may be removed by the laser beam LB. Accordingly, as illustrated in FIGS. 19 and 20, the cathode CAT may have a through hole 80 (or an opening) in an area overlapping the second emission area EA2. The second light emitting layer EL2 may be exposed through the through hole 80 of the cathode CAT. In other words, the cathode CAT according to an embodiment overlaps the first emission area EA1 and a third emission area EA3, but does not overlap the second emission area EA2. According to an embodiment, in plan view, the size of the through hole 80 may be the same as or smaller than the size of the second emission area EA2.

Since the cathode CAT is selectively removed from the second emission area EA2 as described above, the darkening of a second pixel PX2 may be performed more reliably. For example, if the darkening of the second pixel PX2 is not properly performed despite the process of cutting the second anode AND2 in FIG. 15, the darkening of the second pixel PX2 may be performed by selectively removing the cathode CAT of the second emission area EA2 of the second pixel PX2 as illustrated in FIG. 19.

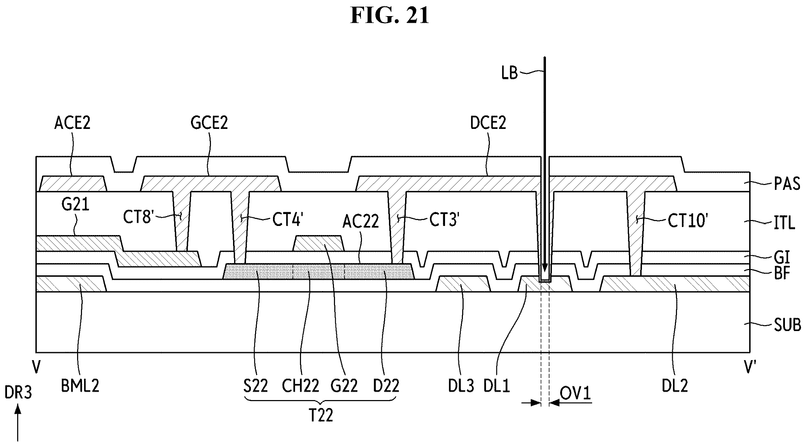

The order of some operations of the above-described repair process can be changed, which will now be described as follows with reference to FIGS. 21 through 23.

FIGS. 21 through 23 are diagrams for explaining a method of fabricating a display device 100 according to an embodiment.

For example, the process order illustrated in FIGS. 12 through 14 described above may be changed to the process order illustrated in FIGS. 21 through 23.

After the process of FIG. 11 described above, a second data connection electrode DCE2 and a first data line DL1 may be electrically connected to each other as illustrated in FIGS. 8 and 21. According to an embodiment, the second data connection electrode DCE2 and the first data line DL1 may be electrically connected to each other in a first overlapping area OV1 of the second data connection electrode DCE2 and the first data line DL1. For example, as illustrated in FIG. 21, when a laser beam LB is irradiated onto a passivation layer PAS in the first overlapping area OV1 of the second data connection electrode DCE2 and the first data line DL1, the second data connection electrode DCE2 and the first data line DL1 may contact (or directly contact) each other in the first overlapping area OV1. Accordingly, a twenty-second drain electrode D22 of a twenty-second transistor T22 and the first data line DL1 may be electrically connected to each other.

According to an embodiment, the passivation layer PAS, an interlayer insulating layer ITL, a gate insulating layer GI, and a buffer layer BF may be penetrated by the laser beam LB in the first overlapping area OV1 of the second data connection electrode DCE2 and the first data line DL1, and a groove may be formed in the first data line DL1.

According to an embodiment, in the first overlapping area OV1, a portion of the second data connection electrode DCE2 may be disposed in respective through holes of the interlayer insulating layer ITL, the gate insulating layer GI and the buffer layer BF and the groove of the first data line DL1.

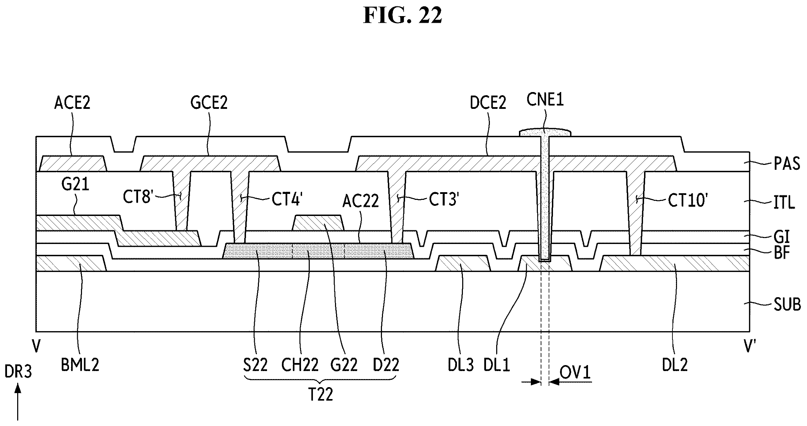

Next, as illustrated in FIGS. 8 and 22, a first connection electrode CNE1 may be disposed on the passivation layer PAS. For example, the first connection electrode CNE1 may be disposed on the passivation layer PAS in the first overlapping area OV1 and around the first overlapping area OV1. A portion of the first connection electrode CNE1 may be disposed in the respective through holes of the passivation layer PAS, the interlayer insulating layer ITL, the gate insulating layer GI and the buffer layer BF (e.g., the through holes formed by irradiating the laser beam LB to the first overlapping area OV1 of FIG. 13) and the groove of the first data line DL1 (e.g., the groove formed by irradiating the laser beam LB to the first overlapping area OV1 of FIG. 13). At this time, the portion of the first connection electrode CNE1 may contact (or directly contact) the second data connection electrode DCE2 and the first data line DL1 in the above-described through holes and groove.

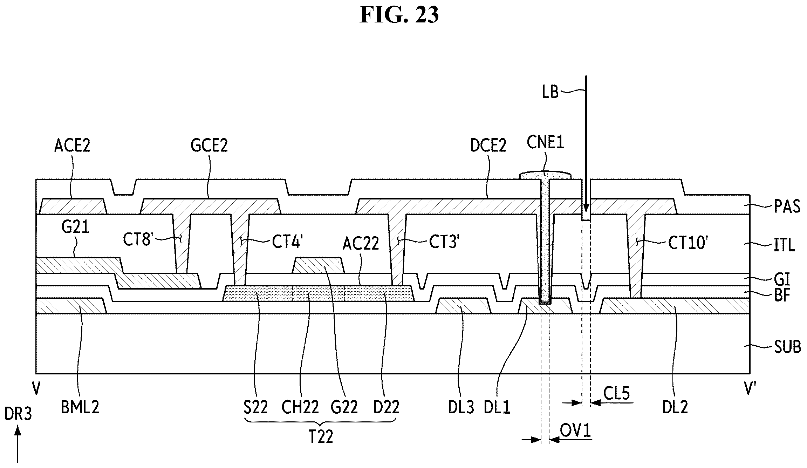

Next, as illustrated in FIGS. 8 and 23, the second data connection electrode DCE2 may be cut. According to an embodiment, the second data connection electrode DCE2 may be cut along a fifth cutting line CL5. For example, as illustrated in FIG. 23, when a laser beam LB is irradiated onto the passivation layer PAS along the fifth cutting line CL5, the second data connection electrode DCE2 on the fifth cutting line CL5 may be cut. Accordingly, the twenty-second drain electrode D22 of the twenty-second transistor T22 and a second data line DL2 may be electrically isolated from each other.

According to an embodiment, the passivation layer PAS and the second data connection electrode DCE2 on the fifth cutting line CL5 may be penetrated by the laser beam LB, and a groove may be formed in the interlayer insulating layer ITL.

A third cutting line CL3 and a fourth cutting line CL4 described above may be connected as one line, and at this time, the laser beam LB may be continuously irradiated along the third cutting line CL3 and the fourth cutting line CL4. In this case, the passivation layer PAS, a first anode connection electrode ACE1, the interlayer insulating layer ITL, and the gate insulating layer GI on the fourth cutting line CL4 may be penetrated by the laser beam LB, and a groove may be formed in the buffer layer BF.

According to the process order of FIGS. 21 through 23, since the process of cutting the second data connection electrode DCE2 is performed after the formation of the first connection electrode CNE1, when conductive ink used as the first connection electrode CNE1 is applied, it can be prevented from flowing into a cut portion of the second data connection electrode DCE2. Accordingly, cut portions of the second data connection electrode DCE2 can be prevented from being connected by the first connection electrode CNE1.

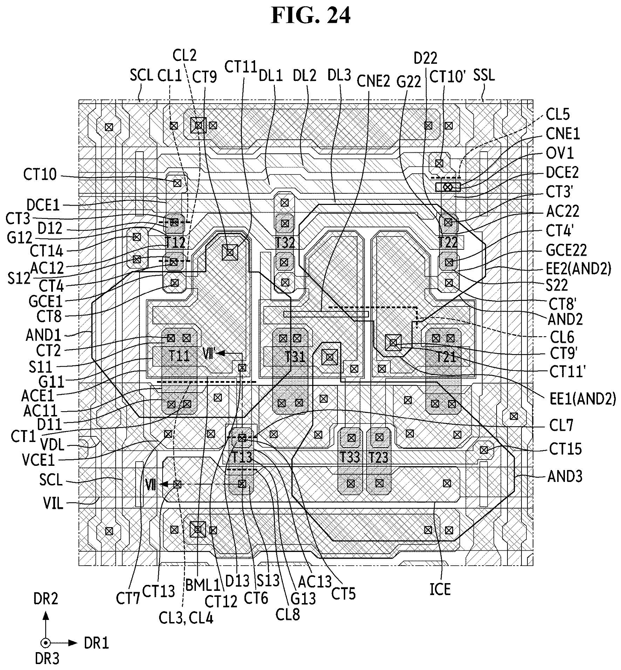

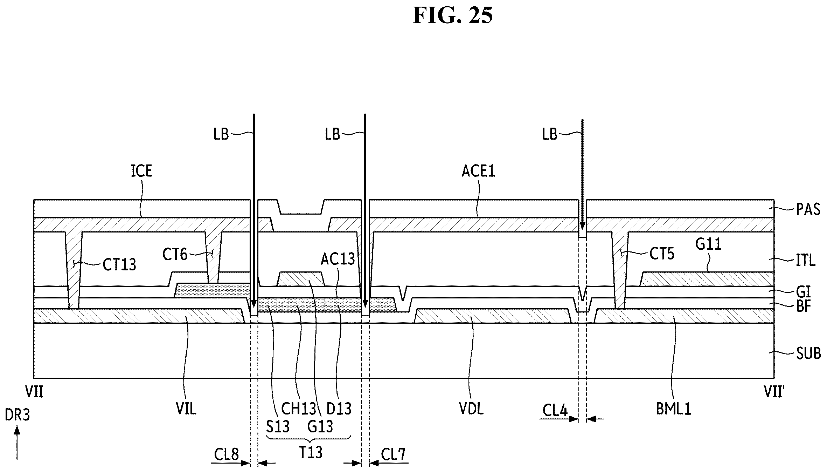

FIGS. 24 and 25 are diagrams for explaining a process of repairing a display device 100 according to an embodiment. For example, FIG. 24 may be a diagram illustrating a seventh cutting line CL7 and an eighth cutting line CL8 in addition to the cutting lines of FIG. 8 described above, and FIG. 25 may be a cross-sectional view taken along line VII-VII' of FIG. 24.

As illustrated in FIGS. 24 and 25, a thirteenth drain electrode D13 and a thirteenth source electrode S13 of a thirteenth transistor T13 may be cut. According to an embodiment, the thirteenth drain electrode D13 of the thirteenth transistor T13 may be cut along the seventh cutting line CL7, and the thirteenth source electrode S13 of the thirteenth transistor T13 may be cut along the eighth cutting line CL8. For example, as illustrated in FIG. 25, when a laser beam LB is irradiated onto a passivation layer PAS along the seventh cutting line CL7, a first anode connection electrode ACE1 and the thirteenth drain electrode D13 of the thirteenth transistor T13 on the seventh cutting line CL7 may be cut. In addition, when a laser beam LB is irradiated onto the passivation layer PAS along the eighth cutting line CL8, an initialization connection electrode ICE and the thirteenth source electrode S13 of the thirteenth transistor T13 on the eighth cutting line CL8 may be cut. Accordingly, the thirteenth drain electrode D13 of the thirteenth transistor T13 and a first light blocking layer BML1 may be electrically isolated from each other, and the thirteenth source electrode S13 of the thirteenth transistor T13 and an initialization voltage line VIL may be electrically isolated from each other. Accordingly, the thirteenth drain electrode D13 of the thirteenth transistor T13 and one electrode of a first capacitor Cst1 may be electrically isolated from each other.

According to an embodiment, in plan view, at least one of the thirteenth drain electrode D13 and the first anode connection electrode ACE1 may be cut along the seventh cutting line CL7 between a fifth contact hole CT5 and a channel region CH13 of the thirteenth transistor T13.

According to an embodiment, in plan view, at least one of the thirteenth drain electrode D13 and the first anode connection electrode ACE1 may be cut along the seventh cutting line CL7 on the fifth contact hole CT5.

According to an embodiment, in plan view, at least one of the thirteenth source electrode S13 and the initialization connection electrode ICE may be cut along the eighth cutting line CL8 between a sixth contact hole CT6 and the channel region CH13 of the thirteenth transistor T13.

According to an embodiment, in plan view, at least one of the thirteenth source electrode S13 and the initialization connection electrode ICE may be cut along the eighth cutting line CL8 on the sixth contact hole CT6.

According to an embodiment, the passivation layer PAS, the first anode connection electrode ACE1, an interlayer insulating layer ITL, a gate insulating layer GI, and the thirteenth drain electrode D13 on the seventh cutting line CL7 may be penetrated by the laser beam LB, and a groove may be formed in a buffer layer BF. In addition, the passivation layer PAS, the initialization connection electrode ICE, the interlayer insulating layer ITL, the gate insulating layer GI, and the thirteenth source electrode S13 on the eighth cutting line CL8 may be penetrated by the laser beam LB, and a groove may be formed in the buffer layer BF.

According to an embodiment, the process of FIGS. 24 and 25 may be performed, for example, between the process of FIG. 11 and the process of FIG. 12 described above.

According to an embodiment, the process of FIGS. 24 and 25 may be performed, for example, between the process of FIG. 12 and the process of FIG. 13 described above.

According to an embodiment, the process of FIGS. 24 and 25 may be performed, for example, instead of the process of FIG. 11 described above. As a specific example, after the process of FIG. 10 described above is performed, the process of FIGS. 24 and 25 may be performed instead of the process of FIG. 11.

The process of FIGS. 24 and 25 may also be omitted.

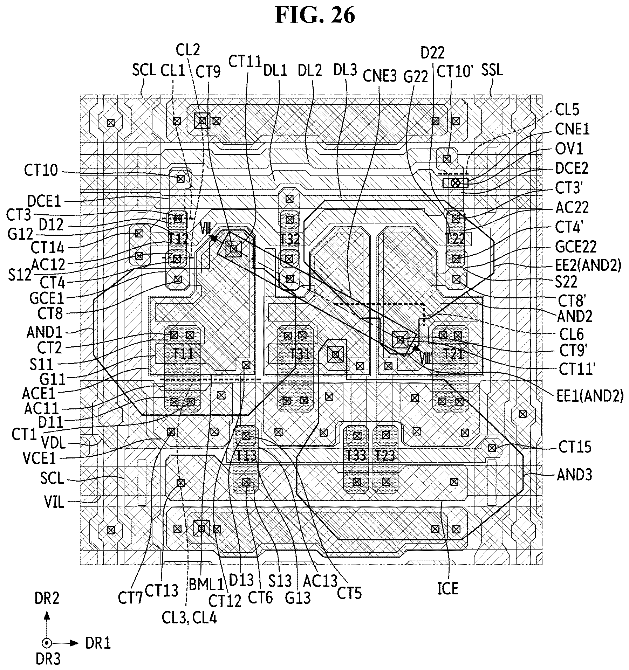

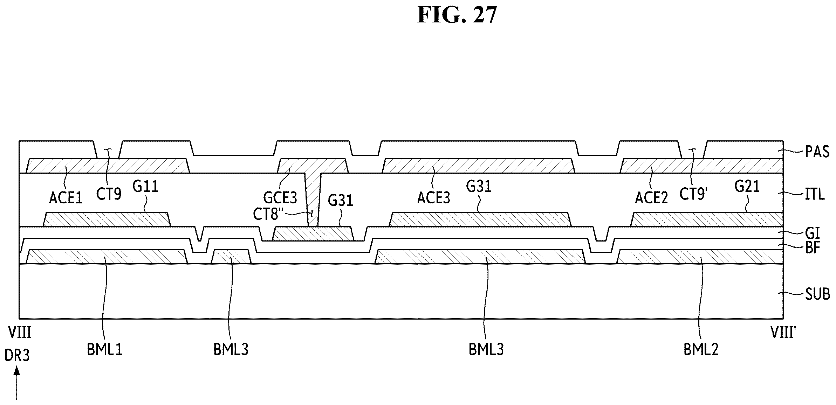

FIGS. 26 through 31 are diagrams for explaining a method of fabricating a display device 100 according to an embodiment. For example, FIG. 26 may be a diagram illustrating a third connection electrode CNE3 instead of the second connection electrode CNE2 of FIG. 8 described above, and FIGS. 27 through 31 may be cross-sectional views taken along line VIII-VIII' of FIG. 26.

According to an embodiment, processes of FIGS. 26 through 31 may be performed after the process of FIG. 14 described above. In this case, the processes of FIGS. 15 through 18 described above may be replaced with the processes of FIGS. 26 through 31. In other words, the method of fabricating the display device 100 according to the embodiment may include the processes of FIGS. 9 through 14 and the processes of FIGS. 26 through 31.

After the process of FIG. 14, as illustrated in FIGS. 26 and 27, ninth contact holes CT9 and CT9' exposing a first anode connection electrode ACE1 and a second anode connection electrode ACE2, respectively, may be formed in a passivation layer PAS. One of the ninth contact holes CT9 and CT9' may penetrate the passivation layer PAS to expose the first anode connection electrode ACE1, and the other of the ninth contact holes CT9 and CT9' may penetrate the passivation layer PAS to expose the second anode connection electrode ACE2.

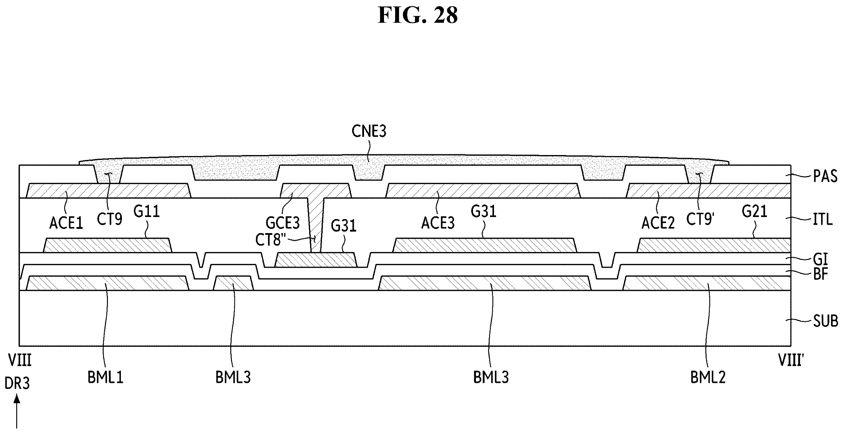

Next, as illustrated in FIGS. 26 and 28, the third connection electrode CNE3 may be disposed on the passivation layer PAS. The third connection electrode CNE3 may be connected to the first anode connection electrode ACE1 and the second anode connection electrode ACE2. For example, one side of the third connection electrode CNE3 may be connected to the first anode connection electrode ACE1 through the ninth contact hole CT9, and the other side of the third connection electrode CNE3 may be connected to the second anode connection electrode ACE2 through the ninth contact hole CT9'. In other words, one side of the third connection electrode CNE3 may contact (or directly contact) the first anode connection electrode ACE1 through the ninth contact hole CT9, and the other side of the third connection electrode CNE3 may contact (or directly contact) the second anode connection electrode ACE2 through the ninth contact hole CT9'. Accordingly, the first anode connection electrode ACE1 and the second anode connection electrode ACE2 may be electrically connected to each other by the third connection electrode CNE3. The third connection electrode CNE3 may include, for example, conductive ink.

According to an embodiment, as illustrated in FIG. 26, the third connection electrode CNE3 may be shaped like a straight line that connects the ninth contact holes CT9 and CT9' in the shortest path.

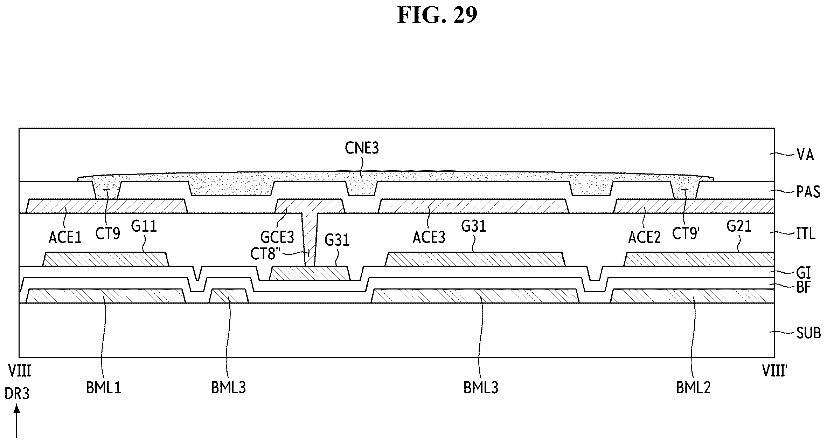

Next, as illustrated in FIGS. 26 and 29, a via layer VA may be formed on the passivation layer PAS and the third connection electrode CNE3. At this time, the via layer VA may also be disposed on a first connection electrode CNE1 described above. In other words, the first connection electrode CNE1 and the third connection electrode CNE3 may be covered by the via layer VA.

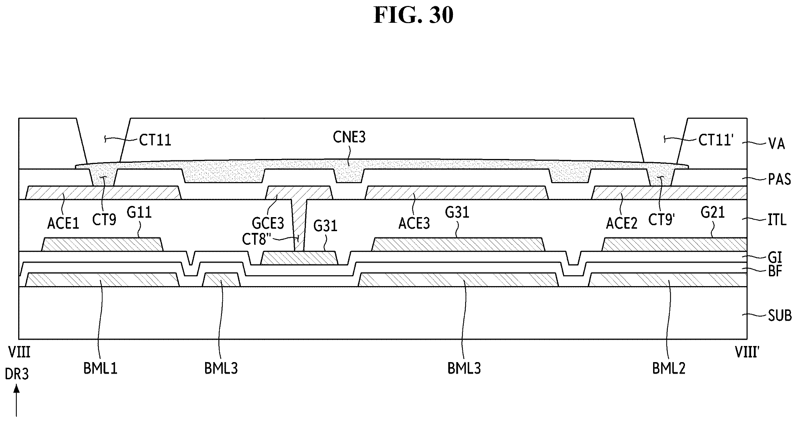

Next, as illustrated in FIGS. 26 and 30, eleventh contact holes CT11 and CT11' overlapping the ninth contact holes CT9 and CT9', respectively, may be formed in the via layer VA. In plan view, one of the eleventh contact holes CT11 and CT11' may surround the ninth contact hole CT9 overlapping the first anode connection electrode ACE1 and the third connection electrode CNE3, and the other of the eleventh contact holes CT11 and CT11' may surround the ninth contact hole CT9' overlapping the second anode connection electrode ACE2 and the third connection electrode CNE3. Each of the ninth contact holes CT9 and CT9' may penetrate the via layer VA to expose the third connection electrode CNE3.

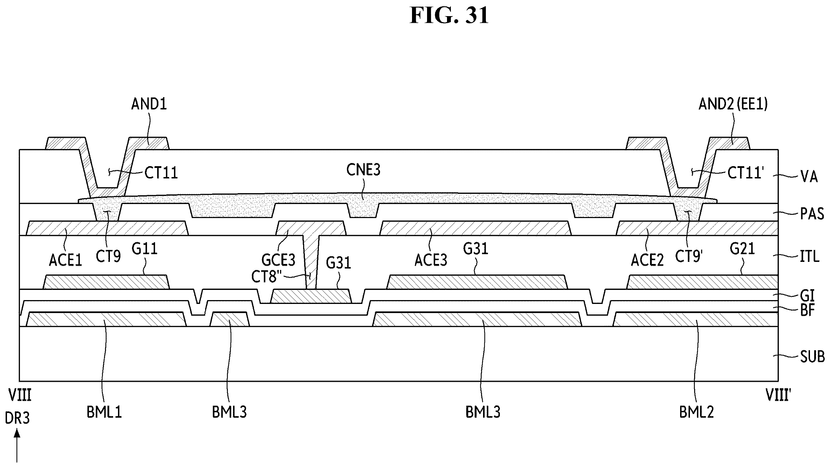

Next, as illustrated in FIGS. 26 and 31, a first anode AND1 and a second anode AND2 may be disposed on the via layer VA. The first anode AND1 may be connected to one side of the third connection electrode CNE3 through the eleventh contact hole CT11, and the second anode AND2 may be connected to the other side of the third connection electrode CNE3 through the eleventh contact hole CT11'. Therefore, the first anode AND1 and the second anode AND2 may be electrically connected to each other through the third connection electrode CNE3.

Next, as illustrated in FIG. 26, the second anode AND2 may be cut along a sixth cutting line CL6 and thus separated into a first partial electrode EE1 and a second partial electrode EE2. A detailed description of the process of cutting the second anode AND2 can be found, for example, in the process of FIG. 15 described above and the related description. Since the second anode AND2 is separated into the first partial electrode EE1 and the second partial electrode EE2, the first partial electrode EE1 may be connected to the third connection electrode CNE3, but the second partial electrode EE2 may be electrically isolated from the third connection electrode CNE3. In other words, the first anode AND1 and the first partial electrode EE1 of the second anode AND2 may be electrically connected to each other by the third connection electrode CNE3. Therefore, a pixel circuit of a second pixel PX2 may be connected to a first pixel PX1 through the first partial electrode EE1 of the second anode AND2. Accordingly, the first pixel PX1 may be repaired, and the second pixel PX2 may be darkened.

Next, a pixel defining layer PDL may be disposed on the first anode AND1 and the second anode AND2, a first emitting layer EL1 and a second emitting layer EL2 respectively connected to the first anode AND1 and the second anode AND2 may be disposed on the pixel defining layer PDL, a cathode CAT connected to the first emitting layer EL1 and the second emitting layer EL2 may be disposed, and an encapsulation layer ENC may be disposed on the cathode CAT. A description of these processes can be found, for example, in the description of the related processes in FIGS. 16 through 18.

According to an embodiment, the display device 100 may include both the second connection electrode CNE2 and the third connection electrode CNE3 described above. In this case, after the processes of FIGS. 9 through 14 are sequentially performed, the processes of FIGS. 27 through 30 may be sequentially performed. Then, as in FIG. 26, the process of separating the second anode AND2 into the first partial electrode EE1 and the second partial electrode EE2 along the sixth cutting line CL6 may be performed (e.g., see FIG. 15). Then, the process of electrically connecting the first anode AND1 and the first partial electrode EE1 of the second anode AND2 to each other using the second connection electrode CNE2 may be performed (e.g., see FIG. 16).

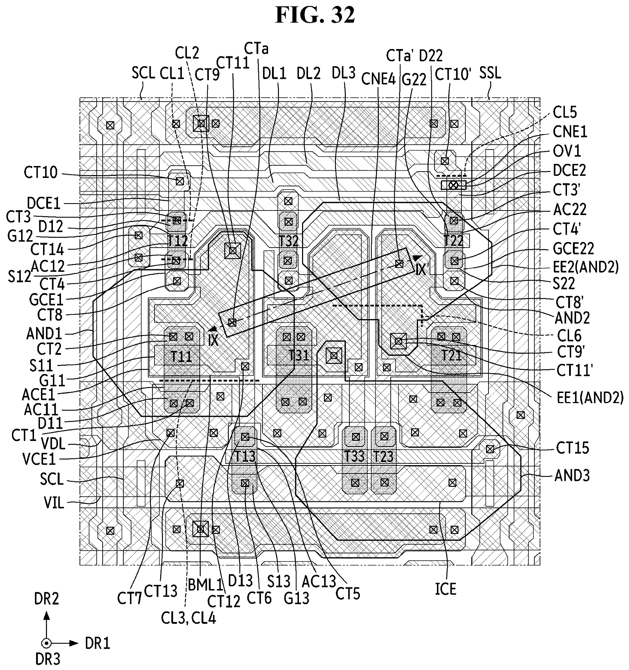

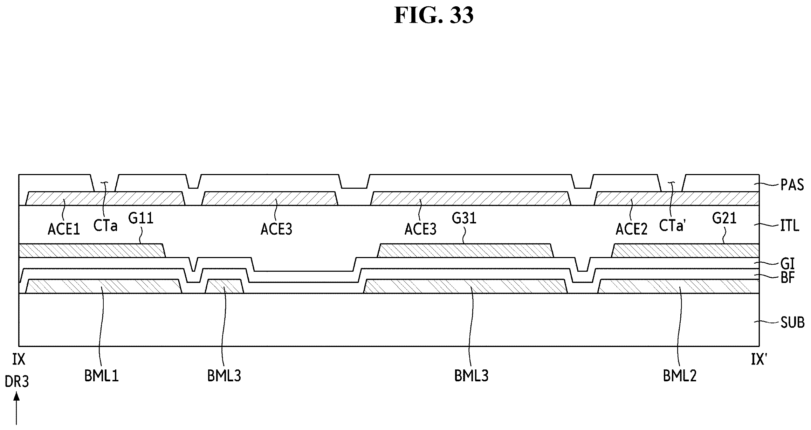

FIGS. 32 through 36 are diagrams for explaining a method of fabricating a display device 100 according to an embodiment. For example, FIG. 32 may be a diagram illustrating a fourth connection electrode CNE4 instead of the second connection electrode CNE2 of FIG. 8 described above, and FIGS. 33 through 36 may be cross-sectional views taken along line IX-IX' of FIG. 32.

According to an embodiment, processes of FIGS. 32 through 36 may be performed after the process of FIG. 14 described above. In this case, the processes of FIGS. 15 through 18 described above may be replaced with the processes of FIGS. 32 through 36. In other words, the method of fabricating the display device 100 according to the embodiment may include the processes of FIGS. 9 through 14 and the processes of FIGS. 32 through 36.

After the process of FIG. 14, as illustrated in FIGS. 32 and 33, auxiliary contact holes CTa and CTa' exposing a first anode connection electrode ACE1 and a second anode connection electrode ACE2, respectively, may be formed in a passivation layer PAS. One of the auxiliary contact holes CTa and CTa' may penetrate the passivation layer PAS to expose the first anode connection electrode ACE1, and the other of the auxiliary contact holes CTa and CTa' may penetrate the passivation layer PAS to expose the second anode connection electrode ACE2. Here, the auxiliary contact holes CTa and CTa' may be formed at the same time as ninth contact holes CT9 and CT9' of FIG. 32 described above. A detailed description of the process of forming the ninth contact holes CT9 and CT9' can be found, for example, in the description of FIG. 27 and the related process.

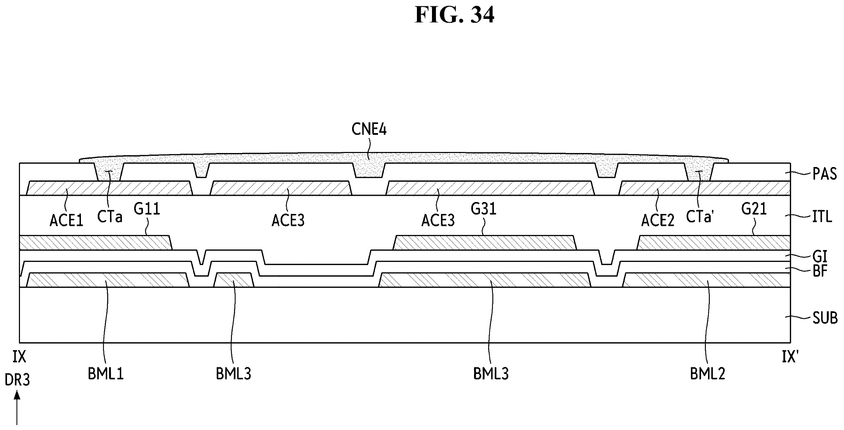

Next, as illustrated in FIGS. 32 and 34, the fourth connection electrode CNE4 may be disposed on the passivation layer PAS. The fourth connection electrode CNE4 may be connected to the first anode connection electrode ACE1 and the second anode connection electrode ACE2. For example, one side of the fourth connection electrode CNE4 may be connected to the first anode connection electrode ACE1 through the auxiliary contact hole CTa, and the other side of the fourth connection electrode CNE4 may be connected to the second anode connection electrode ACE2 through the auxiliary contact hole CTa'. In other words, one side of the fourth connection electrode CNE4 may contact (or directly contact) the first anode connection electrode ACE1 through the auxiliary contact hole CTa, and the other side of the fourth connection electrode CNE4 may contact (or directly contact) the second anode connection electrode ACE2 through the auxiliary contact hole CTa'. Accordingly, the first anode connection electrode ACE1 and the second anode connection electrode ACE2 may be electrically connected to each other by the fourth connection electrode CNE4. The fourth connection electrode CNE4 may include, for example, conductive ink.

According to an embodiment, as illustrated in FIG. 32, the fourth connection electrode CNE4 may be shaped like a straight line that connects the auxiliary contact holes CTa and CTa' in the shortest path.

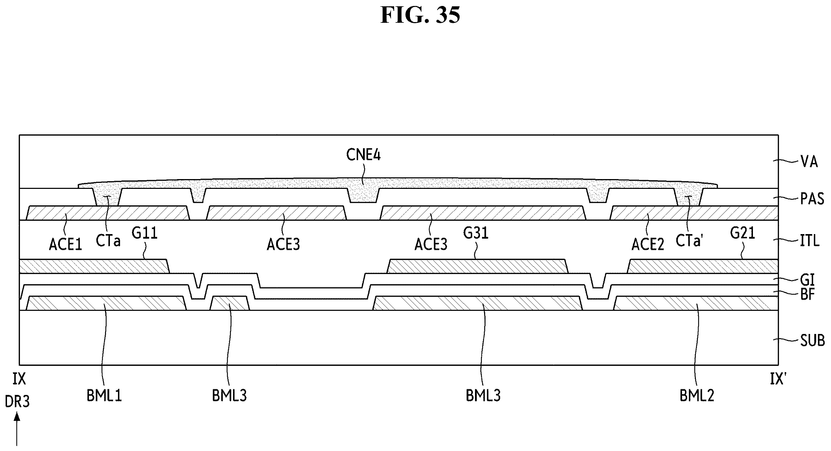

Next, as illustrated in FIGS. 32 and 35, a via layer VA may be formed on the passivation layer PAS and the fourth connection electrode CNE4. At this time, the via layer VA may also be disposed on a first connection electrode CNE1 described above. In other words, the first connection electrode CNE1 and the fourth connection electrode CNE4 may be covered by the via layer VA.

Next, as illustrated in FIG. 32, eleventh contact holes CT11 and CT11' overlapping the ninth contact holes CT9 and CT9', respectively, may be formed in the via layer VA. In plan view, one (CT11) of the eleventh contact holes CT11 and CT11' may surround the ninth contact hole CT9 overlapping the first anode connection electrode ACE1, and the other (CT11') of the eleventh contact holes CT11 and CT11' may surround the ninth contact hole CT9' overlapping the second anode connection electrode ACE2. Each of the ninth contact holes CT9 and CT9' may penetrate the via layer VA to expose a third connection electrode CNE3. A detailed description of the process of forming the eleventh contact holes CT11 and CT11' can be found, for example, in the description of FIG. 30 and the related process.

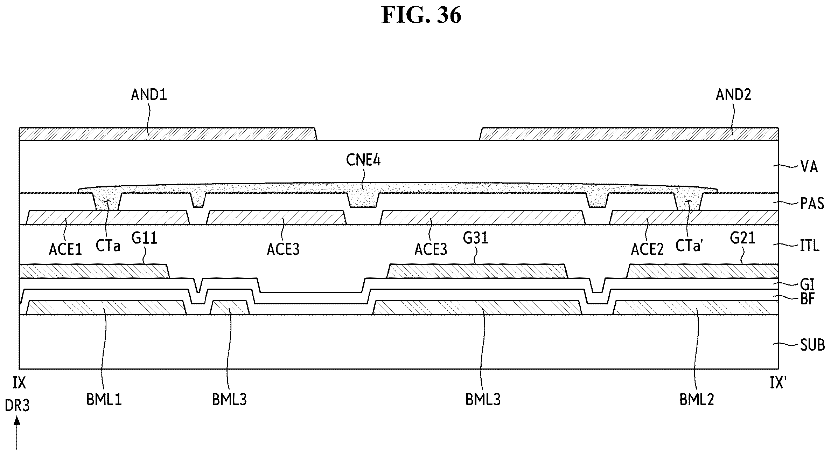

Next, as illustrated in FIGS. 32 and 36, a first anode AND1 and a second anode AND2 may be disposed on the via layer VA. At this time, as illustrated in FIG. 32, the first anode AND1 may be connected to the first anode connection electrode ACE1 through the eleventh contact hole CT11 and the ninth contact hole CT9, and the second anode AND2 may be connected to the second anode connection electrode ACE2 through the eleventh contact hole CT11' and the ninth contact hole CT9'. Therefore, the first anode AND1 and the second anode AND2 may be electrically connected to each other through the first anode connection electrode ACE1, the second anode connection electrode ACE2, and the fourth connection electrode CNE4. In other words, unlike in the embodiment of FIGS. 26 through 31 described above, the first anode AND1 and the second anode AND2 in the embodiment of FIGS. 32 through 36 may not be directly connected to the fourth connection electrode CNE4, but may be indirectly connected to the fourth connection electrode CNE4 through the first anode connection electrode ACE1 and the second anode connection electrode ACE2.

Next, as illustrated in FIG. 32, the second anode AND2 may be cut along a sixth cutting line CL6 and thus separated into a first partial electrode EE1 and a second partial electrode EE2. A detailed description of the process of cutting the second anode AND2 can be found, for example, in the process of FIG. 15 described above and the related description. Since the second anode AND2 is separated into the first partial electrode EE1 and the second partial electrode EE2, the first partial electrode EE1 may be connected to the fourth connection electrode CNE4 through the second anode connection electrode ACE2, but the second partial electrode EE2 may be electrically isolated from the fourth connection electrode CNE4. In other words, the first anode AND1 and the first partial electrode EE1 of the second anode AND2 may be electrically connected to each other by the fourth connection electrode CNE4. Here, the first anode AND1 may be connected to the fourth connection electrode CNE4 through the first anode connection electrode ACE1. Therefore, a pixel circuit of a second pixel PX2 may be connected to a first pixel PX1 through the first partial electrode EE1 of the second anode AND2. Accordingly, the first pixel PX1 may be repaired, and the second pixel PX2 may be darkened.

Next, a pixel defining layer PDL may be disposed on the first anode AND1 and the second anode AND2, a first emitting layer EL1 and a second emitting layer EL2 respectively connected to the first anode AND1 and the second anode AND2 may be disposed on the pixel defining layer PDL, a cathode CAT connected to the first emitting layer EL1 and the second emitting layer EL2 may be disposed, and an encapsulation layer ENC may be disposed on the cathode CAT. A description of these processes can be found, for example, in the description of the related processes in FIGS. 16 through 18.

According to an embodiment related to FIGS. 32 through 36, since the fourth connection electrode CNE4 is disposed on the passivation layer PAS not to overlap the eleventh contact holes CT11 and CT11', it may remain covered by the via layer VA without being exposed during a process of forming the eleventh contact holes CT11, CT11' and CT11" that penetrate the via layer VA (e.g., the process of FIG. 30). Therefore, when the eleventh contact holes CT11, CT11' and CT11" are formed, the fourth connection electrode CNE4 can be prevented from being oxidized or damaged.

According to an embodiment, the display device 100 may include both the second connection electrode CNE2 and the fourth connection electrode CNE4 described above. In this case, after the processes of FIGS. 9 through 14 are sequentially performed, the processes of FIGS. 33 through 36 may be sequentially performed. Then, as in FIG. 26, the process of separating the second anode AND2 into the first partial electrode EE1 and the second partial electrode EE2 along the sixth cutting line CL6 may be performed (e.g., see FIG. 15). Then, the process of electrically connecting the first anode AND1 and the first partial electrode EE1 of the second anode AND2 to each other using the second connection electrode CNE2 may be performed (e.g., see FIG. 16).

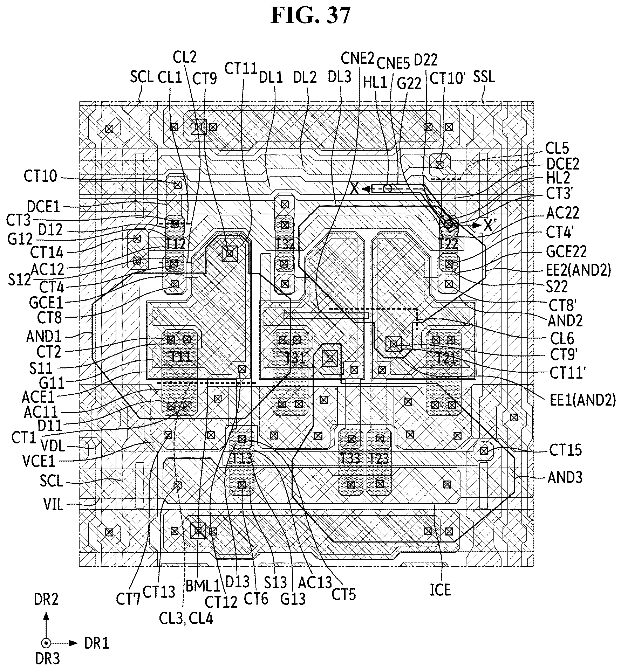

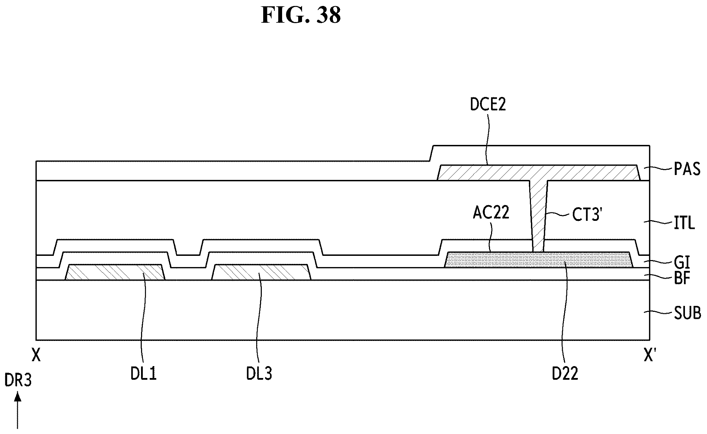

FIGS. 37 through 40 are diagrams for explaining a method of fabricating a display device 100 according to an embodiment. For example, FIG. 37 may be a diagram illustrating a fifth connection electrode CNE5 in addition to the elements of FIG. 8 described above, and FIGS. 38 through 40 may be cross-sectional views taken along line X-X' of FIG. 37.

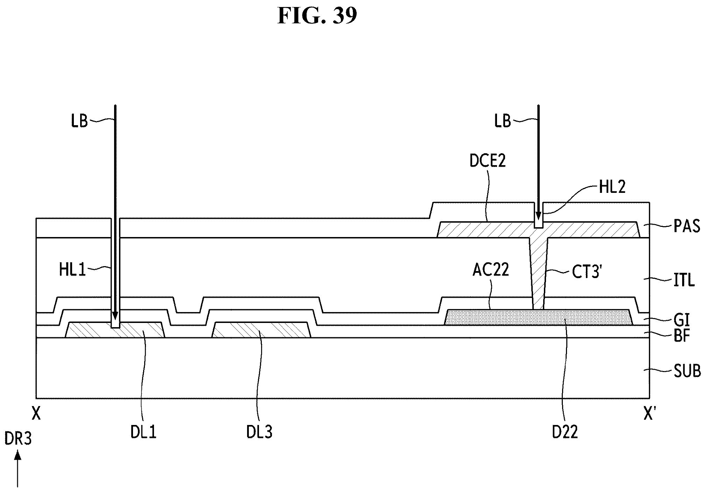

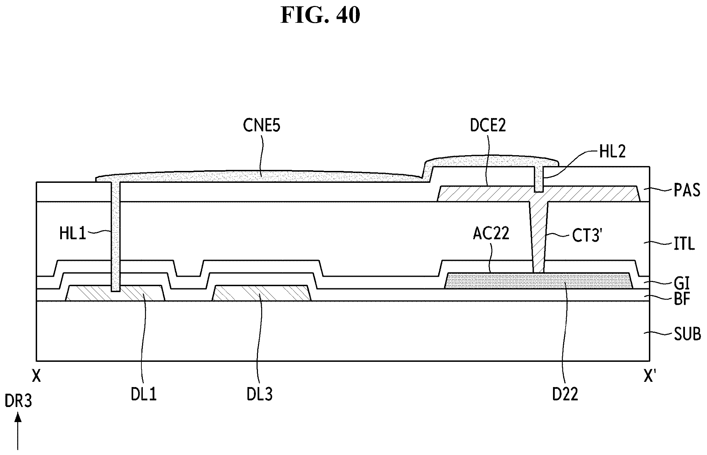

According to an embodiment, processes of FIGS. 37 through 40 may be performed after the process of FIG. 12 described above. In this case, the processes of FIGS. 13 and 14 described above may be replaced with the processes of FIGS. 39 and 40. In other words, the method of fabricating the display device 100 according to the embodiment may include the processes of FIGS. 9 through 12 and the processes of FIGS. 39 and 40.

After the process of FIG. 12, as illustrated in FIGS. 37 through 39, a first through hole HL1 exposing a first data line DL1 and a second through hole HL2 exposing a second data connection electrode DCE2 may be formed. The first through hole HL1 may penetrate a passivation layer PAS, an interlayer insulating layer ITL, a gate insulating layer GI, and a buffer layer BF. The second through hole HL2 may penetrate the passivation layer PAS. At this time, a groove may be formed in each of the first data line DL1 and the second data connection electrode DCE2 by irradiating a laser beam LB. The first through hole HL1 and the second through hole HL2 described above may also be formed by, for example, an etching process instead of the laser beam LB. For example, the first through hole HL1 and the second through hole HL2 may be formed by an etching process for forming ninth contact holes CT9, CT9' and CT9" of the passivation layer PAS described above. In this case, the first through hole HL1, the second through hole HL2, and the ninth contact holes CT9, CT9' and CT9" may be formed simultaneously by one etching process.

Next, as illustrated in FIGS. 37 through 40, the fifth connection electrode CNE5 may be disposed on the passivation layer PAS. The fifth connection electrode CNE5 may be connected to a second data line DL2 and the second data connection electrode DCE2. For example, one side of the fifth connection electrode CNE5 may contact (or directly contact) the first data line DL1 through the first through hole HL1, and the other side of the fifth connection electrode CNE5 may contact (or directly contact) the second data connection electrode DCE2 through the second through hole HL2. Accordingly, the first data line DL1 and the second data connection electrode DCE2 may be electrically connected to each other. In other words, a twenty-second drain electrode D22 of a twenty-second transistor T22 may be electrically connected to the first data line DL1 through the second data connection electrode DCE2 and the fifth connection electrode CNE5. The fifth connection electrode CNE5 may include conductive ink.

According to an embodiment, the fifth connection electrode CNE5 may overlap the first through third data lines DL1 through DL3 as illustrated in FIG. 37. In addition, the fifth connection electrode CNE5 may overlap the second data connection electrode DCE2.

According to an embodiment, as illustrated in FIG. 37, the fifth connection electrode CNE5 may have a bent shape. However, the present disclosure is not limited thereto, and the fifth connection electrode CNE5 may also be shaped like a straight line that connects the first through hole HL1 and the second through hole HL2 in the shortest path.

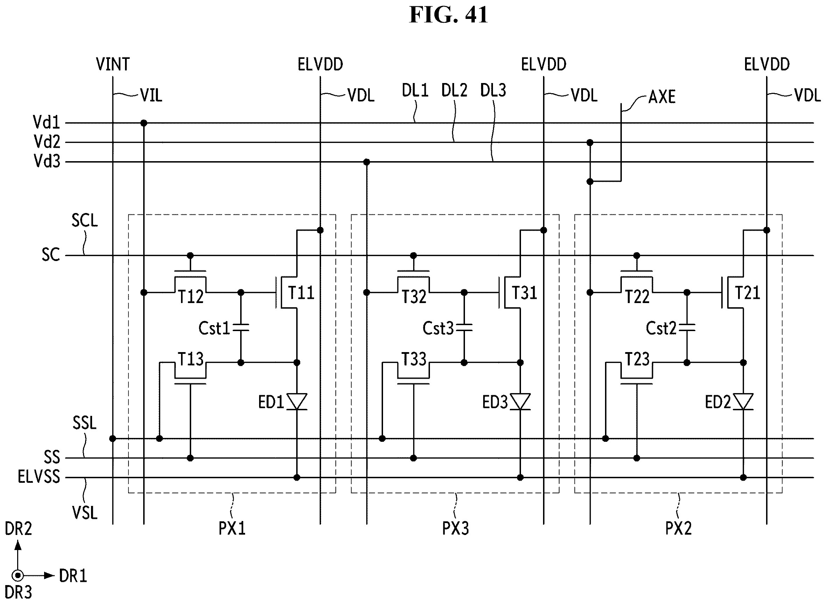

FIG. 41 is a circuit diagram of a display device 100 according to an embodiment.

The display device 100 of FIG. 41 is different from the display device 100 of FIG. 2 described above in the connection relationship between pixels PX1 through PX3 and data lines DL1 through DL3 and is also different from the display device 100 of FIG. 2 in that it further includes an auxiliary connection electrode AXE. Therefore, these differences will be mainly described as follows.

As illustrated in FIG. 41, a second data line DL2 may be disposed between a first data line DL1 and a third data line DL3.

The auxiliary connection electrode AXE may be connected to a second data connection electrode DCE2. The auxiliary connection electrode AXE may overlap the first data line DL1, the second data line DL2, and the third data line DL3.

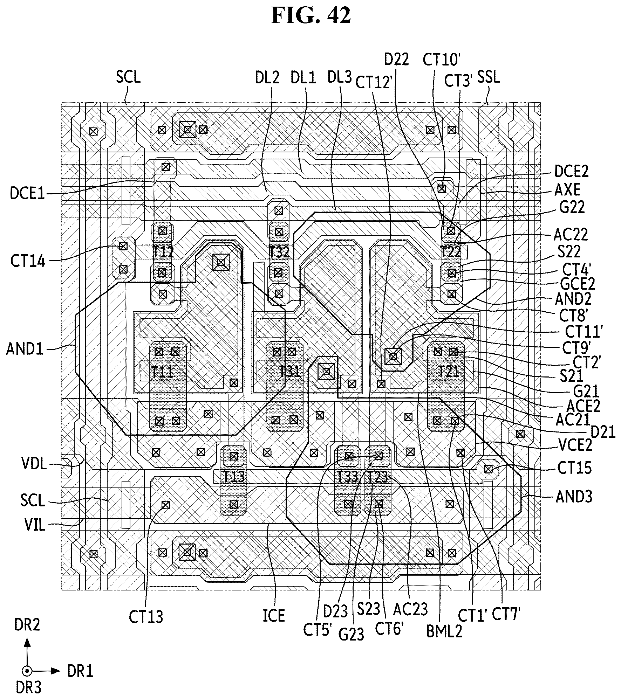

FIG. 42 is a plan view of a display device 100 according to an embodiment. For example, FIG. 42 may be a plan view of a display device 100 including first through third pixels of FIG. 41.

The display device 100 of FIG. 42 is different from the display device 100 of FIG. 3 described above in positions of data lines DL1 through DL3 and shapes of a first data connection electrode DCE1 and a second data connection electrode DCE2 and is also different from the display device 100 of FIG. 3 in that it further includes an auxiliary connection electrode AXE. Therefore, these differences will be mainly described as follows.

As illustrated in FIGS. 41 and 42, a second data line DL2 may be disposed between a first data line DL1 and a third data line DL3. Here, the first data line DL1 may be disposed at an uppermost position, and the third data line DL3 may be disposed at a lowermost position. For example, among the first through third data lines DL1 through DL3, the first data line DL1 may be disposed furthest from a gate structure (e.g., a twelfth gate electrode G12, a thirty-second gate electrode G32, and a twenty-second gate electrode G22), and the third data line DL3 may be disposed closest to the gate structure.

The first data connection electrode DCE1 may overlap the first through third data lines DL1 through DL3.

The second data connection electrode DCE2 may overlap the second data line DL2 and the third data line DL3.

According to an embodiment, the display device 100 of FIG. 41 may further include the auxiliary connection electrode AXE.

The auxiliary connection electrode AXE may be connected to the second data connection electrode DCE2. For example, the auxiliary connection electrode AXE may be integrally formed with the second data connection electrode DCE2. The auxiliary connection electrode AXE may be included, for example, in a fourth pattern layer. One side of the auxiliary connection electrode AXE may be connected to a twenty-second drain electrode D22 of a twenty-second transistor T22 through a third contact hole CT3'. The auxiliary connection electrode AXE may overlap the first through third data lines DL1 through DL3.

According to an embodiment, the display device 100 of FIG. 41 may further include a fifth connection electrode CNE5 of FIG. 37 described above instead of the auxiliary connection electrode AXE. The fifth connection electrode CNE5 may be connected to the twenty-second drain electrode D22 of the twenty-second transistor T22, and the other side of the fifth connection electrode CNE5 may overlap the first data line DL1. At this time, the other side of the fifth connection electrode CNE5 may be connected to the first data line DL1 through a through hole.

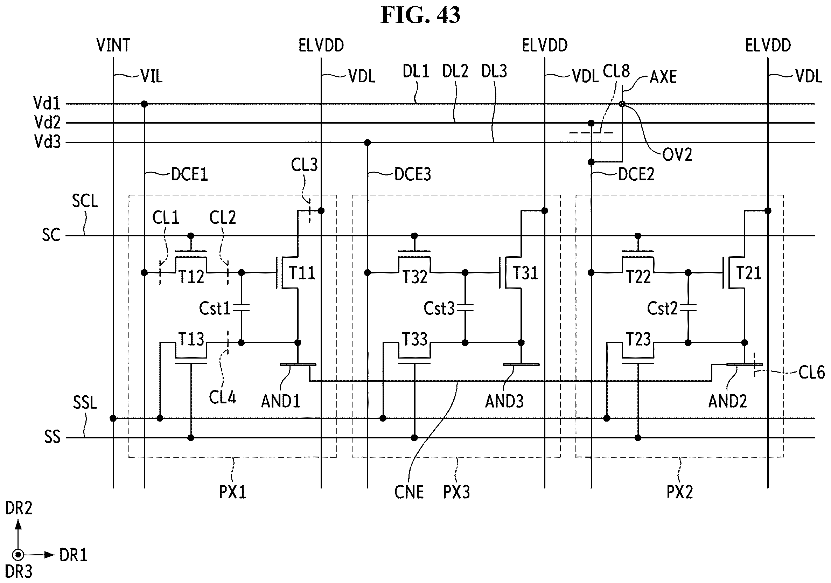

FIG. 43 is a circuit diagram for explaining a method of fabricating a display device 100 according to an embodiment. For example, FIG. 43 may be a diagram for explaining a method of repairing the display device 100 of FIG. 41 described above.

The method of repairing the display device 100 of FIG. 43 is different from the method of repairing the display device 100 of FIG. 7 described above in that it connects a first data line DL1 and a second pixel PX2 by utilizing an auxiliary connection electrode AXE. Therefore, this difference will be mainly described as follows.

For example, in order to connect a pixel circuit (e.g., a twenty-first transistor T21, a twenty-second transistor T22, a twenty-third transistor T23, and a second capacitor Cst2) of a normally operating pixel, for example, the second pixel PX2 to a first pixel PX1, the second pixel PX2 may be connected to the first data line DL1 instead of a second data line DL2. To this end, according to an embodiment, a second data connection electrode DCE2 may be cut along an eighth cutting line CL8, and the auxiliary connection electrode AXE may be connected to the first data line DL1 in a second overlapping area OV2 of the auxiliary connection electrode AXE and the first data line DL1.

According to an embodiment, the first pixel PX1 may be a green pixel that provides green light, the second pixel PX2 may be a blue pixel that provides blue light, and a third pixel PX3 may be a red pixel that provides red light. In a unit pixel including the red pixel, the green pixel, and the blue pixel, the luminance contribution of the green pixel is the highest, and the luminance contribution of the blue pixel is the lowest. Therefore, when the green pixel making the relatively highest luminance contribution is defective, a light emitting element of the green pixel may be driven using a driving current from a pixel circuit of the blue pixel making the relatively lowest luminance contribution, thereby minimizing the defect rate and image quality deterioration of the display device 100.

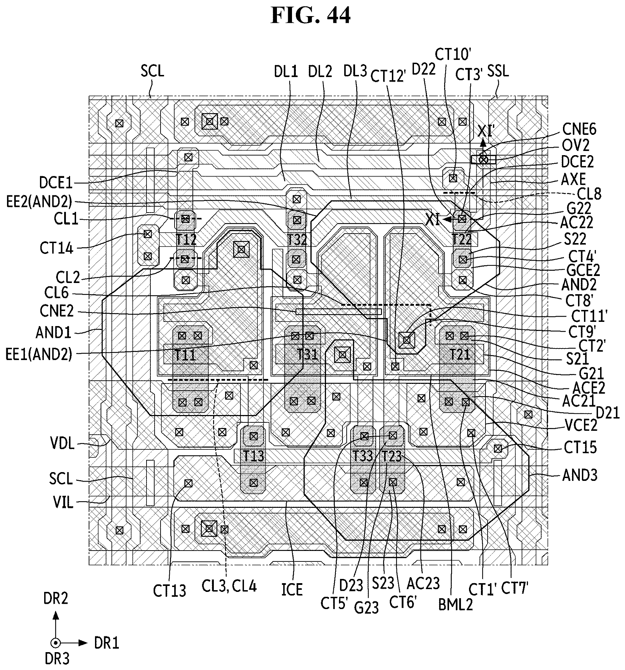

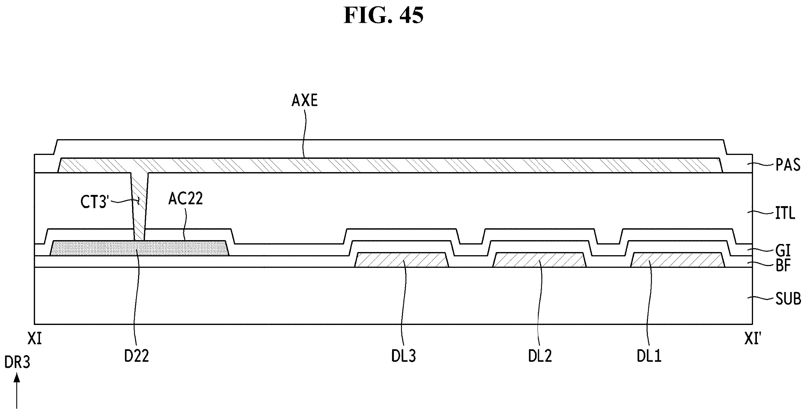

FIGS. 44 through 47 are diagrams for explaining a method of fabricating a display device 100 according to an embodiment. For example, FIGS. 44 through 47 may be diagrams for explaining a method of repairing the display device 100 of FIG. 42. Here, FIGS. 45 through 47 are cross-sectional views taken along line XI-XI' of FIG. 42.

First, as illustrated in FIG. 45, a substrate SUB on which a first pattern layer (e.g., a third data line DL3, a second data line DL2 and a first data line DL1), a buffer layer BF, a second pattern layer (e.g., a twenty-second active layer AC22), a gate insulating layer GI, a third pattern layer, an interlayer insulating layer ITL, a fourth pattern layer (e.g., an auxiliary connection electrode AXE), and a passivation layer PAS are disposed may be prepared.

Next, as illustrated in FIG. 44, a second data connection electrode DCE2 may be cut. According to an embodiment, the second data connection electrode DCE2 may be cut along an eighth cutting line CL8. For example, when a laser beam LB is irradiated onto the passivation layer PAS along the eighth cutting line CL8, the second data connection electrode DCE2 on the eighth cutting line CL8 may be cut. Accordingly, a twenty-second drain electrode D22 of a twenty-second transistor T22 and the second data line DL2 may be electrically isolated from each other. A detailed description of the process of separating the second data connection electrode DCE2 can be found, for example, in FIG. 12 described above and the related description.

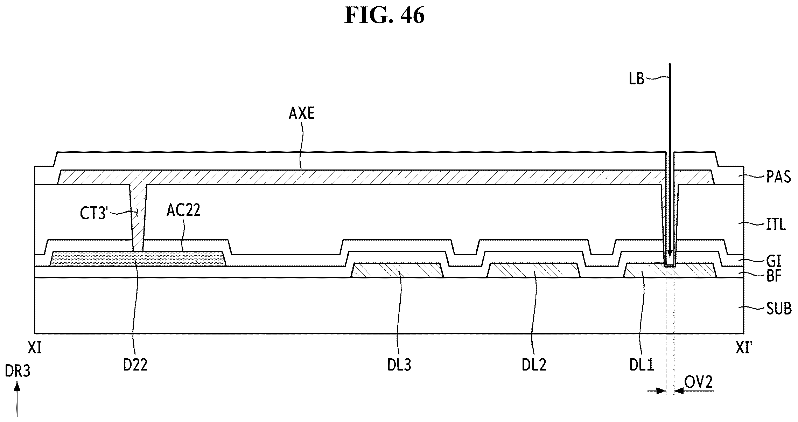

Next, as illustrated in FIGS. 44 and 46, the auxiliary connection electrode AXE and the first data line DL1 may be electrically connected to each other. According to an embodiment, the auxiliary connection electrode AXE and the first data line DL1 may be electrically connected to each other in a second overlapping area OV2 of the auxiliary connection electrode AXE and the first data line DL1. For example, as illustrated in FIG. 46, when a laser beam LB is irradiated onto the passivation layer PAS in the second overlapping area OV2 of the auxiliary connection electrode AXE and the first data line DL1, the auxiliary connection electrode AXE and the first data line DL1 may contact (or directly contact) each other in the second overlapping area OV2. Accordingly, the twenty-second drain electrode D22 of the twenty-second transistor T22 and the first data line DL1 may be electrically connected to each other.

According to an embodiment, the passivation layer PAS, the interlayer insulating layer ITL, the gate insulating layer GI, and the buffer layer BF may be penetrated by the laser beam LB in the second overlapping area OV2 of the auxiliary connection electrode AXE and the first data line DL1, and a groove may be formed in the first data line DL1.

According to an embodiment, in the second overlapping area OV2, a portion of the auxiliary connection electrode AXE may be disposed in respective through holes of the interlayer insulating layer ITL, the gate insulating layer GI and the buffer layer BF and the groove of the first data line DL1.

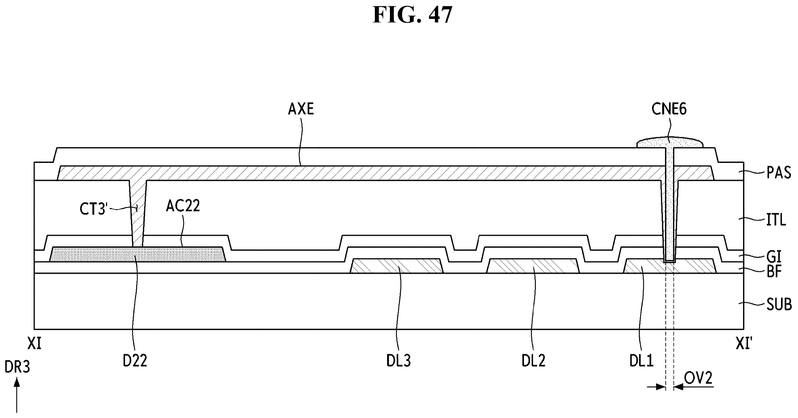

Additionally, as illustrated in FIGS. 44 and 47, a sixth connection electrode CNE6 may be further disposed on the passivation layer PAS. For example, the sixth connection electrode CNE6 may be disposed on the passivation layer PAS in the second overlapping area OV2 and around the second overlapping area OV2. A portion of the sixth connection electrode CNE6 may be disposed in the respective through holes of the passivation layer PAS, the interlayer insulating layer ITL, the gate insulating layer GI and the buffer layer BF (e.g., the through holes formed by irradiating the laser beam LB to the second overlapping area OV2 of FIG. 46) and the groove of the first data line DL1 (e.g., the groove formed by irradiating the laser beam LB to the second overlapping area OV2 of FIG. 46). At this time, the portion of the sixth connection electrode CNE6 may contact (or directly contact) the auxiliary connection electrode AXE and the first data line DL1 in the above-described through holes and groove. The sixth connection electrode CNE6 may improve the connection state between the auxiliary connection electrode AXE and the first data line DL1. The sixth connection electrode CNE6 may include, for example, conductive ink. The sixth connection electrode CNE6 may also be omitted.

According to an embodiment, the repair process in FIGS. 44 through 47 may further include, for example, the processes related to FIGS. 9 through 12 described above and the processes related to FIGS. 15 through 18.

According to an embodiment, the process of cutting the second data connection electrode DCE2 may be performed after the process of connecting the auxiliary connection electrode AXE. An embodiment related to this can be found, for example, in FIGS. 21 through 23 and the related description.

According to an embodiment, when the second data connection electrode DCE2 does not overlap the first data line DL1 (e.g., a data line connected to a defective pixel), a repair process may be normally performed through the auxiliary connection electrode AXE instead of the second data connection electrode DCE2.

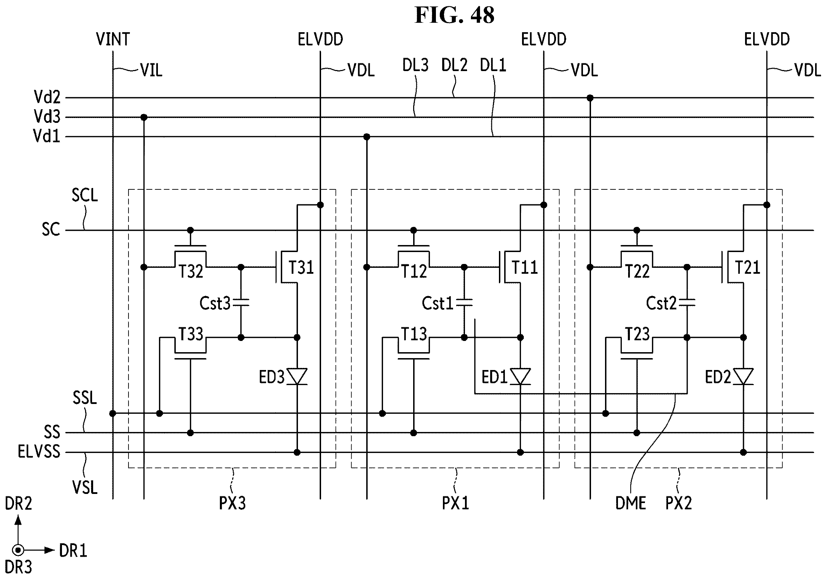

FIG. 48 is a circuit diagram of a display device 100 according to an embodiment.

The display device 100 of FIG. 48 is different from the display device 100 of FIG. 2 described above in the arrangement of pixels and is also different from the display device 100 of FIG. 2 described above in that it further includes a dummy electrode DME. Therefore, these differences will be mainly described as follows.

As illustrated in FIG. 48, a first pixel PX1 may be disposed between a third pixel PX3 and a second pixel PX2.

As illustrated in FIG. 48, one side of the dummy electrode DME may be connected to a second capacitor Cst2 of the second pixel PX2 and a second anode AND2 (or a second anode connection electrode ACE2 to be described later) of a second light emitting element ED2. The other side of the dummy electrode DME may extend to the first pixel PX1. The other side of the dummy electrode DME may overlap one electrode (e.g., a first light blocking layer BML1 to be described later) of a first capacitor Cst1.

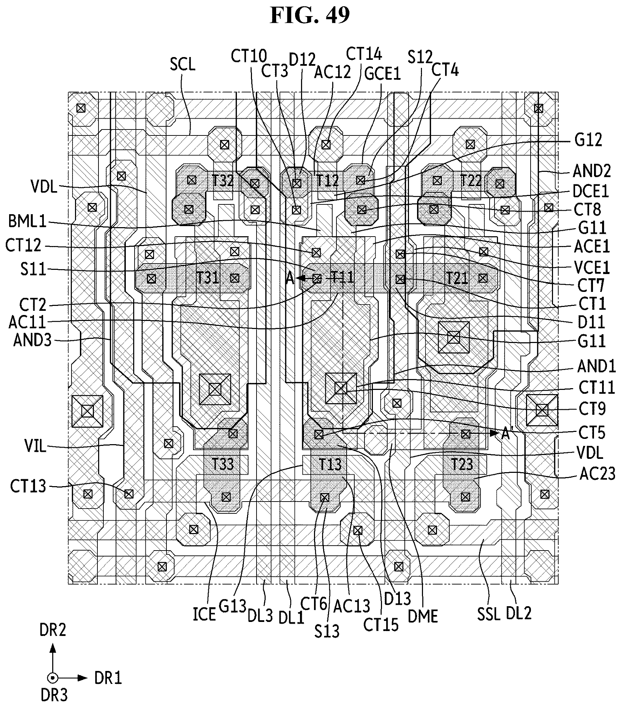

FIGS. 49 through 51 are plan views of a display device 100 according to an embodiment. For example, FIG. 49 may be a plan view of a display device 100 including the first through third pixels PX1 through PX3 of FIG. 48.

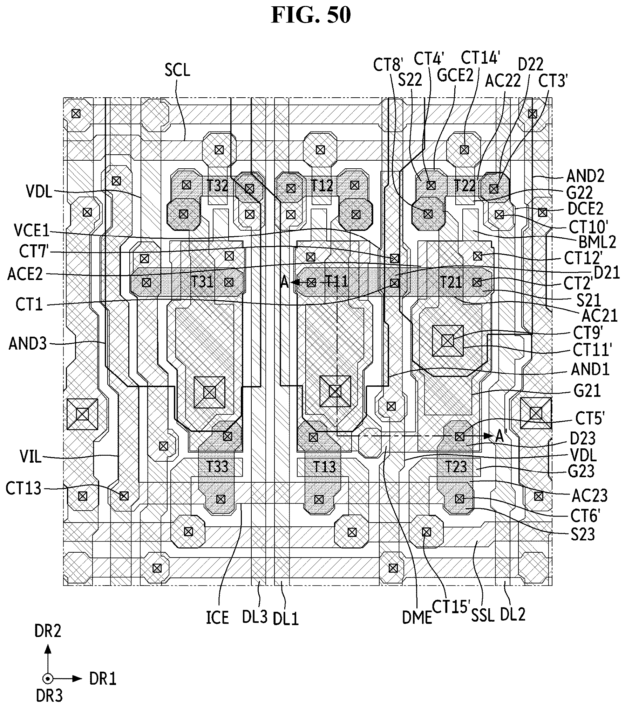

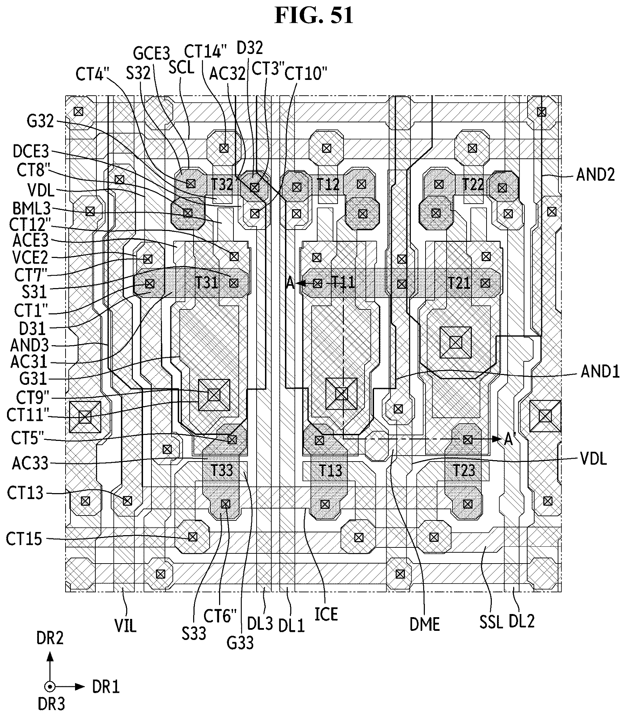

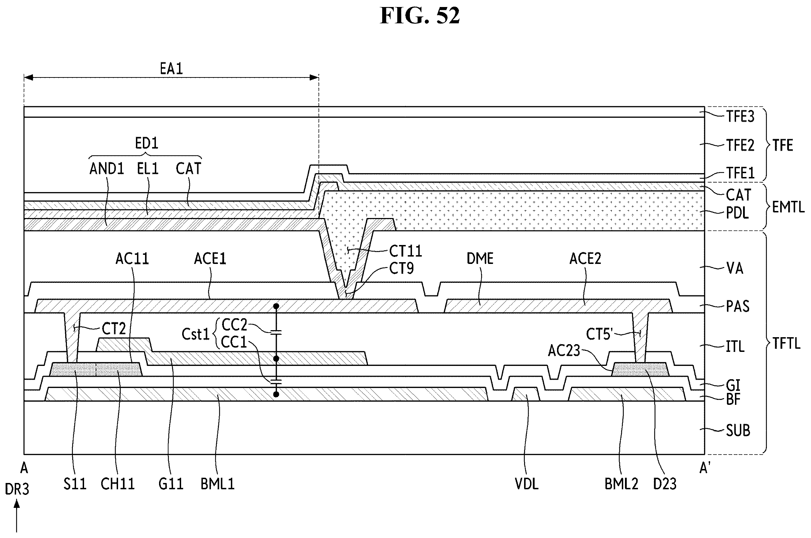

FIG. 49 includes reference numerals related to the first pixel PX1. FIG. 50 is the same drawing as FIG. 49 and includes reference numerals related to the second pixel PX2. FIG. 51 is the same drawing as FIG. 49 and includes reference numerals related to the third pixel PX3. FIG. 52 is a cross-sectional view taken along line A-A' of FIG. 49.

As illustrated in FIG. 52, the display device 100 may include a substrate SUB, a thin-film transistor layer TFTL, a light emitting element layer EMTL, and an encapsulation layer ENC. The thin-film transistor layer TFTL, the light emitting element layer EMTL, and the encapsulation layer ENC may be sequentially disposed on the substrate SUB along the third direction DR3. Here, the thin-film transistor layer TFTL may include eleventh transistors T11, T21 and T31, twelfth transistors T12, T22 and T22, and thirteenth transistors T13, T23 and T33 described above.

Since the substrate SUB of FIG. 52 is the same as the substrate SUB of FIG. 6 described above, a description of the substrate SUB of FIG. 52 can be found in FIG. 6 and the related description.

As illustrated in FIG. 52, a first pattern layer may be disposed on the substrate SUB. The first pattern layer may include, for example, a first light blocking layer BML1, a second light blocking layer BML2, a third light blocking layer BML3, a first data line DL1, a second data line DL2, a third data line DL3, a driving voltage line VDL, and an initialization voltage line VIL as illustrated in FIGS. 49 through 51. The first light blocking layer BML1, the second light blocking layer BML2, the third light blocking layer BML3, the first data line DL1, the second data line DL2, the third data line DL3, the driving voltage line VDL, and the initialization voltage line VIL of FIGS. 49 through 51 are respectively the same as the first light blocking layer BML1, the second light blocking layer BML2, the third light blocking layer BML3, the first data line DL1, the second data line DL2, the third data line DL3, the driving voltage line VDL, and the initialization voltage line VIL of FIGS. 3 through 5 described above. Therefore, a description of the first light blocking layer BML1, the second light blocking layer BML2, the third light blocking layer BML3, the first data line DL1, the second data line DL2, the third data line DL3, the driving voltage line VDL, and the initialization voltage line VIL of FIGS. 49 through 51 can be found in FIGS. 3 through 5 and the related description.

A buffer layer BF may be disposed on the first pattern layer. Since the buffer layer BF of FIG. 52 is the same as the buffer layer BF of FIG. 6 described above, a description of the buffer layer BF of FIG. 52 can be found in FIG. 6 and the related description.

A second pattern layer may be disposed on the buffer layer BF. The second pattern layer may include an eleventh active layer AC11, a twelfth active layer AC12, a thirteenth active layer AC13, a twenty-first active layer AC21, a twenty-second active layer AC22, a twenty-third active layer AC23, a thirty-first active layer AC31, a thirty-second active layer AC32, and a thirty-third active layer AC33 as illustrated in FIGS. 49 through 51. The eleventh active layer AC11, the twelfth active layer AC12, the thirteenth active layer AC13, the twenty-first active layer AC21, the twenty-second active layer AC22, the twenty-third active layer AC23, the thirty-first active layer AC31, the thirty-second active layer AC32, and the thirty-third active layer AC33 of FIGS. 49 through 51 are respectively the same as the eleventh active layer AC11, the twelfth active layer AC12, the thirteenth active layer AC13, the twenty-first active layer AC21, the twenty-second active layer AC22, the twenty-third active layer AC23, the thirty-first active layer AC31, the thirty-second active layer AC32, and the thirty-third active layer AC33 of FIGS. 3 through 5 described above. Therefore, a description of the eleventh active layer AC11, the twelfth active layer AC12, the thirteenth active layer AC13, the twenty-first active layer AC21, the twenty-second active layer AC22, the twenty-third active layer AC23, the thirty-first active layer AC31, the thirty-second active layer AC32, and the thirty-third active layer AC33 of FIGS. 49 through 51 can be found in FIGS. 3 through 5 and the related description.

However, the eleventh active layer AC11 and the twenty-first active layer AC21 of FIGS. 49 through 51 may be integrally formed with each other.

As illustrated in FIG. 52, a gate insulating layer GI may be disposed on the second pattern layer. Since the gate insulating layer GI of FIG. 52 is the same as the gate insulating layer GI of FIG. 6 described above, a description of the gate insulating layer GI of FIG. 52 can be found in FIG. 6 and the related description.

A third pattern layer may be disposed on the gate insulating layer GI. The third pattern layer may include an eleventh gate electrode G11, a twelfth gate electrode G12, a thirteenth gate electrode G13, a twenty-first gate electrode G21, a twenty-second gate electrode G22, a twenty-third gate electrode G23, a thirty-first gate electrode G31, a thirty-second gate electrode G32, and a thirty-third gate electrode G33 as illustrated in FIGS. 49 through 51. The eleventh gate electrode G11, the twelfth gate electrode G12, the thirteenth gate electrode G13, the twenty-first gate electrode G21, the twenty-second gate electrode G22, the twenty-third gate electrode G23, the thirty-first gate electrode G31, the thirty-second gate electrode G32, and the thirty-third gate electrode G33 of FIGS. 49 through 51 are respectively the same as the eleventh gate electrode G11, the twelfth gate electrode G12, the thirteenth gate electrode G13, the twenty-first gate electrode G21, the twenty-second gate electrode G22, the twenty-third gate electrode G23, the thirty-first gate electrode G31, the thirty-second gate electrode G32, and the thirty-third gate electrode G33 of FIGS. 3 through 5 described above. Therefore, a description of the eleventh gate electrode G11, the twelfth gate electrode G12, the thirteenth gate electrode G13, the twenty-first gate electrode G21, the twenty-second gate electrode G22, the twenty-third gate electrode G23, the thirty-first gate electrode G31, the thirty-second gate electrode G32, and the thirty-third gate electrode G33 of FIGS. 49 through 51 can be found in FIGS. 3 through 5 and the related description.

An interlayer insulating layer ITL may be disposed on the third pattern layer. Since the interlayer insulating layer ITL of FIG. 52 is the same as the interlayer insulating layer ITL of FIG. 6 described above, a description of the interlayer insulating layer ITL of FIG. 52 can be found in FIG. 6 and the related description.

A fourth pattern layer may be disposed on the interlayer insulating layer ITL. The fourth pattern layer may include a first anode connection electrode ACE1, a second anode connection electrode ACE2, a third anode connection electrode ACE3, a first gate connection electrode GCE1, a second gate connection electrode GCE2, a third gate connection electrode GCE3, a first data connection electrode DCE1, a second data connection electrode DCE2, a third data connection electrode DCE3, a first driving connection electrode VCE1, a second driving connection electrode VCE2, an initialization connection electrode ICE, a first scan line SCL, and a second scan line SSL as illustrated in FIGS. 49 through 51.

The first anode connection electrode ACE1, the second anode connection electrode ACE2, the third anode connection electrode ACE3, the first gate connection electrode GCE1, the second gate connection electrode GCE2, the third gate connection electrode GCE3, the first data connection electrode DCE1, the second data connection electrode DCE2, the third data connection electrode DCE3, the first driving connection electrode VCE1, the second driving connection electrode VCE2, the initialization connection electrode ICE, the first scan line SCL, and the second scan line SSL of FIGS. 49 through 51 are respectively the same as the first anode connection electrode ACE1, the second anode connection electrode ACE2, the third anode connection electrode ACE3, the first gate connection electrode GCE1, the second gate connection electrode GCE2, the third gate connection electrode GCE3, the first data connection electrode DCE1, the second data connection electrode DCE2, the third data connection electrode DCE3, the first driving connection electrode VCE1, the second driving connection electrode VCE2, the initialization connection electrode ICE, the first scan line SCL, and the second scan line SSL of FIGS. 3 through 5 described above. Therefore, a description of the first anode connection electrode ACE1, the second anode connection electrode ACE2, the third anode connection electrode ACE3, the first gate connection electrode GCE1, the second gate connection electrode GCE2, the third gate connection electrode GCE3, the first data connection electrode DCE1, the second data connection electrode DCE2, the third data connection electrode DCE3, the first driving connection electrode VCE1, the second driving connection electrode VCE2, the initialization connection electrode ICE, the first scan line SCL, and the second scan line SSL of FIGS. 49 through 51 can be found in FIGS. 3 through 5 and the related description.

However, the second driving connection electrode VCE2 of FIGS. 49 through 51 may be commonly connected to an eleventh drain electrode D11 of an eleventh transistor T11 and a twenty-first drain electrode D21 of a twenty-first transistor T21.

In addition, the first scan line SCL of FIGS. 49 through 51 may be connected to the twelfth gate electrode G12 of a twelfth transistor T12 through a fourteenth contact hole CT14 penetrating the interlayer insulating layer ITL, may be connected to the twenty-second gate electrode G22 of a twenty-second transistor T22 through a fourteenth contact hole CT14' penetrating the interlayer insulating layer ITL, and may be connected to the thirty-second gate electrode G32 of a thirty-second transistor T32 through a fourteenth contact hole CT14" penetrating the interlayer insulating layer ITL.

In addition, the second scan line SSL of FIGS. 49 through 51 may be connected to the thirteenth gate electrode G13 of a thirteenth transistor T13 through a fifteenth contact hole CT15 penetrating the interlayer insulating layer ITL, may be connected to the twenty-third gate electrode G23 of a twenty-third transistor T23 through a fifteenth contact hole CT15' penetrating the interlayer insulating layer ITL, and may be connected to the thirty-third gate electrode G33 of a thirty-third transistor T33 through a fifteenth contact hole CT15" penetrating the interlayer insulating layer ITL.

A passivation layer PAS may be disposed on the fourth pattern layer. Since the passivation layer PAS of FIG. 52 is the same as the passivation layer PAS of FIG. 6 described above, a description of the passivation layer PAS of FIG. 52 can be found in FIG. 6 and the related description.

A via layer VA may be disposed on the passivation layer PAS. Since the via layer VA of FIG. 52 is the same as the via layer VA of FIG. 6 described above, a description of the via layer VA of FIG. 52 can be found in FIG. 6 and the related description.

A fifth pattern layer may be disposed on the via layer VA. For example, as illustrated in FIG. 52, the light emitting element layer EMTL including the fifth pattern layer may be disposed on the via layer VA. Since the light emitting element layer EMTL of FIG. 52 is the same as the light emitting element layer EMTL of FIG. 6 described above, a description of the light emitting element layer EMTL of FIG. 52 can be found in FIG. 6 and the related description.

The light emitting element layer EMTL described above may further include a first light emitting element ED1, a second light emitting element ED2, a third light emitting element ED3, and a pixel defining layer PDL. The first light emitting element ED1, the second light emitting element ED2, the third light emitting element ED3, and the pixel defining layer PDL of FIG. 52 are respectively the same as the first light emitting element ED1, the second light emitting element ED2, the third light emitting element ED3, and the pixel defining layer PDL of FIG. 6 described above. Therefore, a description of the first light emitting element ED1, the second light emitting element ED2, the third light emitting element ED3, and the pixel defining layer PDL of FIG. 52 can be found in FIG. 6 and the related description.

A first light emitting layer EL1 may be formed on a first anode AND1, a second light emitting layer EL2 may be formed on a second anode AND2, and a third light emitting layer may be formed on a third anode AND3. The first light emitting layer EL1, the second light emitting layer EL2, and the third light emitting layer of FIG. 52 are respectively the same as the first light emitting layer EL1, the second light emitting layer EL2, and the third light emitting layer of FIG. 6 described above. Therefore, a description of the first light emitting layer EL1, the second light emitting layer EL2, and the third light emitting layer of FIG. 52 can be found in FIG. 6 and the related description.

A cathode CAT may be disposed on the first light emitting layer EL1, the second light emitting layer EL2, and the third light emitting layer. Since the cathode CAT of FIG. 52 is the same as the cathode CAT of FIG. 6 described above, a description of the cathode CAT of FIG. 52 can be found in FIG. 6 and the related description.

The encapsulation layer ENC may be formed on the light emitting element layer EMTL. Since the encapsulation layer ENC of FIG. 52 is the same as the encapsulation layer ENC of FIG. 6 described above, a description of the encapsulation layer ENC of FIG. 52 can be found in FIG. 6 and the related description.

When a foreign substance or the like penetrates into a pixel (e.g., any one of the first pixel PX1, the second pixel PX2, and the third pixel PX3) during a process of fabricating the display device 100, a defect may occur in the pixel, and the pixel may be determined to be a defective pixel that cannot normally provide light. In this case, a repair process may be performed on the defective pixel. The repair process will be described in detail as follows.

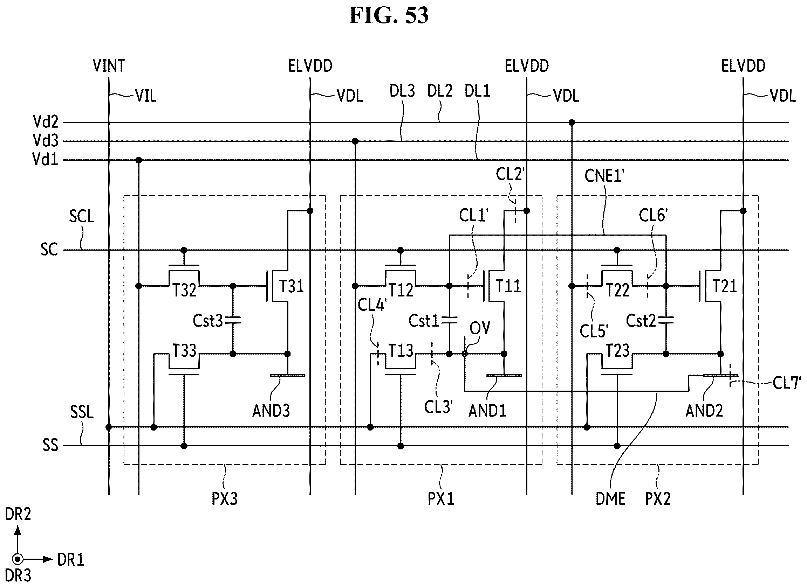

FIG. 53 is a circuit diagram for explaining a method of fabricating a display device 100 according to an embodiment. For example, FIG. 53 may be a diagram for explaining a method of repairing the display device 100 of FIG. 48 described above.

As illustrated in FIG. 53, if a defect occurs in at least one (e.g., an eleventh transistor T11) of transistors of a first pixel PX1 and thus the first pixel PX1 is determined to be a defective pixel that cannot normally provide light, a repair process may be performed on the first pixel PX1.

For example, as illustrated in FIG. 53, a gate electrode of the eleventh transistor T11 may be cut along a first cutting line CL1', a drain electrode of the eleventh transistor T11 may be cut along the first cutting line CL1', a drain electrode of a thirteenth transistor T13 may be cut along a third cutting line CL3', a source electrode of the thirteenth transistor T13 may be cut along a fourth cutting line CL4', a drain electrode of a twenty-second transistor T22 may be cut along a fifth cutting line CL5', a source electrode of the twenty-second transistor T22 may be cut along a sixth cutting line CL6', and a second anode AND2 may be cut along a seventh cutting line CL7'.

Accordingly, the gate electrode of the eleventh transistor T11 and a first capacitor Cst1 may be electrically isolated from each other, the drain electrode of the eleventh transistor T11 and a driving voltage line VDL may be electrically isolated from each other, the drain electrode of the thirteenth transistor T13 and the first capacitor Cst1 may be electrically isolated from each other, the source electrode of the thirteenth transistor T13 and an initialization voltage line VIL may be electrically isolated from each other, the drain electrode of the twenty-second transistor T22 and a second capacitor Cst2 may be electrically isolated from each other, the source electrode of the twenty-second transistor T22 and a second data line DL2 may be electrically isolated from each other, and a portion of the second anode AND2 may be separated from a source electrode of a twenty-first transistor T21.

In order to electrically connect a pixel circuit (e.g., the twenty-first transistor T21, the twenty-second transistor T22, a twenty-third transistor T23 and the second capacitor Cst2) of a normally operating pixel, for example, a second pixel PX2 to the first pixel PX1, a gate electrode of the twenty-first transistor T21 of the second pixel PX2 may be connected to a source electrode of a twelfth transistor T12 through a first connection electrode CNE1, and a dummy electrode DME of the second pixel PX2 and one electrode of the first capacitor Cst1 may be electrically connected in an overlapping area OV of the dummy electrode DME and the one electrode of the first capacitor Cst1.

Through the above repair process and darkening process, a first light emitting element ED1 of the first pixel PX1, which is a defective pixel, may be normally driven by another pixel (e.g., the second pixel PX2). For example, the first light emitting element ED1 of the first pixel PX1 may receive a driving current generated through the pixel circuit of the second pixel PX2 (e.g., the twenty-first transistor T21, the twenty-second transistor T22, the twenty-third transistor T23, and the second capacitor Cst2) to emit light. At this time, the twenty-first transistor T21 of the second pixel PX2 may receive a first data voltage Vd1 from a first data line DL1 through the twelfth transistor T12 of the first pixel PX1. The driving current provided from the twenty-first transistor T21 based on the first data voltage Vd1 may be supplied to a first anode AND1 of the first pixel PX1 through the dummy electrode DME. Therefore, the first light emitting element ED1 of the first pixel PX1 may provide light corresponding to the magnitude (or grayscale value) of the first data voltage Vd1 which is the original data voltage.

According to an embodiment, the first pixel PX1 may be a green pixel that provides green light, the second pixel PX2 may be a blue pixel that provides blue light, and a third pixel PX3 may be a red pixel that provides red light. In a unit pixel including the red pixel, the green pixel, and the blue pixel, the luminance contribution of the green pixel is the highest, and the luminance contribution of the blue pixel is the lowest. Therefore, when the green pixel making the relatively highest luminance contribution is defective, a light emitting element of the green pixel may be driven using a driving current from a pixel circuit of the blue pixel making the relatively lowest luminance contribution, thereby minimizing the defect rate and image quality deterioration of the display device 100.

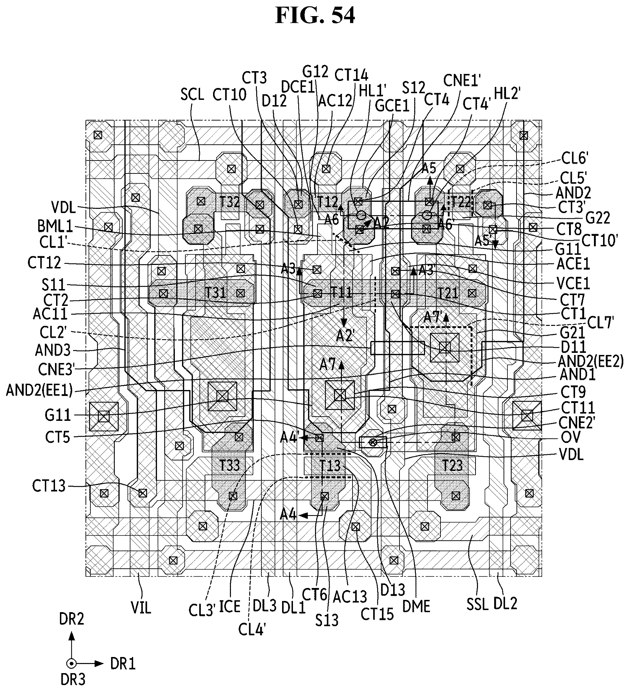

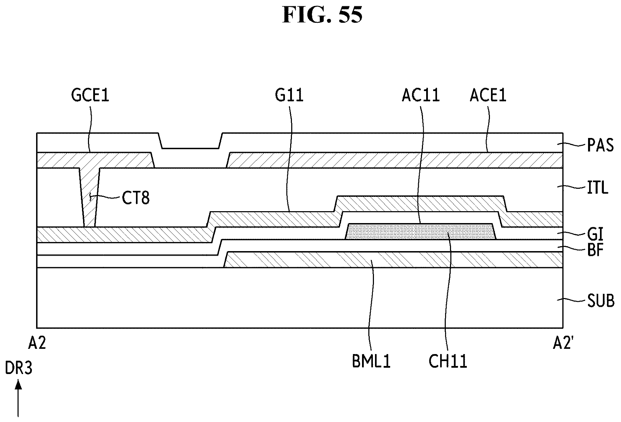

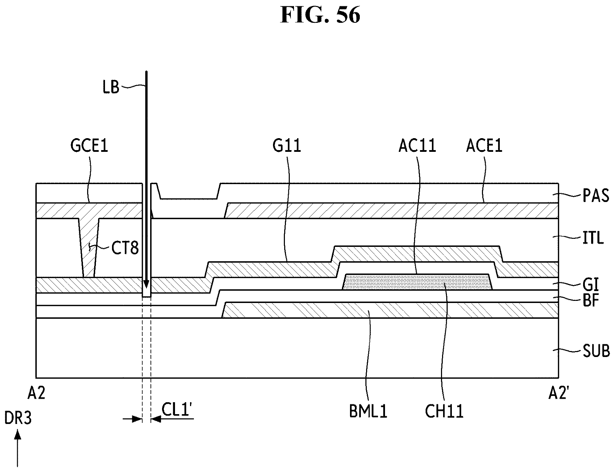

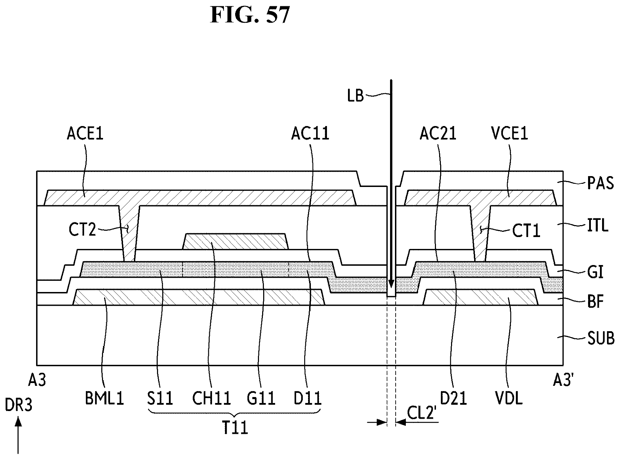

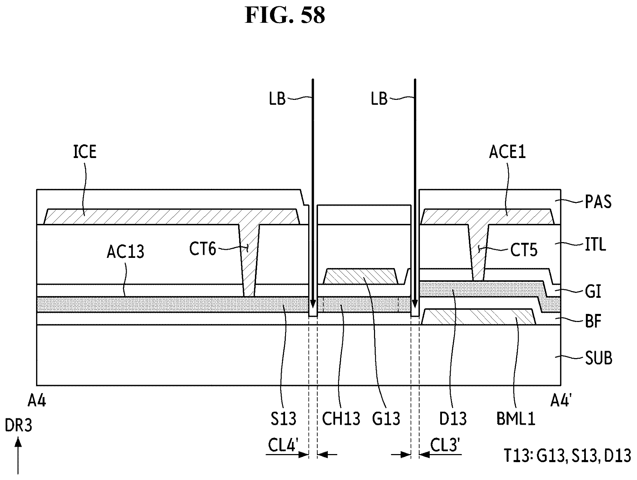

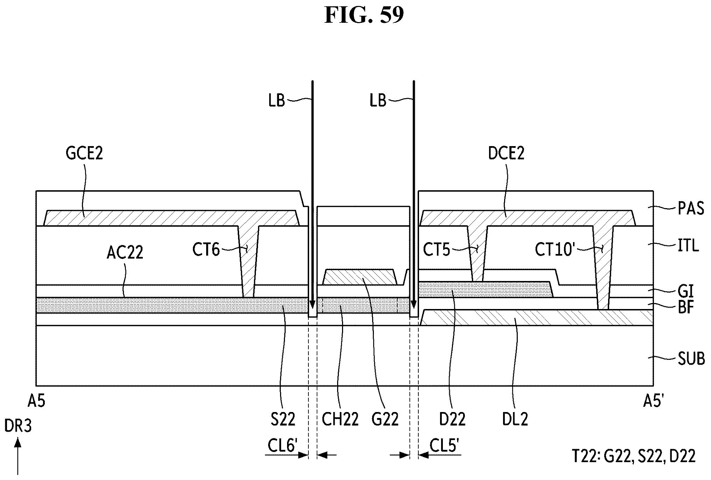

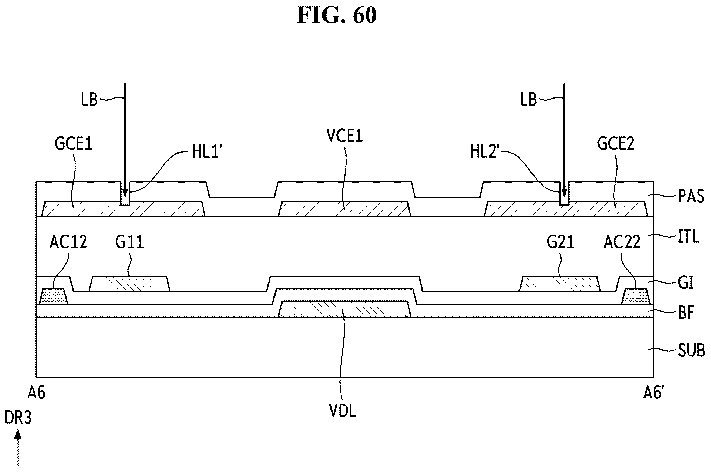

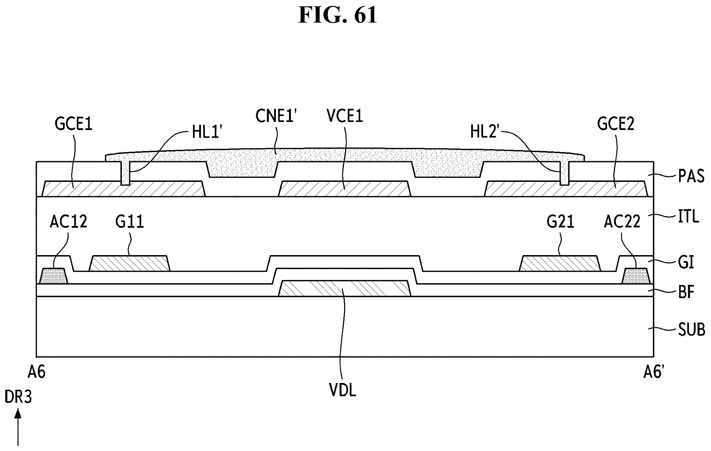

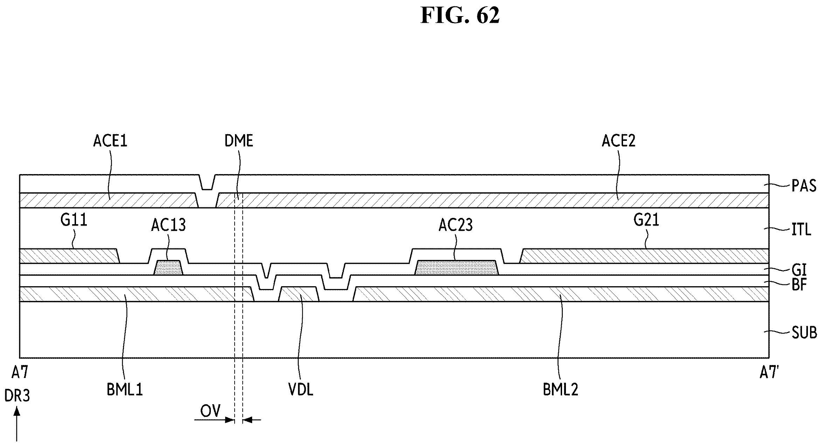

FIGS. 54 through 64 are array diagrams for explaining a method of fabricating a display device 100 according to an embodiment. For example, FIG. 54 may be a diagram for explaining a method of repairing the display device 100 of FIG. 49 described above. Here, FIGS. 55 and 56 are process cross-sectional views taken along line A2-A2' of FIG. 54. FIG. 57 is a process cross-sectional view taken along line A3-A3' of FIG. 54. FIG. 58 is a process cross-sectional view taken along line A4-A4' of FIG. 54. FIG. 59 is a process cross-sectional view taken along line A5-A5' of FIG. 54. FIGS. 60 and 61 are process cross-sectional views taken along line A6-A6' of FIG. 54. FIGS. 62 through 64 are process cross-sectional views taken along line A7-A7' of FIG. 54.

A repair process according to an embodiment may be performed, for example, after a passivation layer PAS is formed. For example, as illustrated in FIG. 55, after a first pattern layer (e.g., a first data line DL1), a buffer layer BF, a second pattern layer (e.g., an eleventh active layer AC11), a gate insulating layer GI, a third pattern layer (e.g., an eleventh gate electrode G11 and a twelfth gate electrode G12), an interlayer insulating layer ITL, a fourth pattern layer (e.g., a first gate connection electrode GCE1 and a first anode connection electrode ACE1), and the passivation layer PAS are sequentially placed on a substrate SUB, a test process may be performed to detect whether each pixel is defective. After this test process, when it is determined that a defect has occurred in a first pixel PX1 among first through third pixels PX1 through PX3, the following repair process may be performed.

For example, as illustrated in FIGS. 54 and 56, the eleventh gate electrode G11 of an eleventh transistor T11 may be cut. According to an embodiment, the eleventh gate electrode G11 of the eleventh transistor T11 may be cut along a first cutting line CL1'. For example, as illustrated in FIG. 56, when a laser beam LB is irradiated onto the passivation layer PAS along the first cutting line CL1', the eleventh gate electrode G11 on the first cutting line CL1' may be cut. Accordingly, the eleventh gate electrode G11 of the eleventh transistor T11 and a twelfth source electrode S12 of a twelfth transistor T12 may be electrically isolated from each other.

According to an embodiment, in plan view, at least one of the eleventh gate electrode G11 and the first gate connection electrode GCE1 may be cut along the first cutting line CL1' between an eighth contact hole CT8 and a channel region CH11 of the eleventh transistor T11.

According to an embodiment, the passivation layer PAS, the first gate connection electrode GCE1, the interlayer insulating layer ITL, and the eleventh gate electrode G11 on the first cutting line CL1' may be penetrated by the laser beam LB, and a groove may be formed in the gate insulating layer GI.

Next, as illustrated in FIGS. 54 and 57, an eleventh drain electrode D11 of the eleventh transistor T11 may be cut. According to an embodiment, the eleventh drain electrode D11 of the eleventh transistor T11 may be cut along a second cutting line CL2'. For example, as illustrated in FIG. 57, when a laser beam LB is irradiated onto the passivation layer PAS along the second cutting line CL2', the eleventh drain electrode D11 on the second cutting line CL2' may be cut. Accordingly, the eleventh drain electrode D11 of the eleventh transistor T11 and a driving voltage line VDL may be electrically isolated from each other.

According to an embodiment, in plan view, at least one of the eleventh drain electrode D11, a first driving connection electrode VCE1, and the first anode connection electrode ACE1 may be cut along the second cutting line CL2' between a first contact hole CT1 and the channel region CH11 of the eleventh transistor T11.

According to an embodiment, the passivation layer PAS, the interlayer insulating layer ITL, the gate insulating layer GI, and the eleventh drain electrode D11 on the second cutting line CL2' may be penetrated by the laser beam LB, and a groove may be formed in the buffer layer BF.

Next, as illustrated in FIGS. 54 and 58, a thirteenth drain electrode D13 and a thirteenth source electrode S13 of a thirteenth transistor T13 may be cut. According to an embodiment, the thirteenth drain electrode D13 of the thirteenth transistor T13 may be cut along a third cutting line CL3', and the thirteenth source electrode S13 of the thirteenth transistor T13 may be cut along a fourth cutting line CL4'.

For example, as illustrated in FIG. 58, when a laser beam LB is irradiated onto the passivation layer PAS along the third cutting line CL3', the thirteenth drain electrode D13 on the third cutting line CL3' may be cut. In addition, when a laser beam LB is irradiated onto the passivation layer PAS along the fourth cutting line CL4', the thirteenth source electrode S13 on the fourth cutting line CL4' may be cut. Accordingly, the thirteenth drain electrode D13 of the thirteenth transistor T13 and a first capacitor Cst1 may be electrically isolated from each other, and the thirteenth source electrode S13 of the thirteenth transistor T13 and an initialization voltage line VIL may also be electrically isolated from each other.

According to an embodiment, in plan view, at least one of the thirteenth drain electrode D13 and the first anode connection electrode ACE1 may be cut along the third cutting line CL3' between a fifth contact hole CT5 and a channel region CH13 of the thirteenth transistor T13.

According to an embodiment, in plan view, at least one of the thirteenth source electrode S13 and an initialization connection electrode ICE may be cut along the fourth cutting line CL4' between a sixth contact hole CT6 and the channel region CH13 of the thirteenth transistor T13.

According to an embodiment, the passivation layer PAS, the interlayer insulating layer ITL, the gate insulating layer GI and the thirteenth drain electrode D13 on the third cutting line CL3' may be penetrated by the laser beam LB, and a groove may be formed in the buffer layer BF. In addition, according to an embodiment, the passivation layer PAS, the interlayer insulating layer ITL, the gate insulating layer GI and the thirteenth source electrode S13 on the fourth cutting line CL4' may be penetrated by the laser beam LB, and a groove may be formed in the buffer layer BF.

Next, as illustrated in FIGS. 54 and 59, a twenty-second drain electrode D22 and a twenty-second source electrode S22 of a twenty-second transistor T22 may be cut. According to an embodiment, the twenty-second drain electrode D22 of the twenty-second transistor T22 may be cut along a fifth cutting line CL5', and the twenty-second source electrode S22 of the twenty-second transistor T22 may be cut along a sixth cutting line CL6'.

For example, as illustrated in FIG. 59, when a laser beam LB is irradiated onto the passivation layer PAS along the fifth cutting line CL5', the twenty-second drain electrode D22 on the fifth cutting line CL5' may be cut. In addition, when a laser beam LB is irradiated onto the passivation layer PAS along the sixth cutting line CL6', the twenty-second source electrode S22 on the sixth cutting line CL6' may be cut. Accordingly, the twenty-second drain electrode D22 of the twenty-second transistor T22 and a second data line DL2 may be electrically isolated from each other, and the twenty-second source electrode S22 of the twenty-second transistor T22 and a gate electrode of a twenty-first transistor T21 may also be electrically isolated from each other.

According to an embodiment, in plan view, at least one of the twenty-second drain electrode D22 and a second data connection electrode DCE2 may be cut along the fifth cutting line CL5' between the fifth contact hole CT5 and a channel region CH22 of the twenty-second transistor T22.

According to an embodiment, in plan view, at least one of the twenty-second source electrode S22 and a second gate connection electrode GCE2 may be cut along the sixth cutting line CL6' between the sixth contact hole CT6 and the channel region CH22 of the twenty-second transistor T22.

According to an embodiment, the passivation layer PAS, the interlayer insulating layer ITL, the gate insulating layer GI and the twenty-second drain electrode D22 on the fifth cutting line CL5' may be penetrated by the laser beam LB, and a groove may be formed in the buffer layer BF. In addition, according to an embodiment, the passivation layer PAS, the interlayer insulating layer ITL, the gate insulating layer GI and the twenty-second source electrode S22 on the sixth cutting line CL6' may be penetrated by the laser beam LB, and a groove may be formed in the buffer layer BF.

Next, as illustrated in FIGS. 54 through 60, a first through hole HL1' exposing the first gate connection electrode GCE1 and a second through hole HL2' exposing the second gate connection electrode GCE2 may be formed. Each of the first through hole HL1' and the second through hole HL2' may penetrate the passivation layer PAS. At this time, a groove may be formed in each of the first gate connection electrode GCE1 and the second gate connection electrode GCE2 by irradiating a laser beam LB. The first through hole HL1' and the second through hole HL2' described above may also be formed by, for example, an etching process instead of the laser beam LB. For example, the first through hole HL1' and the second through hole HL2' may be formed by an etching process for forming ninth contact holes CT9, CT9' and CT9" of the passivation layer PAS described above. In this case, the first through hole HL1', the second through hole HL2', and the ninth contact holes CT9, CT9' and CT9" may be formed simultaneously by one etching process.

Next, as illustrated in FIGS. 54 and 61, a first connection electrode CNE1' may be disposed on the passivation layer PAS. The first connection electrode CNE1' may be connected to the first gate connection electrode GCE1 and the second gate connection electrode GCE2. For example, one side of the first connection electrode CNE1' may contact (or directly contact) the first gate connection electrode GCE1 through the first through hole HL1', and the other side of the first connection electrode CNE1' may contact (or directly contact) the second gate connection electrode GCE2 through the second through hole HL2'. Accordingly, the first gate connection electrode GCE1 and the second gate connection electrode GCE2 may be electrically connected to each other. In other words, the twelfth source electrode S12 of the twelfth transistor T12 may be electrically connected to a twenty-first gate electrode G21 of the twenty-first transistor T21 through the first gate connection electrode GCE1, the first connection electrode CNE1', and the second gate connection electrode GCE2. The first connection electrode CNE1' may include conductive ink.

According to an embodiment, the first connection electrode CNE1' may overlap the first gate connection electrode GCE1, the driving voltage line VDL, and the second gate connection electrode GCE2 as illustrated in FIG. 54.

According to an embodiment, as illustrated in FIG. 54, the first connection electrode CNE1' may be shaped like a straight line that connects the first through hole HL1' and the second through hole HL2' in the shortest path.

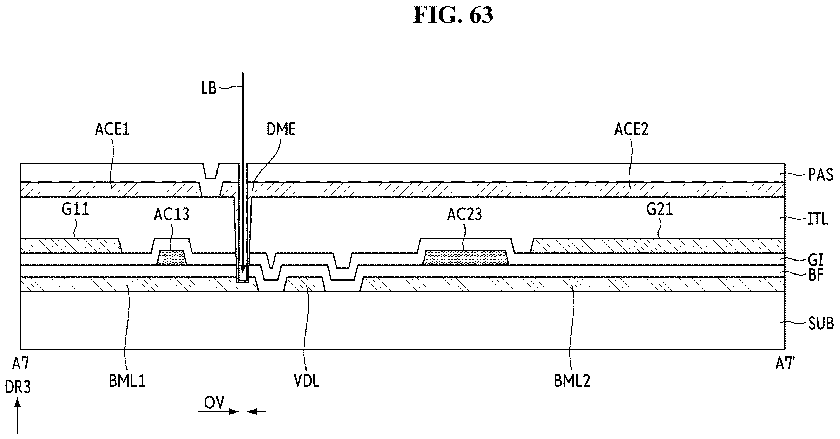

Next, as illustrated in FIGS. 54, 62 and 63, a dummy electrode DME and a first light blocking layer BML1 may be electrically connected to each other. According to an embodiment, the dummy electrode DME and the first light blocking layer BML1 may be electrically connected to each other in an overlapping area OV of the dummy electrode DME and the first light blocking layer BML1. For example, as illustrated in FIG. 63, when a laser beam LB is irradiated onto the passivation layer PAS in the overlapping area OV of the dummy electrode DME and the first light blocking layer BML1, the dummy electrode DME and the first light blocking layer BML1 may contact (or directly contact) each other in the overlapping area OV. Accordingly, a second anode connection electrode ACE2 (or a second anode AND2) and the first anode connection electrode ACE1 (or a first anode AND1) may be electrically connected to each other.

According to an embodiment, the passivation layer PAS, the interlayer insulating layer ITL, the gate insulating layer GI, and the buffer layer BF may be penetrated by the laser beam LB in the overlapping area OV of the dummy electrode DME and the first light blocking layer BML1, and a groove may be formed in the first light blocking layer BML1.

According to an embodiment, in the overlapping area OV, a portion of the dummy electrode DME may be disposed in respective through holes of the interlayer insulating layer ITL, the gate insulating layer GI and the buffer layer BF and the groove of the first light blocking layer BML1.

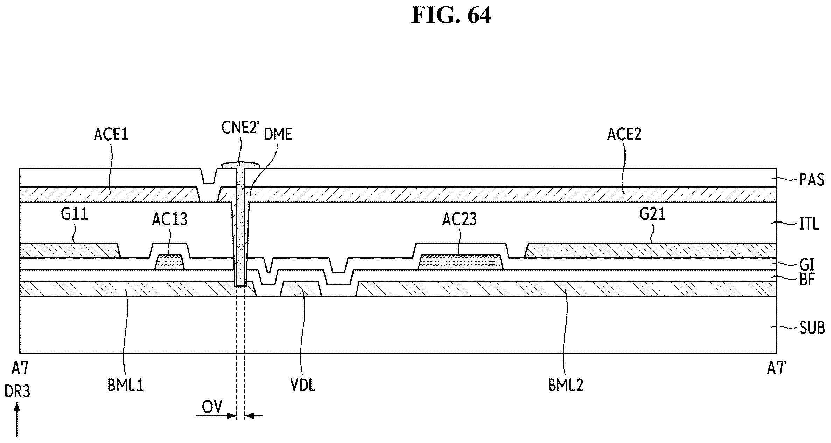

Additionally, as illustrated in FIGS. 54 and 64, a second connection electrode CNE2' may be further disposed on the passivation layer PAS. For example, the second connection electrode CNE2' may be disposed on the passivation layer PAS in the overlapping area OV and around the overlapping area OV. A portion of the second connection electrode CNE2' may be disposed in the respective through holes of the passivation layer PAS, the interlayer insulating layer ITL, the gate insulating layer GI and the buffer layer BF (e.g., the through holes formed by irradiating the laser beam LB to the overlapping area OV of FIG. 63) and the groove of the first light blocking layer BML1 (e.g., the groove formed by irradiating the laser beam LB to the overlapping area OV of FIG. 63). At this time, the portion of the second connection electrode CNE2' may contact (or directly contact) the dummy electrode DME and the first light blocking layer BML1 in the above-described through holes and groove. The second connection electrode CNE2' may improve the connection state between the dummy electrode DME and the first light blocking layer BML1. The second connection electrode CNE2' may include, for example, conductive ink. The second connection electrode CNE2' may also be omitted.

Next, after the ninth contact holes CT9, CT9' and CT9" are formed to penetrate the passivation layer PAS to expose the first anode connection electrode ACE1, the second anode connection electrode ACE2 and a third anode connection electrode ACE3, a via layer VA may be formed on the passivation layer PAS. Next, eleventh contact holes CT11, CT11' and CT11" may be formed to penetrate the via layer VA to expose the first anode connection electrode ACE1, the second anode connection electrode ACE2, and the third anode connection electrode ACE3.

Next, the first anode AND1, the second anode AND2, and a third anode AND3 connected to the first anode connection electrode ACE1, the second anode connection electrode ACE2, and the third anode connection electrode ACE3 through the eleventh contact holes CT11, CT11' and CT11" and the ninth contact holes CT9, CT9' and CT9" may be disposed on the via layer VA.

Next, as illustrated in FIG. 54, the second anode AND2 may be cut. According to an embodiment, the second anode AND2 may be cut along a seventh cutting line CL7'. For example, when a laser beam LB is irradiated onto the second anode AND2 along the seventh cutting line CL7', the second anode AND2 on the seventh cutting line CL7' may be cut. For example, the second anode AND2 may include a first partial electrode EE1 and a second partial electrode EE2 separated from each other by the seventh cutting line CL7'. The first partial electrode EE1 may be connected to the second anode connection electrode ACE2 through the eleventh contact hole CT11' and the ninth contact hole CT9', but the second partial electrode EE2 may be electrically and physically separated from the second anode connection electrode ACE2. Accordingly, the first partial electrode EE1 may be connected to a twenty-first source electrode S21 of the twenty-first transistor T21, but the second partial electrode EE2 may be separated from the twenty-first source electrode S21 of the twenty-first transistor T21. At this time, in plan view as illustrated in FIG. 54, the first partial electrode EE1 may be smaller than the second partial electrode EE2. For example, in plan view, the area of the first partial electrode EE1 may be smaller than the area of the second partial electrode EE2. Therefore, when a driving current is supplied to the second anode AND2, an actual emission area of the darkened second pixel PX2 may be minimized. Here, the actual emission area of the darkened second pixel PX2 may be an area corresponding to the first partial electrode EE1 of the second anode AND2. A detailed description of the process of cutting the second anode AND2 of FIG. 54 can be found in FIG. 15 described above and the related description.

As illustrated in FIG. 54, a third connection electrode CNE3' connecting the first partial electrode EE1 of the second anode AND2 and the first anode AND1 may be further disposed on the via layer VA. The third connection electrode CNE3' may include conductive ink. A description of the third connection electrode CNE3' can be found in FIG. 16 and the related description.

Those skilled in the art to which the present specification pertains will understand that the present specification may be embodied in other specific forms without changing the technical spirit or essential characteristics. Therefore, the above-described embodiments are to be understood as illustrative in all respects and not as restrictive. The scope of the present specification is defined by the claims described below rather than by the foregoing detailed description, and all modifications or variations derived from the meaning, scope, and equivalent concepts of the claims should be interpreted as falling within the scope of the present specification.

Meanwhile, the present specification and drawings disclose preferred embodiments of the present specification, and although specific terms have been used, they are used in a general sense merely to facilitate the description of the technical content of the specification and to aid understanding of the invention, and are not intended to limit the scope of the specification. In addition to the embodiments disclosed herein, it will be apparent to those skilled in the art that other modifications based on the technical idea of the present specification may also be implemented.

## Claims

1. A display device comprising:
a first light emitting element;
a (1-1)-th transistor comprising a drain electrode connected to a driving voltage line and a source electrode connected to a first anode of the first light emitting element;
a (1-2)-th transistor comprising a gate electrode connected to a first scan line, a drain electrode connected to a first data line, and a source electrode connected to a gate electrode of the (1-1)-th transistor;
a (1-3)-th transistor comprising a gate electrode connected to a second scan line, a drain electrode connected to the first anode of the first light emitting element, and a source electrode connected to an initialization voltage line;
a second light emitting element;
a (2-1)-th transistor comprising a drain electrode connected to a driving voltage line and a source electrode connected to a second anode of the second light emitting element;
a (2-2)-th transistor comprising a gate electrode connected to the first scan line, a drain electrode connected to a second data line, and a source electrode connected to a gate electrode of the (2-1)-th transistor;
a (2-3)-th transistor comprising a gate electrode connected to the second scan line, a drain electrode connected to the second anode of the second light emitting element, and a source electrode connected to the initialization voltage line;
a first data connection electrode connected to the first data line and the drain electrode of the (1-2)-th transistor; and
a second data connection electrode connected to the second data line and the drain electrode of the (2-2)-th transistor,
wherein at least one of the drain electrode of the (1-2)-th transistor and the first data connection electrode is cut, the second data connection electrode is cut, and the second data connection electrode and the first data line are connected to each other.

2. The display device of claim 1, wherein the drain electrode of the (1-2)-th transistor and the first data connection electrode are connected to each other through a first contact hole of an insulating layer, and in plan view, at least one of the drain electrode of the (1-2)-th transistor and the first data connection electrode is cut on the first contact hole.

3. The display device of claim 1, further comprising a first gate connection electrode connected to the source electrode of the (1-2)-th transistor and the gate electrode of the (1-1)-th transistor.

4. The display device of claim 3, wherein at least one of the source electrode of the (1-2)-th transistor and the first gate connection electrode is cut.

5. The display device of claim 4, wherein the source electrode of the (1-2)-th transistor and the first gate connection electrode are connected to each other through a second contact hole of an insulating layer, and in plan view, at least one of the source electrode of the (1-2)-th transistor and the first gate connection electrode is cut on the second contact hole.

6. The display device of claim 1, wherein the second data connection electrode and the second data line are connected to each other through a third contact hole of an insulating layer, the second data connection electrode and the drain electrode of the (2-2)-th transistor are connected to each other through a fourth contact hole of an insulating layer, and in plan view, the second data connection electrode is cut between the third contact hole and the fourth contact hole.

7. The display device of claim 1, further comprising a first driving connection electrode connected to the drain electrode of the (1-1)-th transistor and the driving voltage line.

8. The display device of claim 7, wherein the drain electrode of the (1-1)-th transistor is cut.

9. The display device of claim 8, wherein the drain electrode of the (1-1)-th transistor and the first driving connection electrode are connected to each other through a fifth contact hole of an insulating layer, and in plan view, the drain electrode of the (1-1)-th transistor is cut between the fifth contact hole and a channel region of the (1-1)-th transistor.

10. The display device of claim 1, further comprising:
a first light blocking layer overlapping the gate electrode of the (1-1)-th transistor; and
a first anode connection electrode overlapping the gate electrode of the (1-1)-th transistor and connected to the first light blocking layer, the drain electrode of the (1-3)-th transistor, and the first anode.

11. The display device of claim 10, wherein the first anode connection electrode is cut.

12. The display device of claim 11, wherein the first anode connection electrode and the first light blocking layer are connected to each other through a sixth contact hole of an insulating layer, the first anode connection electrode and the drain electrode of the (1-3)-th transistor are connected to each other through a seventh contact hole of an insulating layer, and in plan view, the first anode connection electrode is cut between the sixth contact hole and the seventh contact hole.

13. The display device of claim 10, wherein at least one of the drain electrode of the (1-3)-th transistor and the first anode connection electrode is cut.

14. The display device of claim 13, wherein the first anode connection electrode and the drain electrode of the (1-3)-th transistor are connected to each other through a seventh contact hole of an insulating layer, and in plan view, at least one of the drain electrode of the (1-3)-th transistor and the first anode connection electrode is cut on the seventh contact hole.

15. The display device of claim 1, further comprising an initialization connection electrode connected to the source electrode of the (1-3)-th transistor and the initialization voltage line.

16. The display device of claim 15, wherein at least one of the source electrode of the (1-3)-th transistor and the initialization connection electrode is cut.

17. The display device of claim 16, wherein the source electrode of the (1-3)-th transistor and the initialization connection electrode are connected to each other through an eighth contact hole of an insulating layer, and in plan view, at least one of the source electrode of the (1-3)-th transistor and the initialization connection electrode is cut between the eighth contact hole and a channel region of the (1-3)-th transistor.

18. The display device of claim 1, further comprising a first connection electrode overlapping an intersection area of the second data connection electrode and the first data line and connected to the second data connection electrode and the first data line.

19. The display device of claim 18, wherein the first connection electrode comprises conductive ink.

20. The display device of claim 1, wherein the second anode is cut.

21. The display device of claim 20, further comprising a second anode connection electrode connected to the second anode, wherein the cut second anode comprises a first partial electrode and a second partial electrode separated from each other, and the first partial electrode is connected to the second anode connection electrode.

22. The display device of claim 21, wherein the first anode and the first partial electrode of the second anode are connected to each other.

23. The display device of claim 22, further comprising a second connection electrode connecting the first anode and the first partial electrode of the second anode to each other.

24. The display device of claim 23, wherein the second connection electrode is disposed on the same layer as the first anode and the second anode.

25. The display device of claim 21, wherein a size of the first partial electrode is smaller than a size of the second partial electrode in plan view.

26. The display device of claim 1, further comprising:
a pixel defining layer disposed on the first anode and the second anode and defining a first emission area exposing the first anode and a second emission area exposing the second anode;
a first light emitting layer disposed on the first anode to correspond to the first emission area of the pixel defining layer;
a second light emitting layer disposed on the second anode to correspond to the second emission area of the pixel defining layer; and
a common electrode on the first light emitting layer and the second light emitting layer.

27. The display device of claim 26, wherein the common electrode has a through hole which exposes the second light emitting layer.

28. The display device of claim 27, wherein a size of the through hole is equal to or smaller than a size of the second emission area in plan view.

29. The display device of claim 1, further comprising:
a first anode connection electrode connected to the first anode;
a second anode connection electrode connected to the second anode; and
a third connection electrode connecting the first anode connection electrode and the second anode connection electrode to each other.

30. The display device of claim 29, wherein one side of the third connection electrode is connected to the first anode connection electrode through a ninth contact hole of an insulating layer, and the other side of the third connection electrode is connected to the second anode connection electrode through a tenth contact hole of an insulating layer.

31. The display device of claim 30, wherein the first anode and the second anode are disposed on the third connection electrode, the first anode is connected to the one side of the third connection electrode through an eleventh contact hole of an insulating layer, and the second anode is connected to the other side of the third connection electrode through a twelfth contact hole of an insulating layer.

32. The display device of claim 30, wherein the first anode is connected to the first anode connection electrode through a thirteenth contact hole of an insulating layer, and the second anode is connected to the second anode connection electrode through a fourteenth contact hole of an insulating layer.

33. The display device of claim 1, further comprising a fourth connection electrode connecting the first data line and the second data connection electrode to each other.

34. The display device of claim 33, wherein one side of the fourth connection electrode is connected to the first data line through a first through hole of an insulating layer, and the other side of the fourth connection electrode is connected to the second data connection electrode through a second through hole of an insulating layer.

35. The display device of claim 1, wherein the first data connection electrode overlaps the first data line, and the second data connection electrode overlaps the first data line and the second data line.

36. The display device of claim 1, wherein the first data connection electrode overlaps the first data line and the second data line, and the second data connection electrode overlaps the second data line.

37. The display device of claim 36, further comprising an auxiliary connection electrode overlapping the first data line and the second data line and connected to the source electrode of the (2-2)-th transistor.

38. The display device of claim 37, wherein the auxiliary connection electrode is integrally formed with the second data connection electrode.

39. The display device of claim 37, wherein the auxiliary connection electrode and the second data line are connected to each other.

40. The display device of claim 39, further comprising a fifth connection electrode overlapping an intersection area of the auxiliary connection electrode and the first data line and connected to the auxiliary connection electrode and the first data line.

41. The display device of claim 1, wherein the first light emitting element and the second light emitting element provide light of different colors.

42. The display device of claim 41, wherein the first light emitting element provides green light, and the second light emitting element provides blue light.

43. A display device comprising:
a first light emitting element;
a (1-1)-th transistor comprising a drain electrode connected to a driving voltage line and a source electrode connected to a first anode of the first light emitting element;
a (1-2)-th transistor comprising a gate electrode connected to a first scan line, a drain electrode connected to a first data line, and a source electrode connected to a gate electrode of the (1-1)-th transistor;
a (1-3)-th transistor comprising a gate electrode connected to a second scan line, a drain electrode connected to the first anode of the first light emitting element, and a source electrode connected to an initialization voltage line;
a second light emitting element;
a (2-1)-th transistor comprising a drain electrode connected to a driving voltage line and a source electrode connected to a second anode of the second light emitting element;
a (2-2)-th transistor comprising a gate electrode connected to the first scan line, a drain electrode connected to a second data line, and a source electrode connected to a gate electrode of the (2-1)-th transistor;
a (2-3)-th transistor comprising a gate electrode connected to the second scan line, a drain electrode connected to the second anode of the second light emitting element, and a source electrode connected to the initialization voltage line;
a first light blocking layer overlapping the gate electrode of the (1-1)-th transistor;
a first anode connection electrode overlapping the gate electrode of the (1-1)-th transistor and connected to the first light blocking layer and the drain electrode of the (1-3)-th transistor;
a second anode connection electrode overlapping the gate electrode of the (2-1)-th transistor and connected to the second anode; and
a dummy electrode extending from the second anode connection electrode to overlap the first light blocking layer.

44. The display device of claim 43, wherein the dummy electrode and the first light blocking layer are connected to each other.

45. The display device of claim 44, further comprising a first connection electrode overlapping an overlapping area of the dummy electrode and the first light blocking layer and connected to the dummy electrode and the first light blocking layer.

46. The display device of claim 45, wherein the first connection electrode comprises conductive ink.

47. The display device of claim 43, further comprising a first gate connection electrode connected to the gate electrode of the (1-1)-th transistor and the source electrode of the (1-2)-th transistor.

48. The display device of claim 47, wherein at least one of the gate electrode of the (1-1)-th transistor and the first gate connection electrode is cut.

49. The display device of claim 48, wherein the gate electrode of the (1-1)-th transistor and the first gate connection electrode are connected to each other through a first contact hole of an insulating layer, and in plan view, at least one of the gate electrode of the (1-1)-th transistor and the first gate connection electrode is cut between the first contact hole and a channel region of the (1-1)-th transistor.

50. The display device of claim 43, further comprising a first driving connection electrode connected to the drain electrode of the (1-1)-th transistor and the driving voltage line.

51. The display device of claim 50, wherein the drain electrode of the (1-1)-th transistor is cut.

52. The display device of claim 51, wherein the drain electrode of the (1-1)-th transistor and the first driving connection electrode are connected to each other through a second contact hole of an insulating layer, and in plan view, the drain electrode of the (1-1)-th transistor is cut between the second contact hole and the channel region of the (1-1)-th transistor.

53. The display device of claim 43, wherein the drain electrode of the (1-3)-th transistor is cut.

54. The display device of claim 53, wherein the first anode connection electrode and the drain electrode of the (1-3)-th transistor are connected to each other through a third contact hole of an insulating layer, and in plan view, the drain electrode of the (1-3)-th transistor is cut between the third contact hole and a channel region of the (1-3)-th transistor.

55. The display device of claim 43, further comprising an initialization connection electrode connected to the source electrode of the (1-3)-th transistor and the initialization voltage line.

56. The display device of claim 55, wherein the source electrode of the (1-3)-th transistor is cut.

57. The display device of claim 56, wherein the source electrode of the (1-3)-th transistor and the initialization connection electrode are connected to each other through a fourth contact hole of an insulating layer, and in plan view, the source electrode of the (1-3)-th transistor is cut between the fourth contact hole and the channel region of the (1-3)-th transistor.

58. The display device of claim 43, wherein the drain electrode of the (2-2)-th transistor is cut.

59. The display device of claim 58, further comprising:
a first data connection electrode connected to the drain electrode of the (1-2)-th transistor and the first data line; and
a second data connection electrode connected to the drain electrode of the (2-2)-th transistor and the second data line.

60. The display device of claim 59, wherein the second data connection electrode and the drain electrode of the (2-2)-th transistor are connected to each other through a fifth contact hole of an insulating layer, and in plan view, the drain electrode of the (2-2)-th transistor is cut between the fifth contact hole and a channel region of the (2-2)-th transistor.

61. The display device of claim 43, wherein the source electrode of the (2-2)-th transistor is cut.

62. The display device of claim 58, further comprising:
a first gate connection electrode connected to the gate electrode of the (1-1)-th transistor and the source electrode of the (1-2)-th transistor; and
a second gate connection electrode connected to the gate electrode of the (2-1)-th transistor and the source electrode of the (2-2)-th transistor.

63. The display device of claim 62, wherein the second gate connection electrode and the source electrode of the (2-2)-th transistor are connected to each other through a sixth contact hole of an insulating layer, and the source electrode of the (2-2)-th transistor is cut between the sixth contact hole and the channel region of the (2-2)-th transistor.

64. The display device of claim 43, further comprising:
a first gate connection electrode connected to the gate electrode of the (1-1)-th transistor and the source electrode of the (1-2)-th transistor; and
a second gate connection electrode connected to the gate electrode of the (2-1)-th transistor and the source electrode of the (2-2)-th transistor,
wherein the first gate connection electrode and the second gate connection electrode are connected to each other.

65. The display device of claim 64, further comprising a second connection electrode connecting the first gate connection electrode and the second gate connection electrode to each other.

66. The display device of claim 65, wherein one side of the second connection electrode is connected to the first gate connection electrode through a first through hole of an insulating layer, and the other side of the second connection electrode is connected to the second gate connection electrode through a second through hole of an insulating layer.

67. A method of fabricating a display device, the method comprising:
forming, on a substrate, a (1-1)-th transistor comprising a drain electrode connected to a driving voltage line, a (1-2)-th transistor comprising a gate electrode connected to a first scan line, a drain electrode connected to a first data line and a source electrode connected to a gate electrode of the (1-1)-th transistor, a (1-3)-th transistor comprising a gate electrode connected to a second scan line and a source electrode connected to an initialization voltage line, a (2-1)-th transistor comprising a drain electrode connected to a driving voltage line, a (2-2)-th transistor comprising a gate electrode connected to the first scan line, a drain electrode connected to a second data line and a source electrode connected to a gate electrode of the (2-1)-th transistor, and a (2-3)-th transistor comprising a gate electrode connected to the second scan line and a source electrode connected to the initialization voltage line;
forming a first insulating layer on the (1-1)-th transistor, the (1-2)-th transistor, the (1-3)-th transistor, the (2-1)-th transistor, the (2-2)-th transistor, and the (2-3)-th transistor;
forming, on the first insulating layer, a first data connection electrode connected to the first data line and the drain electrode of the (1-2)-th transistor and a second data connection electrode connected to the second data line and the drain electrode of the (2-2)-th transistor;
forming a second insulating layer on the first data connection electrode and the second data connection electrode;
cutting at least one of the drain electrode of the (1-2)-th transistor and the first data connection electrode;
cutting the second data connection electrode; and
connecting the second data connection electrode and the first data line to each other.

68. The method of claim 67, wherein the drain electrode of the (1-2)-th transistor and the first data connection electrode are connected to each other through a first contact hole of the first insulating layer, and the cutting of the at least one of the drain electrode of the (1-2)-th transistor and the first data connection electrode comprises irradiating a laser beam toward the first data connection electrode on the first contact hole from above the second insulating layer.

69. The method of claim 67, further comprising forming, on the first insulating layer, a first gate connection electrode connected to the source electrode of the (1-2)-th transistor and the gate electrode of the (1-1)-th transistor.

70. The method of claim 69, further comprising cutting at least one of the source electrode of the (1-2)-th transistor and the first gate connection electrode.

71. The method of claim 70, wherein the source electrode of the (1-2)-th transistor and the first gate connection electrode are connected to each other through a second contact hole of the first insulating layer, and the cutting of the at least one of the source electrode of the (1-2)-th transistor and the first gate connection electrode comprises irradiating a laser beam toward the first gate connection electrode on the second contact hole from above the second insulating layer.

72. The method of claim 67, wherein the second data connection electrode and the second data line are connected to each other through a third contact hole of the first insulating layer, the second data connection electrode and the drain electrode of the (2-2)-th transistor are connected to each other through a fourth contact hole of the first insulating layer, and the cutting of the second data connection electrode comprises irradiating a laser beam toward the second data connection electrode between the third contact hole and the fourth contact hole from above the second insulating layer.

73. The method of claim 67, comprising further forming, on the first insulating layer, a first driving connection electrode connected to the drain electrode of the (1-1)-th transistor and the driving voltage line.

74. The method of claim 73, further comprising cutting the drain electrode of the (1-1)-th transistor.

75. The method of claim 74, wherein the drain electrode of the (1-1)-th transistor and the first driving connection electrode are connected to each other through a fifth contact hole of the first insulating layer, and the cutting of the drain electrode of the (1-1)-th transistor comprises irradiating a laser beam toward the drain electrode of the (1-1)-th transistor between the fifth contact hole and a channel region of the (1-1)-th transistor from above the second insulating layer.

76. The method of claim 67, further comprising:
forming, on the substrate, a first light blocking layer overlapping the gate electrode of the (1-1)-th transistor; and
further forming, on the first insulating layer, a first anode connection electrode overlapping the gate electrode of the (1-1)-th transistor and connected to the first light blocking layer and a drain electrode of the (1-3)-th transistor.

77. The method of claim 76, further comprising cutting the first anode connection electrode.

78. The method of claim 77, wherein the first anode connection electrode and the first light blocking layer are connected to each other through a sixth contact hole of the first insulating layer, the first anode connection electrode and the drain electrode of the (1-3)-th transistor are connected to each other through a seventh contact hole of the first insulating layer, and the cutting of the first anode connection electrode comprises irradiating a laser beam toward the first anode connection electrode between the sixth contact hole and the seventh contact hole from above the second insulating layer.

79. The method of claim 76, further comprising cutting at least one of the drain electrode of the (1-3)-th transistor and the first anode connection electrode.

80. The method of claim 79, wherein the first anode connection electrode and the drain electrode of the (1-3)-th transistor are connected to each other through the seventh contact hole of the first insulating layer, and the cutting of the at least one of the drain electrode of the (1-3)-th transistor and the first anode connection electrode comprises irradiating a laser beam toward the first anode connection electrode on the seventh contact hole from above the second insulating layer.

81. The method of claim 67, further comprising forming, on the first insulating layer, an initialization connection electrode connected to the source electrode of the (1-3)-th transistor and the initialization voltage line.

82. The method of claim 81, further comprising cutting at least one of the source electrode of the (1-3)-th transistor and the initialization connection electrode.

83. The method of claim 82, wherein the source electrode of the (1-3)-th transistor and the initialization connection electrode are connected to each other through an eighth contact hole of the first insulating layer, and the cutting of the at least one of the source electrode of the (1-3)-th transistor and the initialization connection electrode comprises irradiating a laser beam toward the initialization connection electrode between the eighth contact hole and a channel region of the (1-3)-th transistor from above the second insulating layer.

84. The method of claim 67, wherein the connecting of the second data connection electrode and the first data line to each other comprises irradiating a laser beam toward an overlapping area of the second data connection electrode and the first data line from above the second insulating layer.

85. The method of claim 84, further comprising forming, on the second insulating layer, a first connection electrode connected to the second data connection electrode and the first data line in the overlapping area of the second data connection electrode and the first data line.

86. The method of claim 85, wherein the first connection electrode is made of conductive ink.

87. The method of claim 67, further comprising:
forming, on the first insulating layer, a first anode connection electrode connected to a source electrode of the (1-1)-th transistor and a second anode connection electrode connected to a source electrode of the (2-1)-th transistor;
forming a third insulating layer on the second insulating layer;
forming, on the third insulating layer, a first anode connected to the first anode connection electrode and a second anode connected to the second anode connection electrode;
forming a first partial electrode connected to the second anode connection electrode and a second partial electrode separated from the second anode connection electrode by cutting the second anode; and
connecting the first anode and the first partial electrode.

88. The method of claim 87, wherein the connecting of the first anode and the first partial electrode comprises forming, on the third insulating layer, a second connection electrode connecting the first anode and the first partial electrode.

89. The method of claim 87, further comprising:
forming a pixel defining layer, which defines a first emission area and a second emission area, on the first anode and the second anode;
forming a first light emitting layer and a second light emitting layer on the first emission area and the second emission area, respectively;
forming a cathode on the first light emitting layer and the second light emitting layer; and
removing the cathode corresponding to the second emission area.

90. A method of fabricating a display device, the method comprising:
forming, on a substrate, a (1-1)-th transistor comprising a drain electrode connected to a driving voltage line, a (1-2)-th transistor comprising a gate electrode connected to a first scan line, a drain electrode connected to a first data line and a source electrode connected to a gate electrode of the (1-1)-th transistor, a (1-3)-th transistor comprising a gate electrode connected to a second scan line and a source electrode connected to an initialization voltage line, a (2-1)-th transistor comprising a drain electrode connected to a driving voltage line, a (2-2)-th transistor comprising a gate electrode connected to the first scan line, a drain electrode connected to a second data line and a source electrode connected to a gate electrode of the (2-1)-th transistor, a (2-3)-th transistor comprising a gate electrode connected to the second scan line and a source electrode connected to the initialization voltage line, and a first light blocking layer overlapping the gate electrode of the (1-1)-th transistor;
forming a first insulating layer on the (1-1)-th transistor, the (1-2)-th transistor, the (1-3)-th transistor, the (2-1)-th transistor, the (2-2)-th transistor, the (2-3)-th transistor, and the first light blocking layer; and
forming, on the first insulating layer, a first anode connection electrode overlapping the gate electrode of the (1-1)-th transistor and connected to the first light blocking layer and a drain electrode of the (1-3)-th transistor, a second anode connection electrode overlapping the gate electrode of the (2-1)-th transistor, and a dummy electrode extending from the second anode connection electrode to overlap the first light blocking layer.

91. The method of claim 90, further comprising connecting the dummy electrode and the first light blocking layer to each other.

92. A method of fabricating a display device, the method comprising:
disconnecting a first pixel circuit of a first pixel from first signal lines;
disconnecting a second pixel circuit of a second pixel from a second signal line;
connecting the second pixel circuit of the second pixel and any one of the first signal lines to each other; and
connecting a second anode of the second pixel and a first anode of the first pixel to each other,
wherein visibility of the first pixel is higher than visibility of the second pixel.

93. The method of claim 92, wherein the disconnecting of the first pixel circuit from the first signal lines comprises disconnecting the first pixel circuit of the first pixel from a first data line, disconnecting the first pixel circuit of the first pixel from a first scan line and disconnecting the first pixel circuit of the first pixel from a driving voltage line, the disconnecting of the second pixel circuit of the second pixel from the second signal line comprises disconnecting the second pixel circuit of the second pixel from a second data line, and the connecting of the second pixel circuit of the second pixel and the any one of the first signal lines to each other comprises connecting the second pixel circuit of the second pixel and the first data line to each other.

94. The method of claim 92, wherein the first pixel is a pixel that provides green light, and the second pixel is a pixel that provides blue light.

95. The method of claim 92, wherein the first pixel is a pixel that provides red light, and the second pixel is a pixel that provides blue light.
